(19) Europäisches Patentamt

European Patent Office

Office européen des brevets

(11) EP 1 206 831 B1

(12) EUROPEAN PATENT SPECIFICATION

(45) Date of publication and mention
of the grant of the patent:
**13.10.2004 Bulletin 2004/42**

(51) Int Cl.7: **H03C 3/40**

(21) Application number: **00952520.5**

(86) International application number:
**PCT/US2000/021359**

(22) Date of filing: **04.08.2000**

(87) International publication number:
**WO 2001/011767 (15.02.2001 Gazette 2001/07)**

(54) **MODEM FOR WIRELESS LOCAL AREA NETWORK**

MODEM FÜR EINES DRAHTLOSES LOKALES NETZWERK

MODEM POUR RESEAU LOCAL SANS FIL

(84) Designated Contracting States:
**AT BE CH CY DE DK ES FI FR GB GR IE IT LI LU MC NL PT SE**

(30) Priority: **04.08.1999 US 147129 P**
**14.03.2000 US 525615**
**14.03.2000 US 526041**

(43) Date of publication of application:
**22.05.2002 Bulletin 2002/21**

(73) Proprietor: **Parkervision, Inc.**
**Jacksonville, FL 32256 (US)**

(72) Inventors:
 • **SORRELLS, David, F.**
 **Middleburg, FL 32068 (US)**
 • **BULTMAN, Michael, J.**
 **Jacksonville, FL 32246 (US)**
 • **COOK, Robert, W.**
 **Switzerland, FL 32259 (US)**
 • **LOOKE, Richard, C.**
 **Jacksonville, FL 32223 (US)**
 • **MOSES, Charley, D., Jr.**
 **Jacksonville, FL 32217 (US)**
 • **RAWLINS, Gregory, S.**
 **Heathrow, FL 32746 (US)**
 • **RAWLINS, Michael, W.**
 **Lake Mary, FL 32746-5917 (US)**

(74) Representative:
**Cross, James Peter Archibald et al**
**R.G.C. Jenkins & Co.,**
**26 Caxton Street**
**London SW1H 0RJ (GB)**

(56) References cited:
**WO-A-96/02977      US-A- 4 393 395**
**US-A- 4 967 160      US-A- 5 809 060**

## Description

### *Background of the Invention*

#### *Field of the Invention*

The present invention is generally related to wireless local area networks (WLANs), and more particularly, to WLANs that utilize universal frequency translation technology for frequency translation, and applications of same.

#### *Related Art*

Wireless LANs exist for receiving and transmitting information to/from mobile terminals using electromagnetic (EM) signals. Conventional wireless communications circuitry is complex and has a large number of circuit parts. This complexity and high parts count increases overall cost. Additionally, higher part counts result in higher power consumption, which is undesirable, particularly in battery powered wireless units. Additionally, various communication components exist for performing frequency down-conversion, frequency up-conversion, and filtering. Also, schemes exist for signal reception in the face of potential jamming signals.

The document US 4393395 discloses a balanced modulator for modulating components of a chrominance signal onto a subcarrier.

The document US 5809060 discloses a transmitter for a wireless local-area network which uses spread-spectrum modulation.

The document WO 96/02977 discloses a frequency downconverter using aliasing.

### *Summary of the Invention*

According to one aspect of the present invention, there is provided a wireless modem apparatus according to claim 1. According to another aspect of the present invention, there is provided a method according to claim 29.

An embodiment of the present invention is directed to a wireless local area network (WLAN) that includes one or more WLAN devices (also called stations, terminals, access points, client devices, or infrastructure devices) for effecting wireless communications over the WLAN. The WLAN device includes at least an antenna, a receiver, and a transmitter for effecting wireless communications over the WLAN. Additionally, the WLAN device may also include a LNA/PA module, a control signal generator, a demodulation/modulation facilitation module, and a media access control (MAC) interface. The WLAN receiver includes at least one universal frequency translation module that frequency down-converts a received electromagnetic (EM) signal. Preferably, the UFT based receiver is configured in a multi-phase embodiment to reduce or eliminate re-radiation that is caused by DC offset. The WLAN transmitter includes at least one universal frequency translation module that frequency up-converts a baseband signal in preparation for transmission over the WLAN. Preferably, the UFT based transmitter is configured in a differential and/or multi-phase embodiment to reduce carrier insertion and spectral growth in the transmitted signal.

WLANs exhibit multiple advantages by using UFT modules for frequency translation. These advantages include, but are not limited to: lower power consumption, longer battery life, fewer parts, lower cost, less tuning, and more effective signal transmission and reception. These advantages are possible because the UFT module enables direct frequency conversion in an efficient manner with minimal signal distortion. The structure and operation of the UFT module, and various applications of the same are described in detail in the following sections.

Further features and advantages of the invention, as well as the structure and operation are described in detail below with reference to the accompanying drawings.

### *Brief Description of the Figures*

The present invention will be described with reference to the accompanying drawings, wherein:

FIG. 1A is a block diagram of a universal frequency translation (UFT) module;
FIG. 1B is a more detailed diagram of a universal frequency translation (UFT) module;
FIG. 1C illustrates a UFT module used in a universal frequency down-conversion (UFD) module;
FIG. 1D illustrates a UFT module used in a universal frequency up-conversion (UFU) module;
FIG. 2A-2B illustrate block diagrams of universal frequency translation (UFT) modules;
FIG. 3 is a block diagram of a universal frequency up-conversion (UFU) module;
FIG. 4 is a more detailed diagram of a universal frequency up-conversion (UFU) module;
FIG. 5 is a block diagram of an alternate universal frequency up-conversion (UFU) module;

FIGS. 6A-6I illustrate example waveforms used to describe the operation of the UFU module;

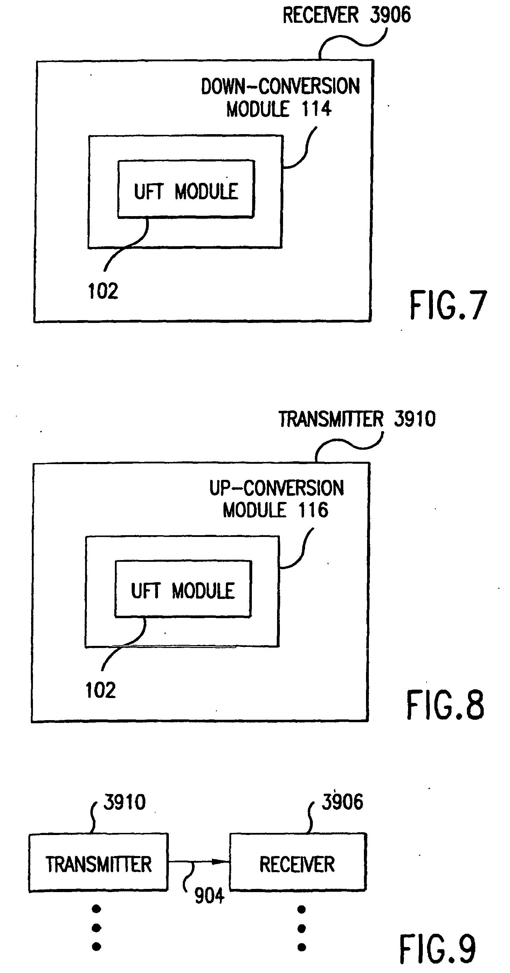

FIG. 7 illustrates a UFT module used in a receiver;

FIG. 8 illustrates a UFT module used in a transmitter;

FIG. 9 illustrates an environment comprising a transmitter and a receiver, each of which may be implemented using a UFT module;

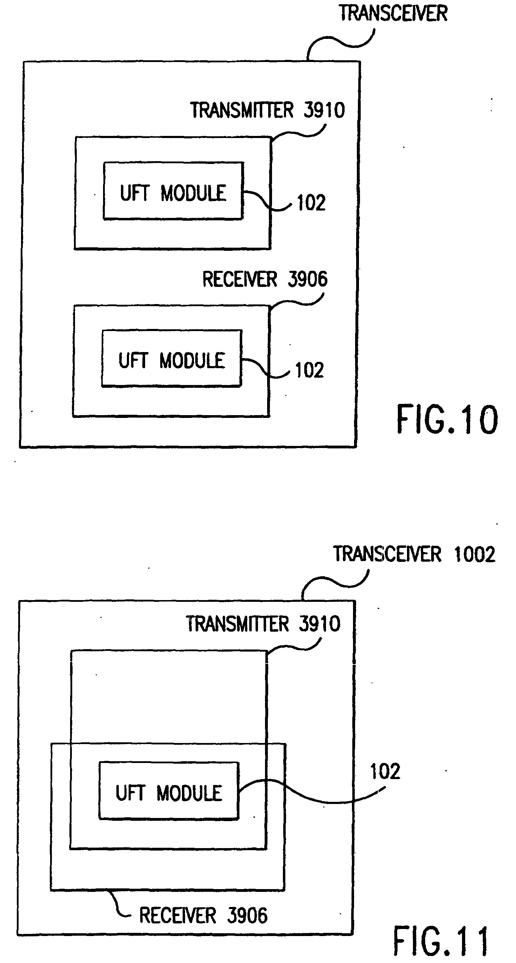

FIG. 10 illustrates a transceiver;

FIG. 11 illustrates an alternate transceiver;

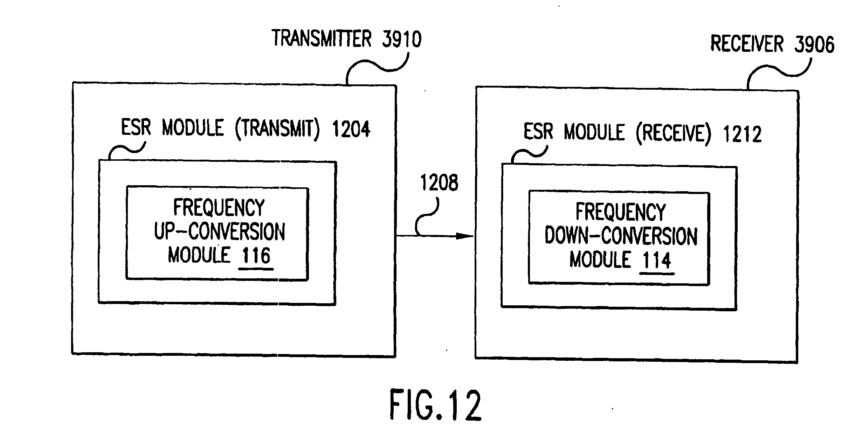

FIG. 12 illustrates an environment comprising a transmitter and a receiver, each of which may be implemented using enhanced signal reception (ESR) components;

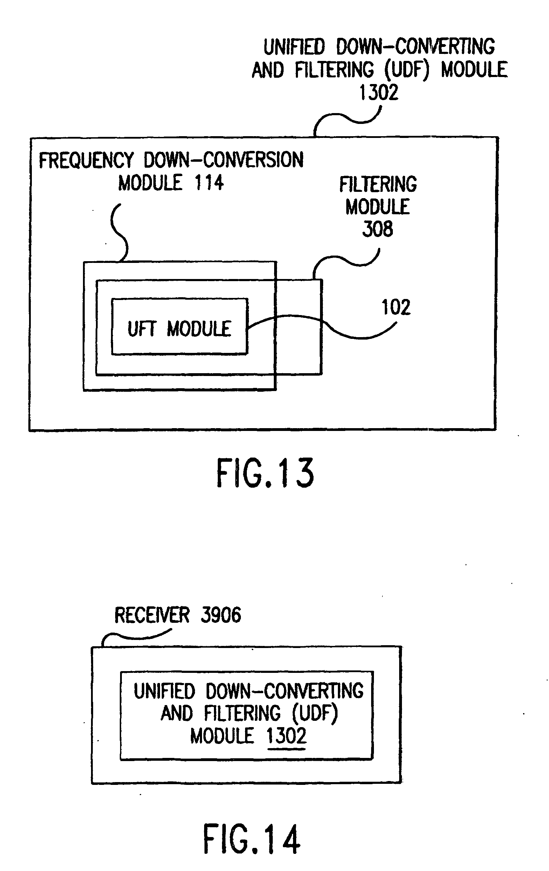

FIG. 13 illustrates a UFT module used in a unified down-conversion and filtering (UDF) module;

FIG. 14 illustrates an example receiver implemented using a UDF module;

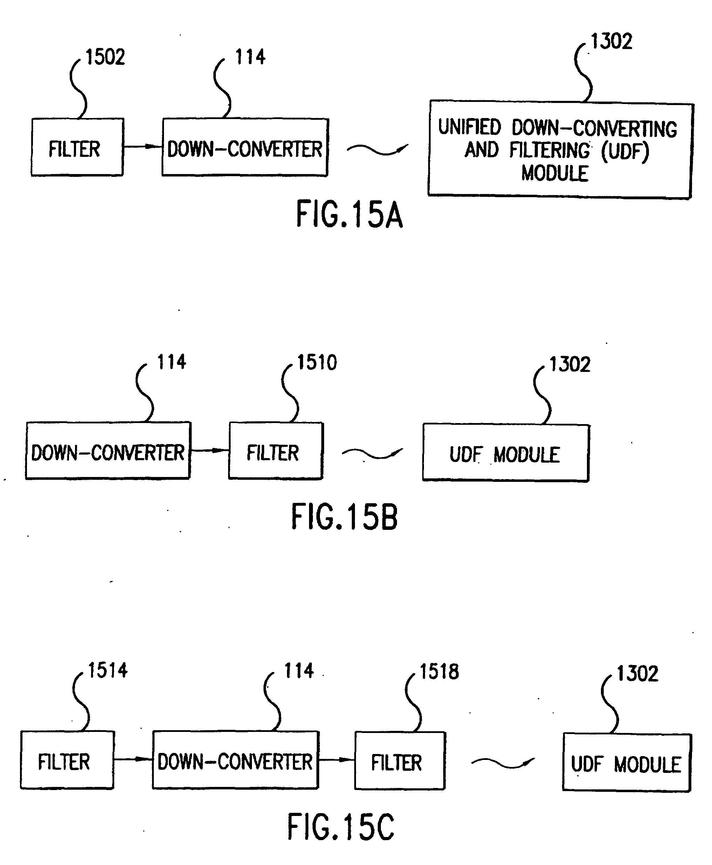

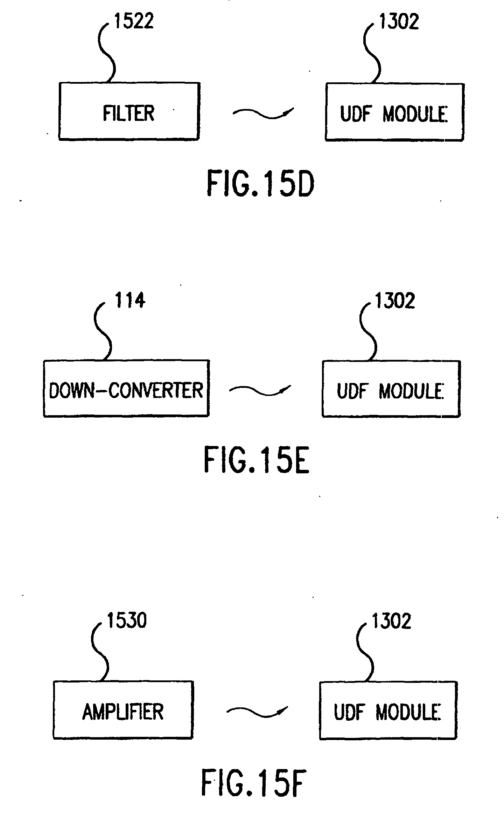

FIGS. 15A-15F illustrate example applications of the UDF module;

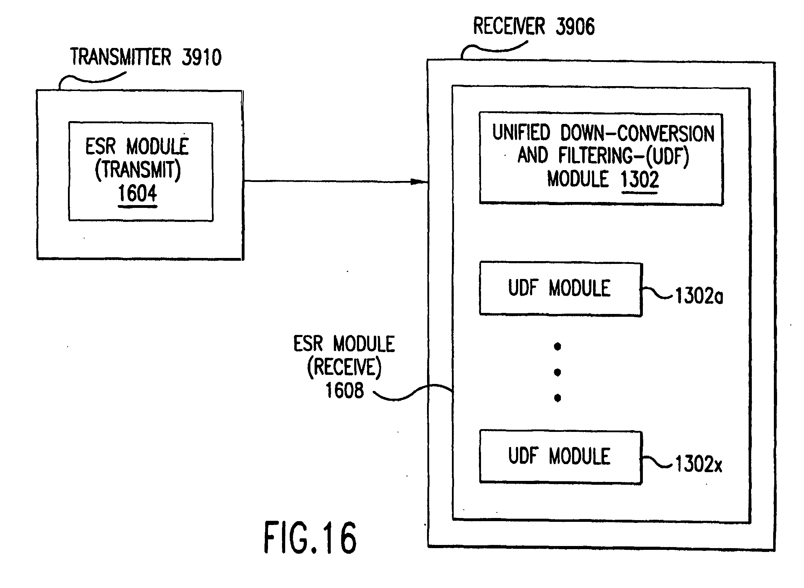

FIG. 16 illustrates an environment comprising a transmitter and a receiver, each of which may be implemented using enhanced signal reception (ESR) components, wherein the receiver may be further implemented using one or more UFD modules;

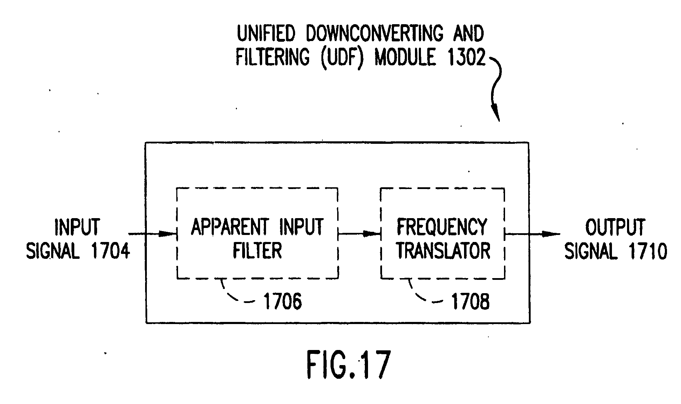

FIG. 17 illustrates a unified down-converting and filtering (UDF) module;

FIGS. 18A and 18A-1 are example aliasing modules;

FIGS. 18B-18F are example waveforms used to describe the operation of the aliasing modules of FIGS. 18A and 18A-1;

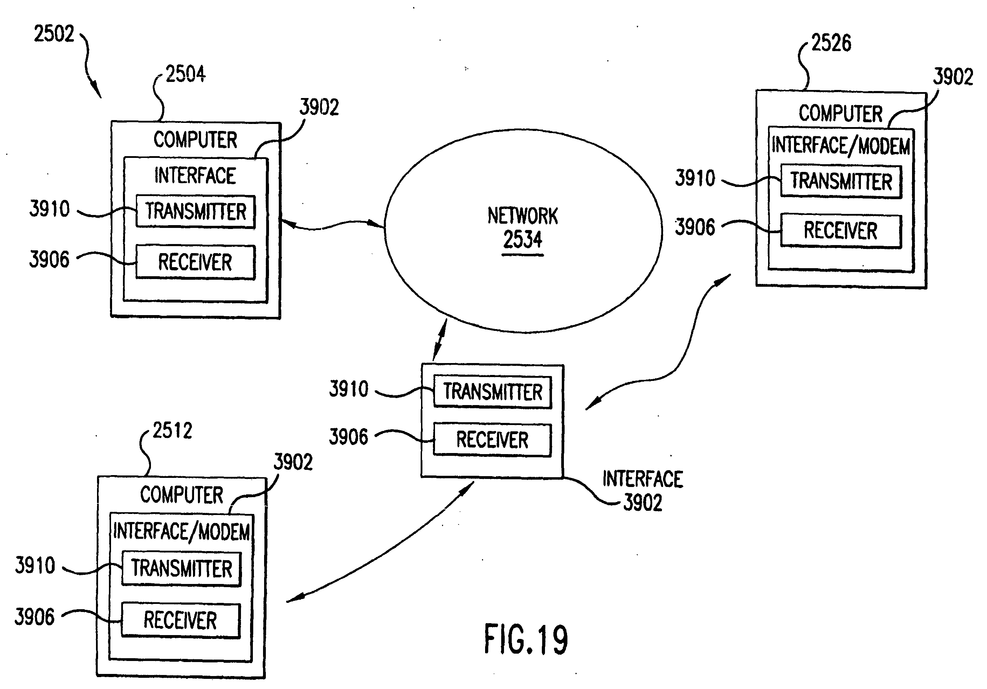

FIG. 19 illustrates a block diagram of an example computer network;

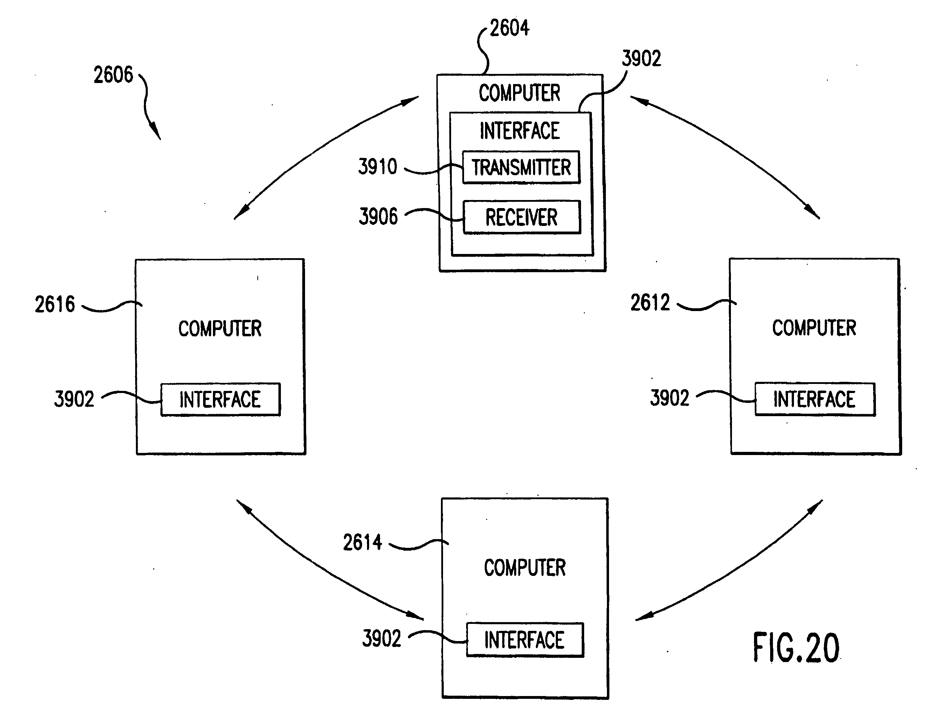

FIG. 20 illustrates a block diagram of an example computer network;

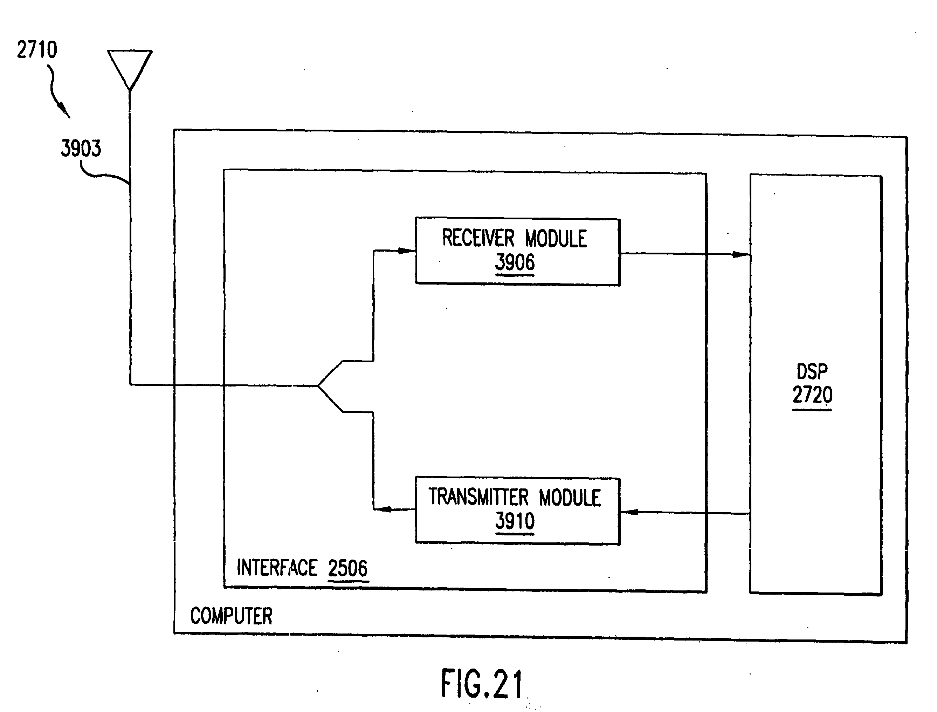

FIG. 21 illustrates a block diagram of an example wireless interface;

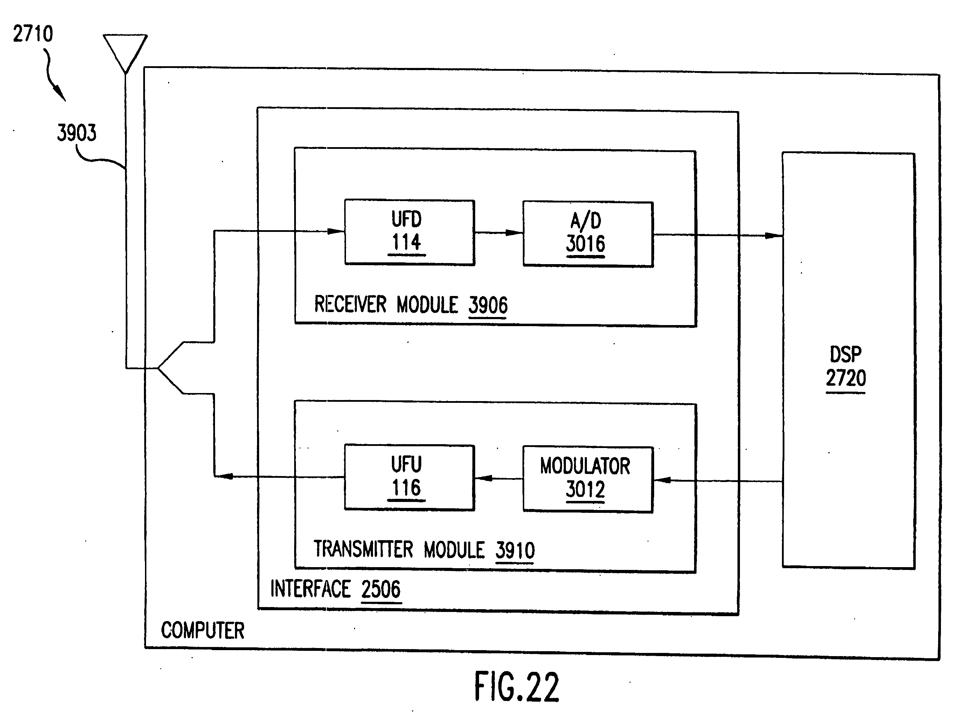

FIG. 22 illustrates an example high level block diagram of the interface illustrated in FIG. 21;

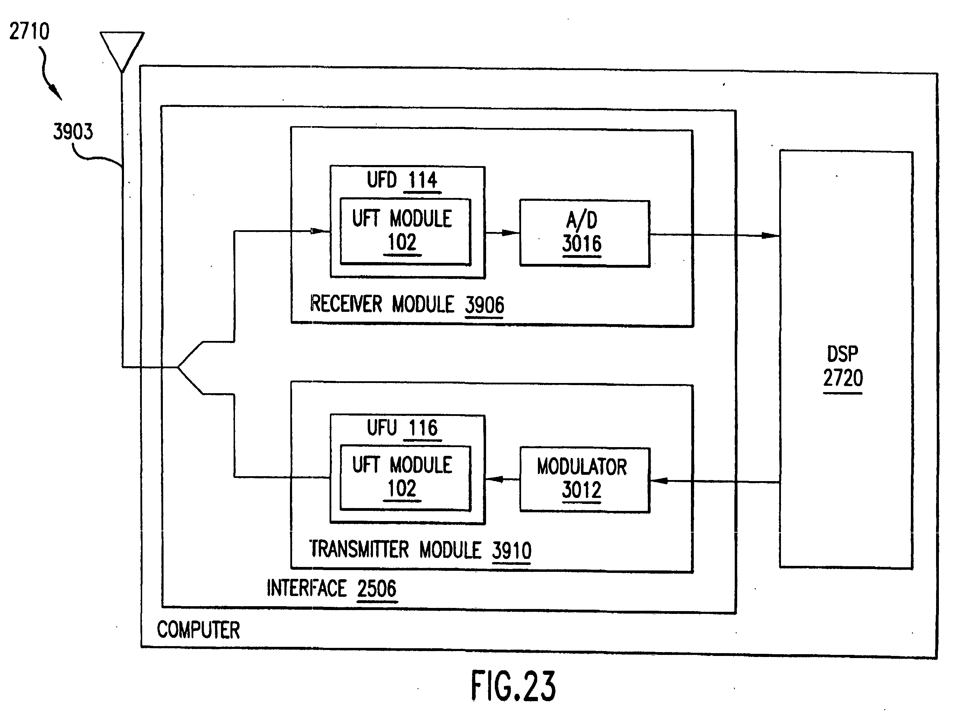

FIG. 23 illustrates a example block diagram of an interface;

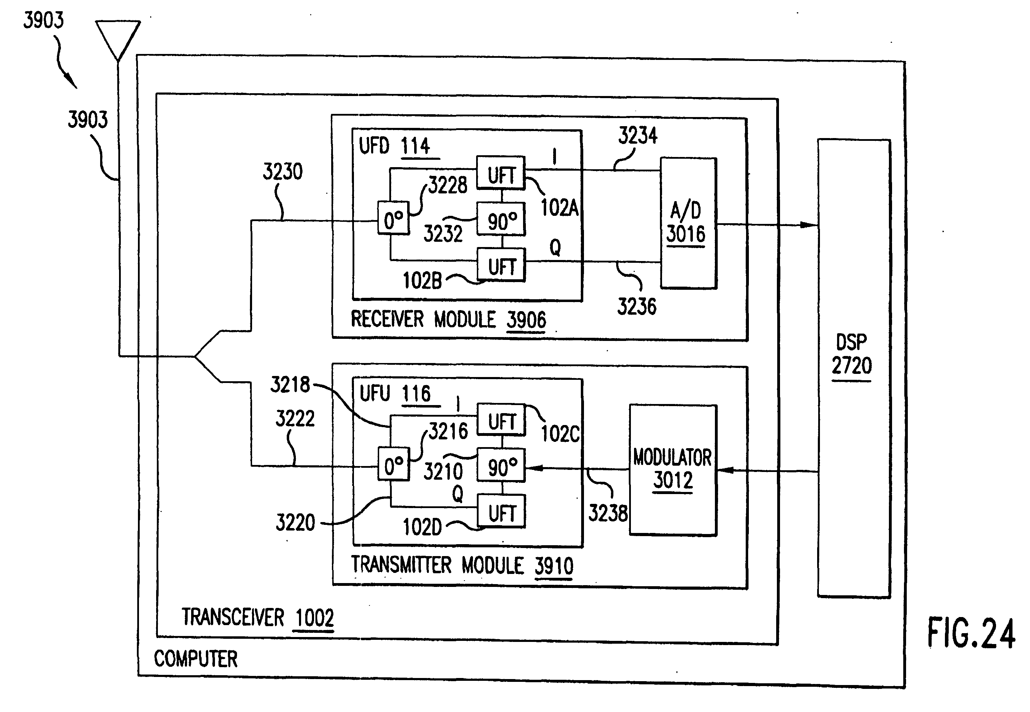

FIG. 24 illustrates an example I/Q implementation of the interface illustrated in FIG. 23;

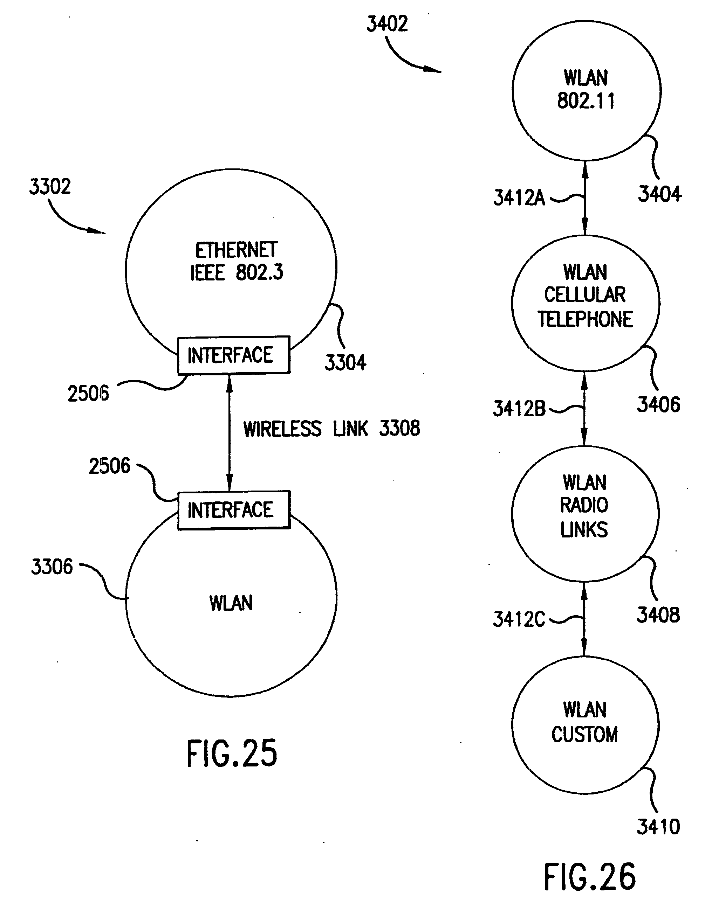

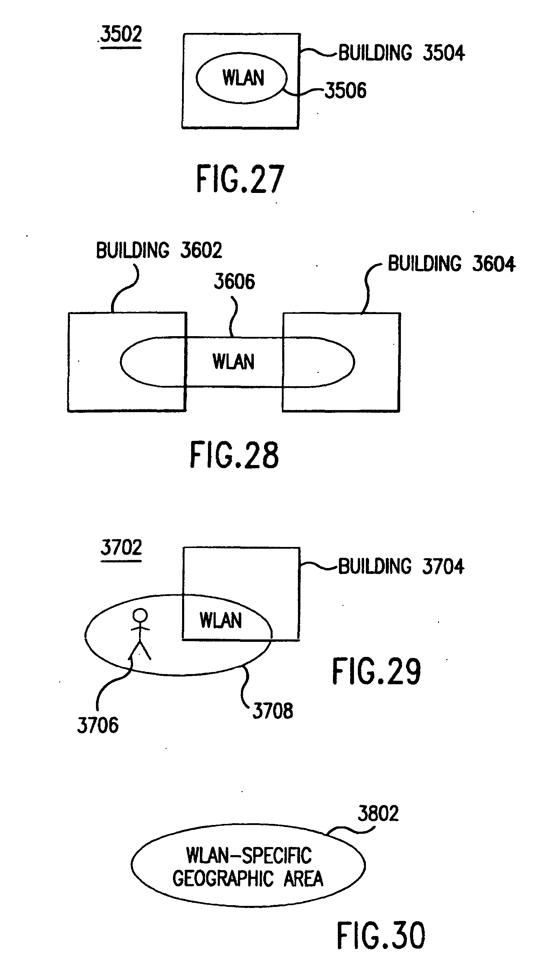

FIGS. 25-30 illustrate example environments;

FIG. 31 illustrates a block diagram of a WLAN interface;

FIG. 32 illustrates a WLAN receiver;

FIG. 33 illustrates a WLAN transmitter;

FIG. 34 relates to an example demodulator/modulator facilitation module for an example WLAN interface;

FIGS. 35A-C and 36 relate to an example receiver for an example WLAN interface;

FIGS. 37A-D, 38, 39A-D, 40A, and 40B relate to an example transmitter for an example WLAN interface;

FIGS. 41A-B illustrate IQ receivers having UFT modules in a series and shunt configurations;

FIGS. 42A-B illustrate IQ receivers having UFT modules with delayed control signals for quadrature implementation;

FIGS. 43A-B illustrate IQ receivers having FET implementations;

FIG. 44A and 44A-1 illustrates an IQ receiver having shunt UFT modules;

FIG. 44B illustrates control signal generator embodiments for receiver 3906;

FIGS. 44C-D illustrate various control signal waveforms;

FIG. 44E-1 and 44E-2 illustrates an example IQ modulation receiver;

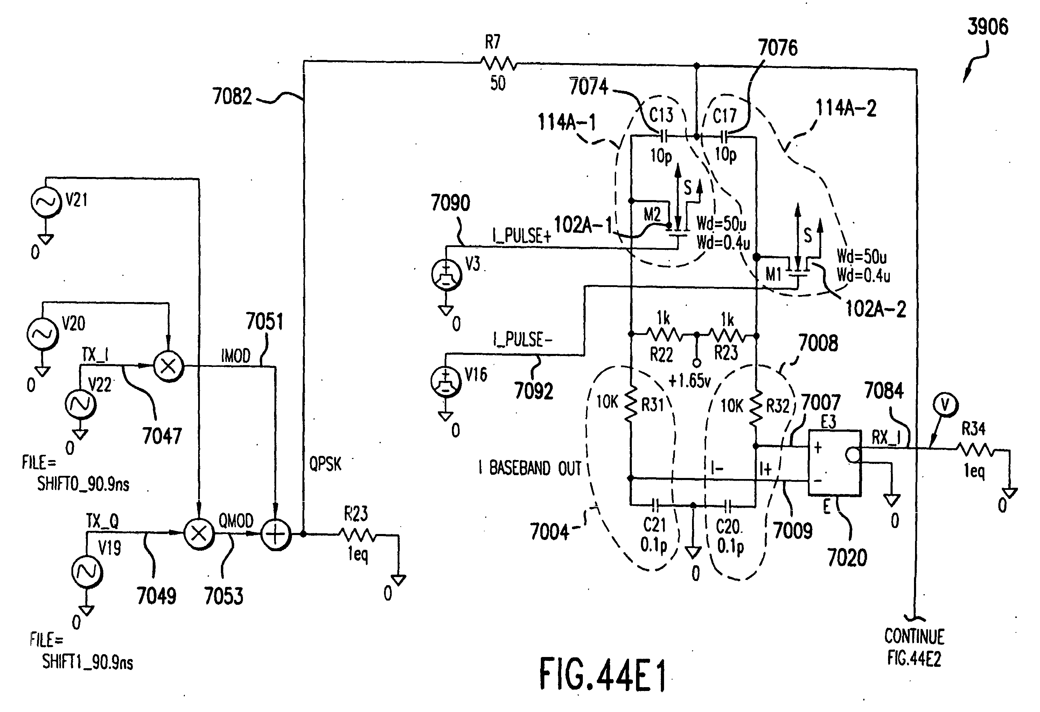

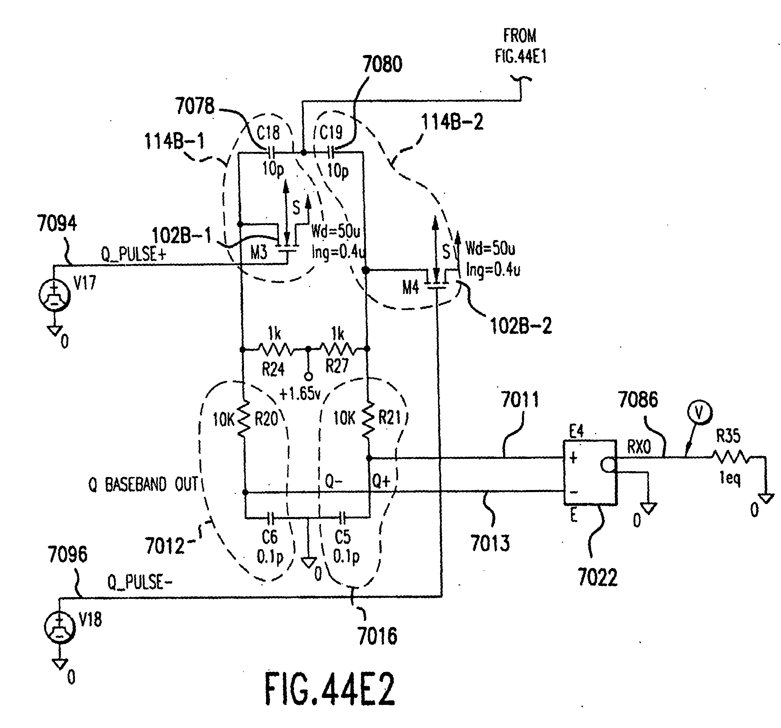

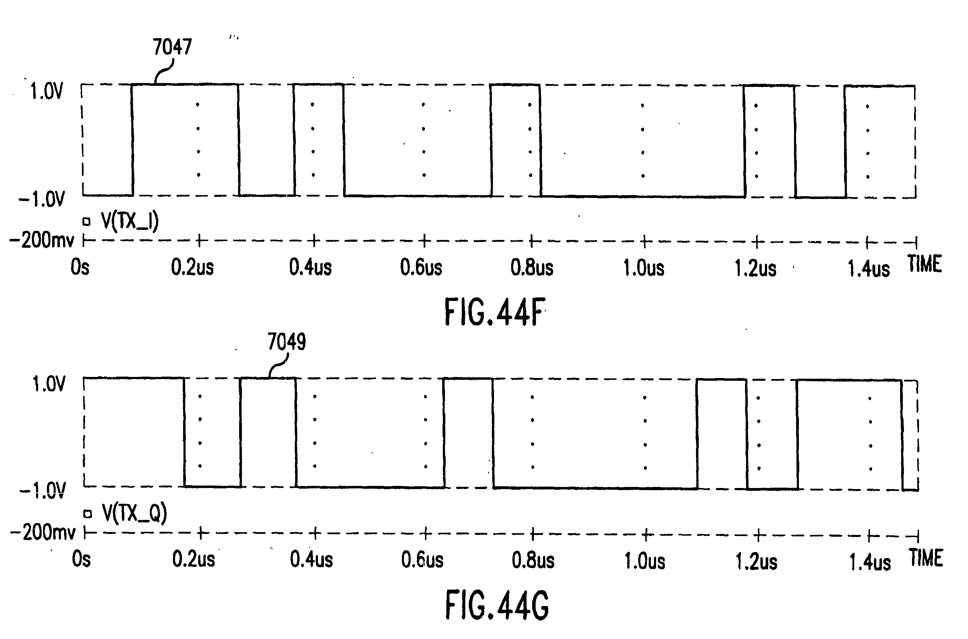

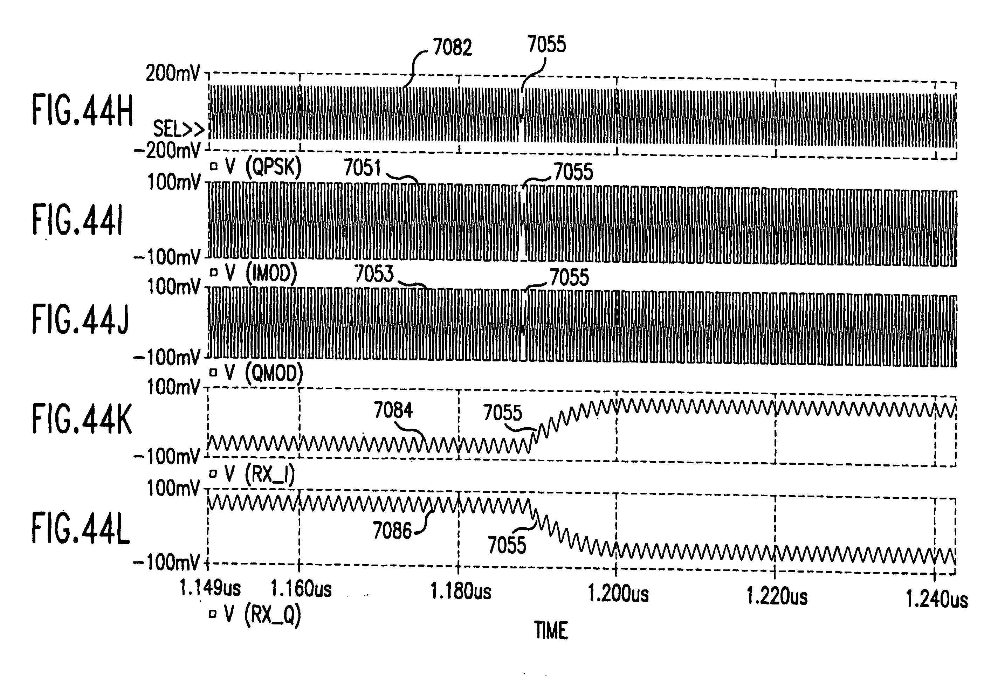

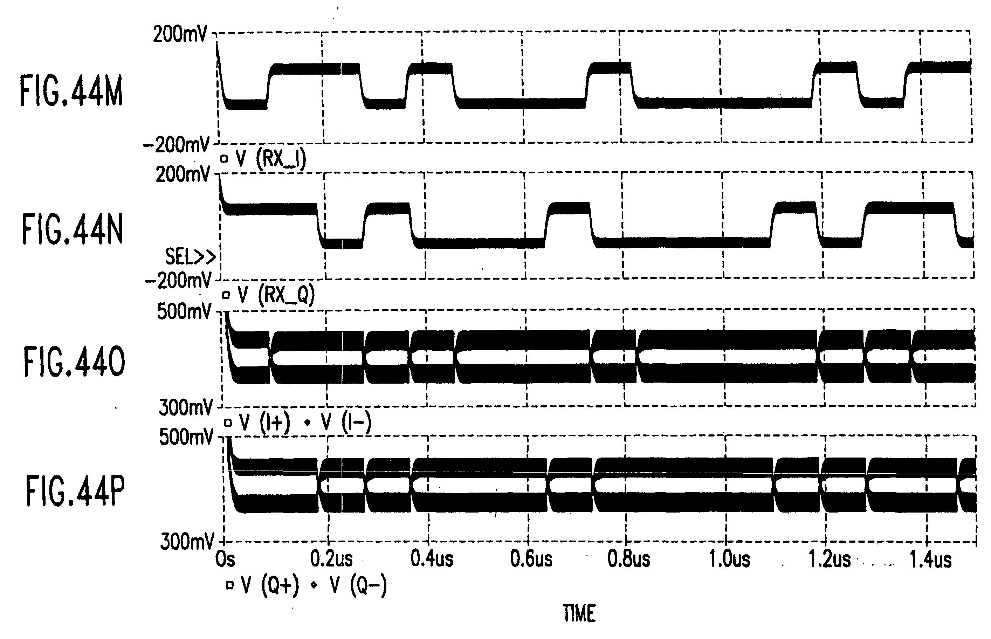

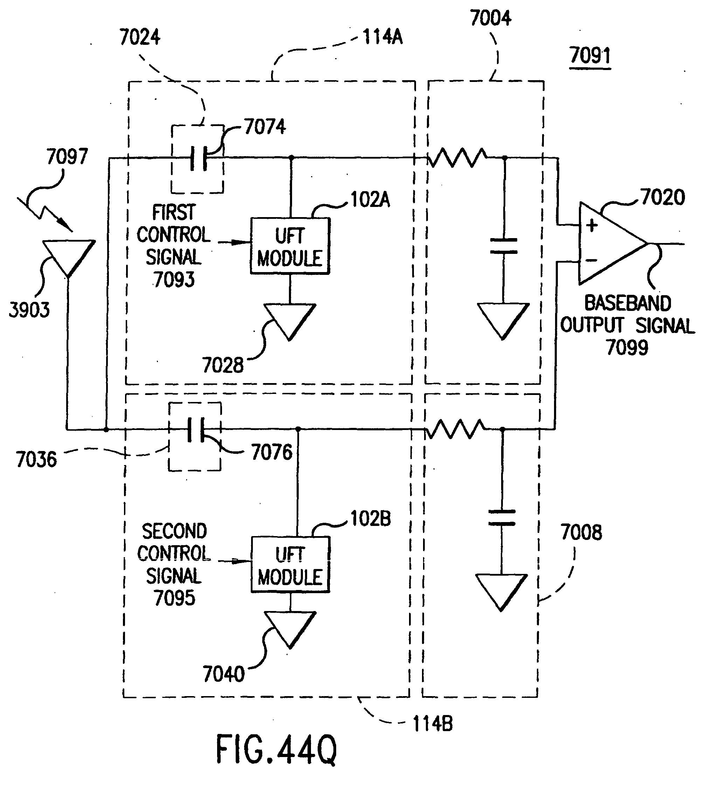

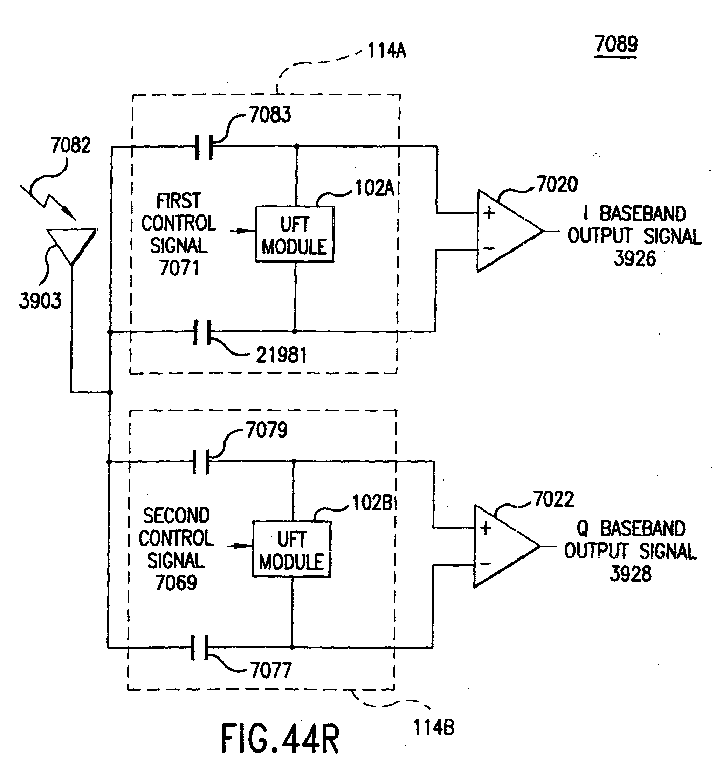

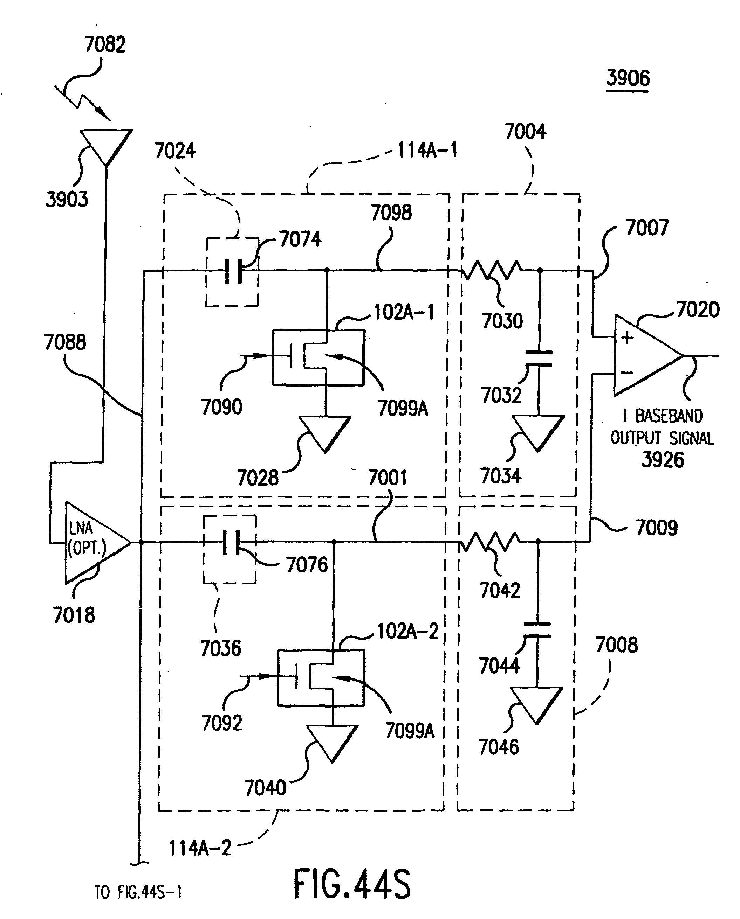

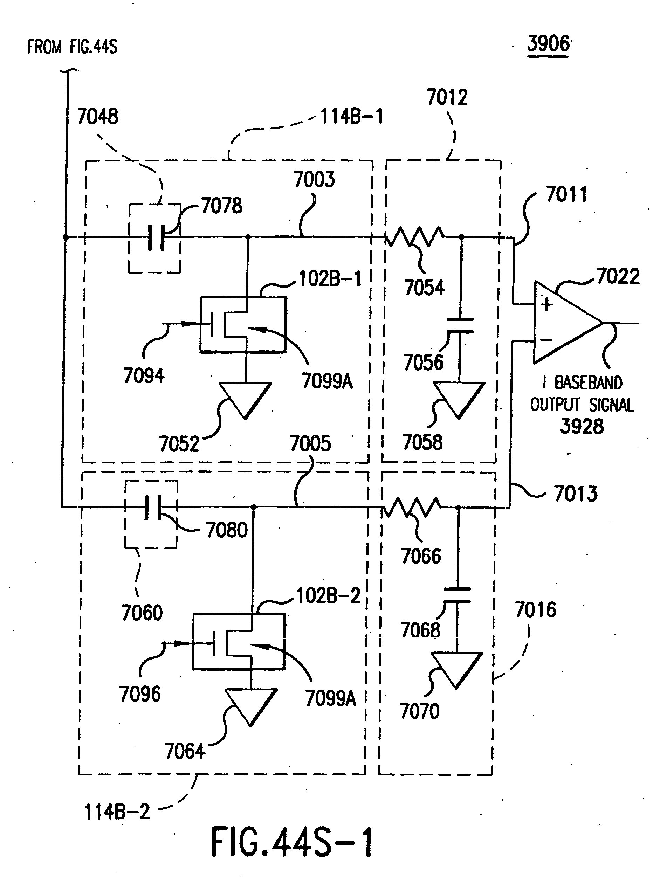

FIGS. 44F-P illustrate example waveforms that are representative of the IQ receiver in FIG. 44E;

FIGS. 44Q-R illustrate single channel receiver;

FIG. 44S and 44S-1 illustrate a FET configuration of an IQ receiver;

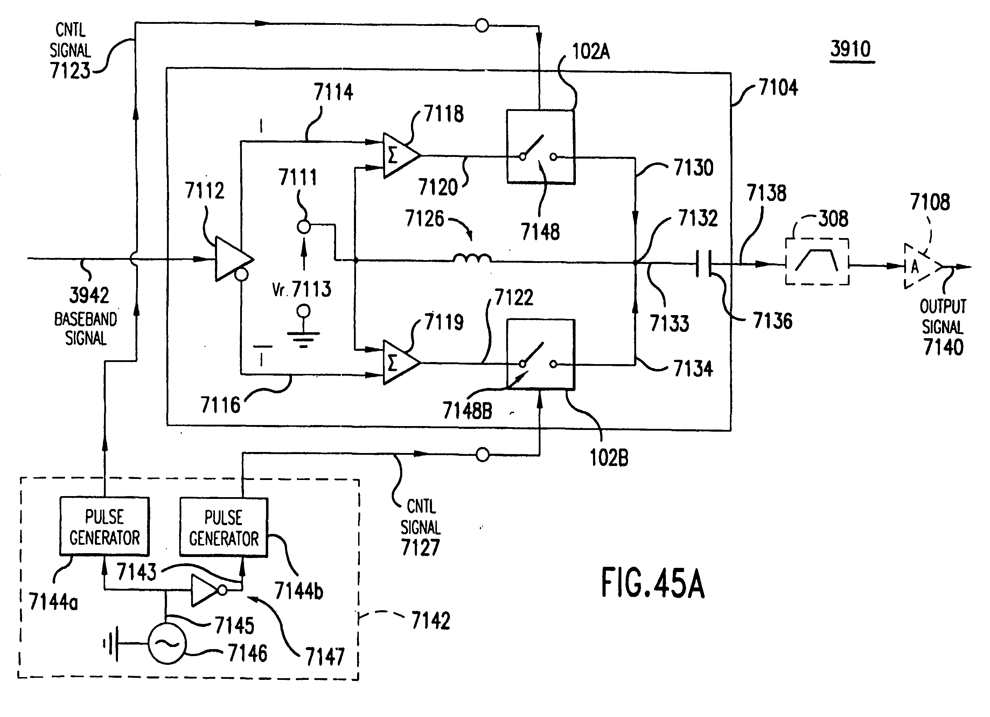

FIG. 45A illustrate a balanced transmitter 7102;

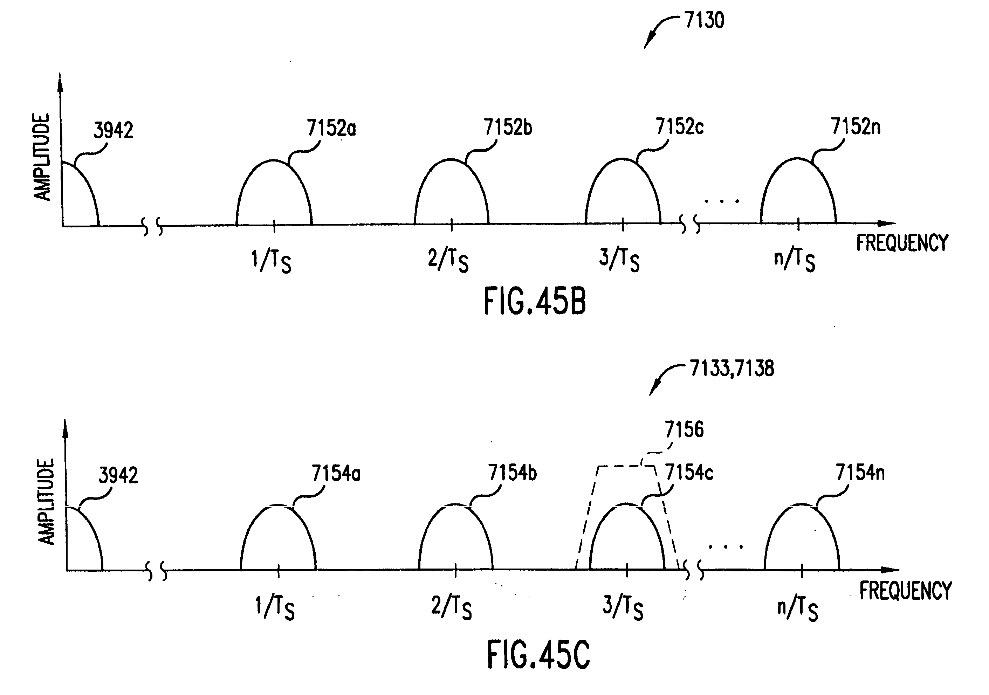

FIGs. 45B-C illustrate example waveforms that are associated with the balanced transmitter 7102;

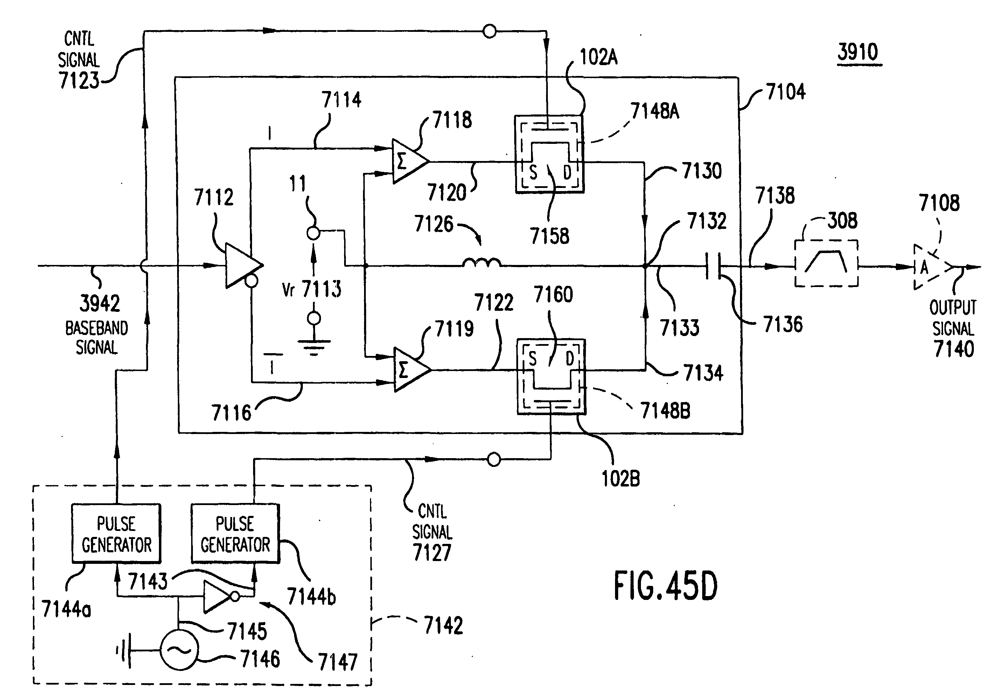

FIG. 45D illustrates example FET configurations of the balanced transmitter 7102;

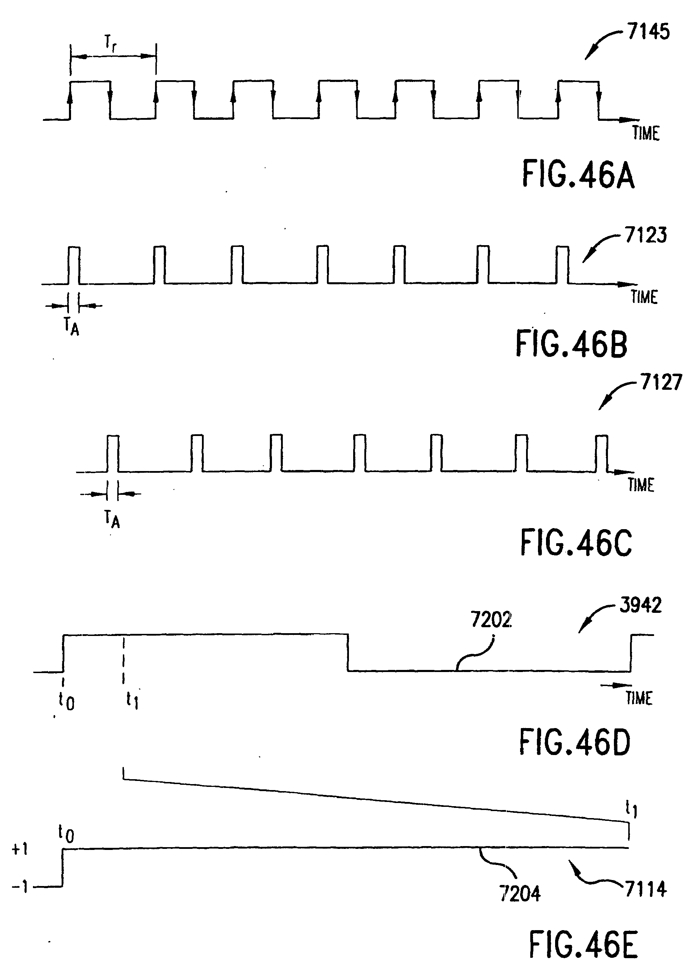

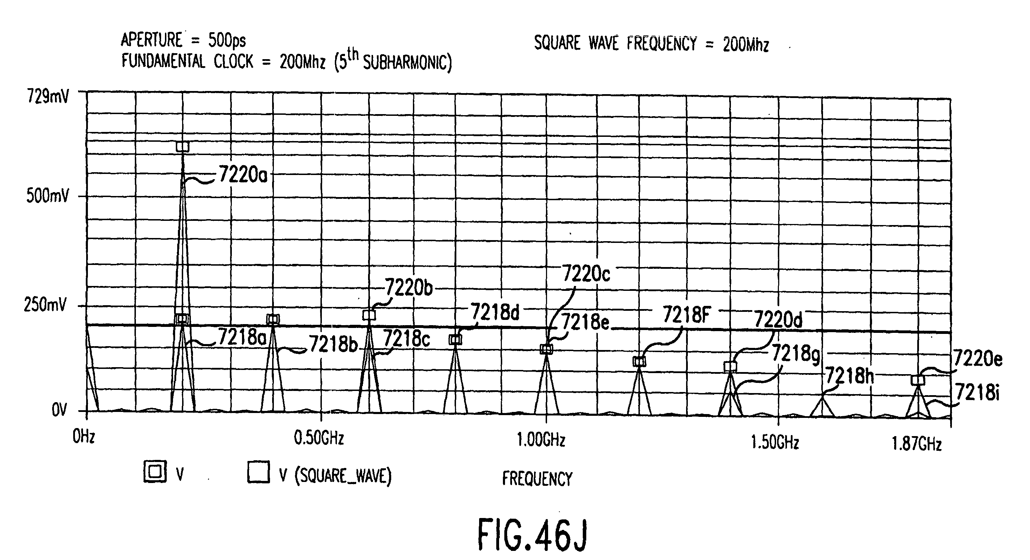

FIGs. 46A-I illustrate various example timing diagrams that are associated with the transmitter 7102;

FIG. 46J illustrates an example frequency spectrum that is associated with a modulator 7104;

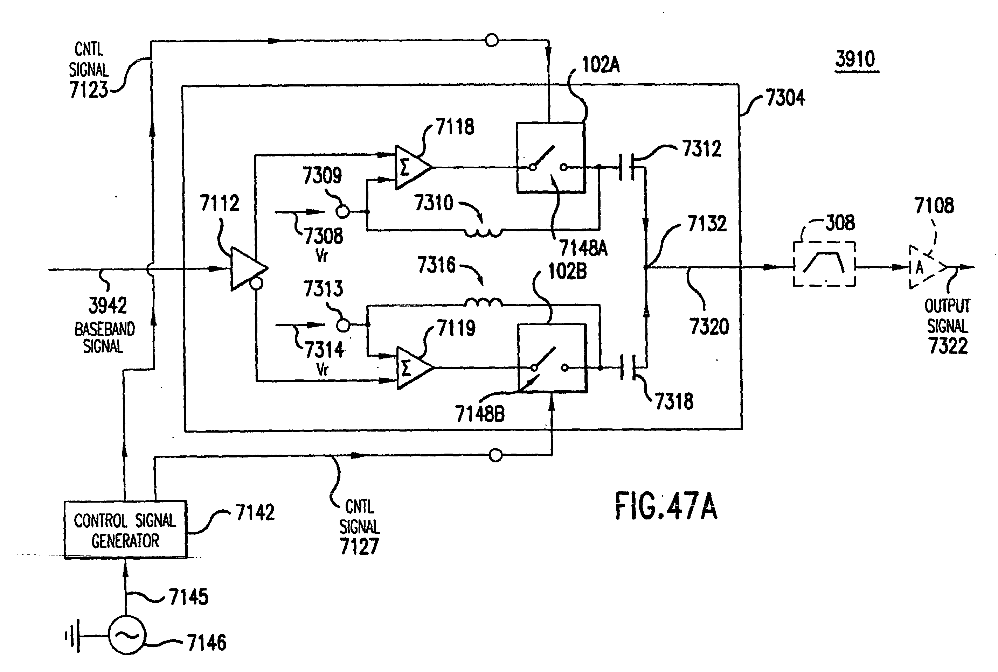

FIG. 47A illustrate a transmitter 7302 that is configured for carrier insertion;

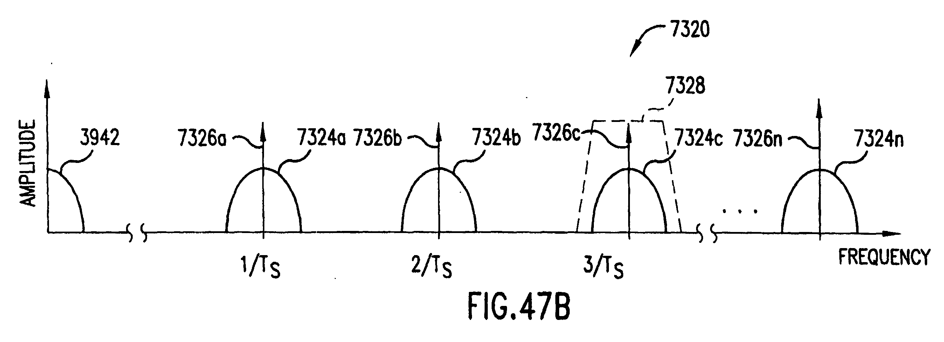

FIG. 47B illustrates example signals associated with the transmitter 7302;

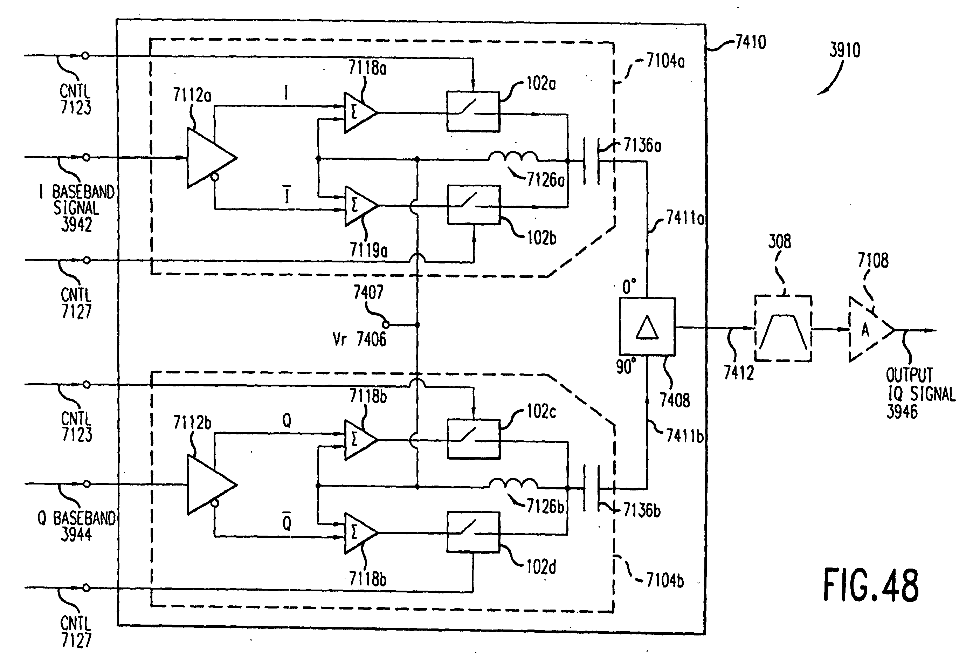

FIG. 48 illustrates an IQ balanced transmitter 3910;

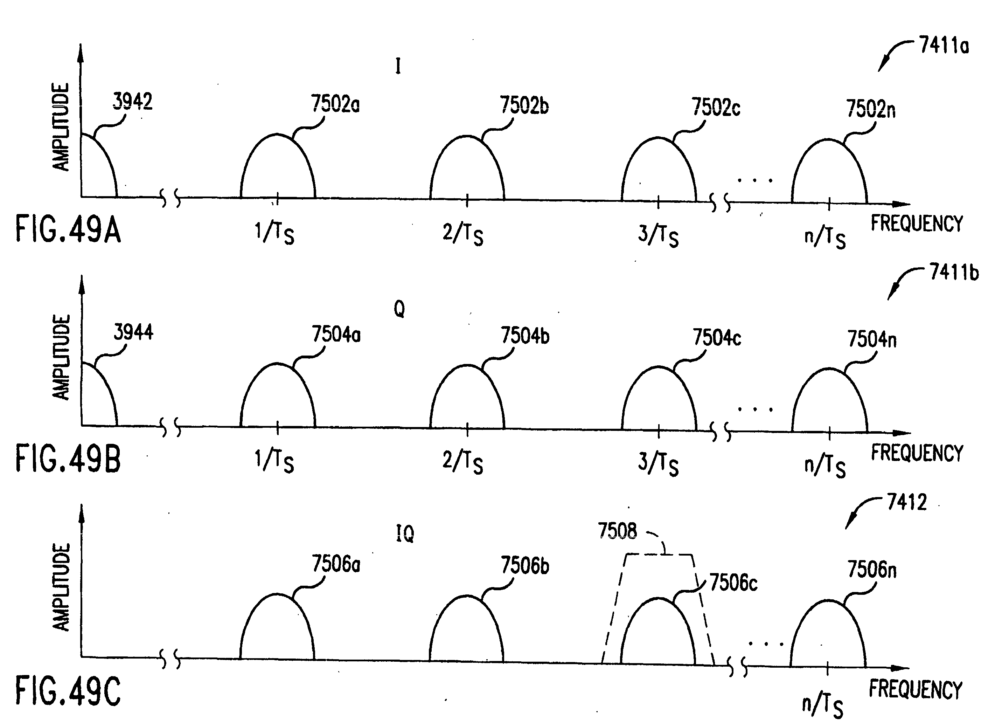

FIGs. 49A-C illustrate various example signal diagrams associated with the balanced transmitter 3910 in FIG. 48;

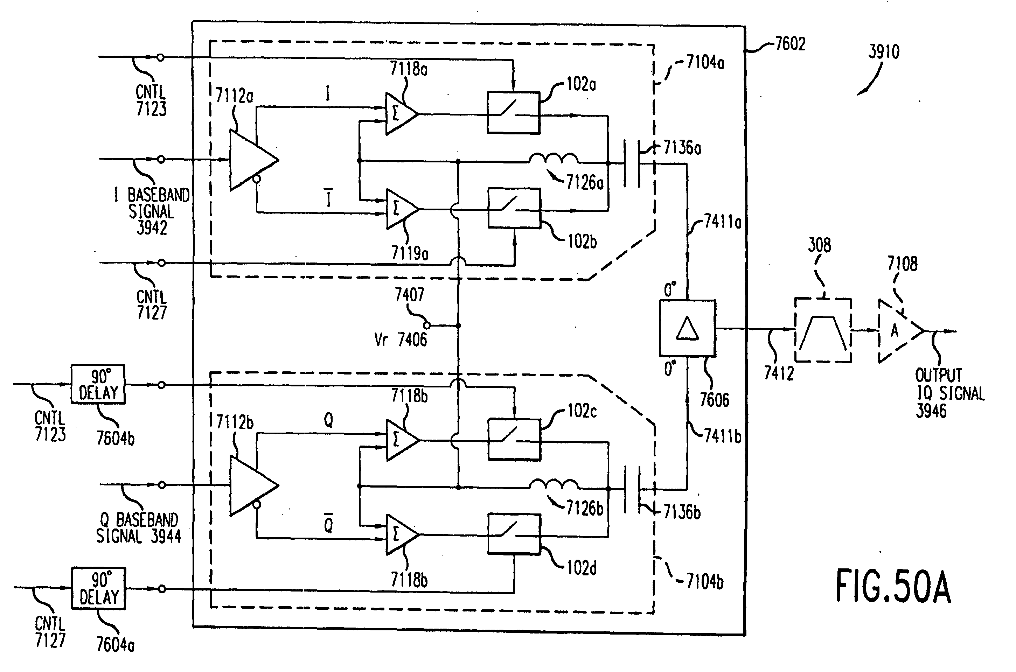

FIG. 50A illustrates an IQ balanced transmitter 7608;

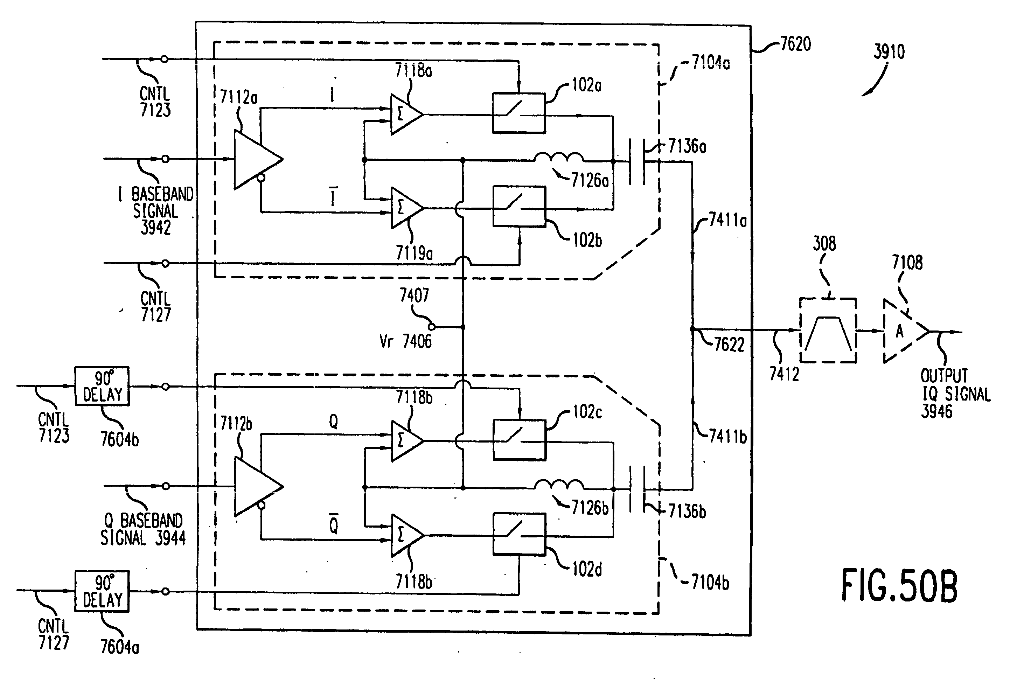

FIG. 50B illustrates an IQ balanced modulator 7618;

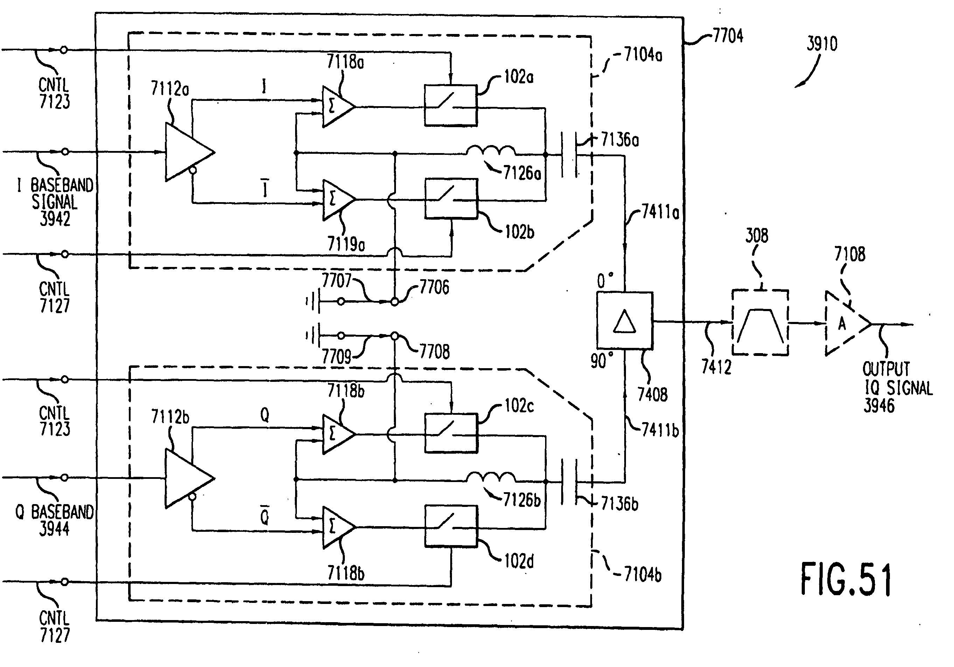

FIG. 51 illustrates an IQ balanced modulator 7702 configured for carrier insertion;

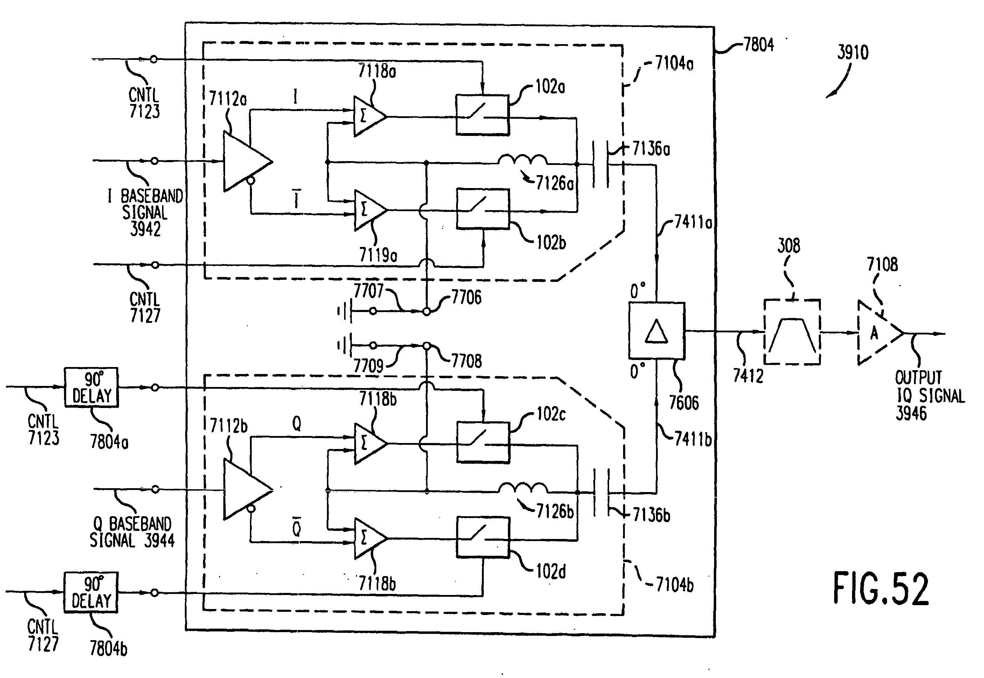

FIG. 52 illustrates an IQ balanced modulator 7802 configured for carrier insertion;

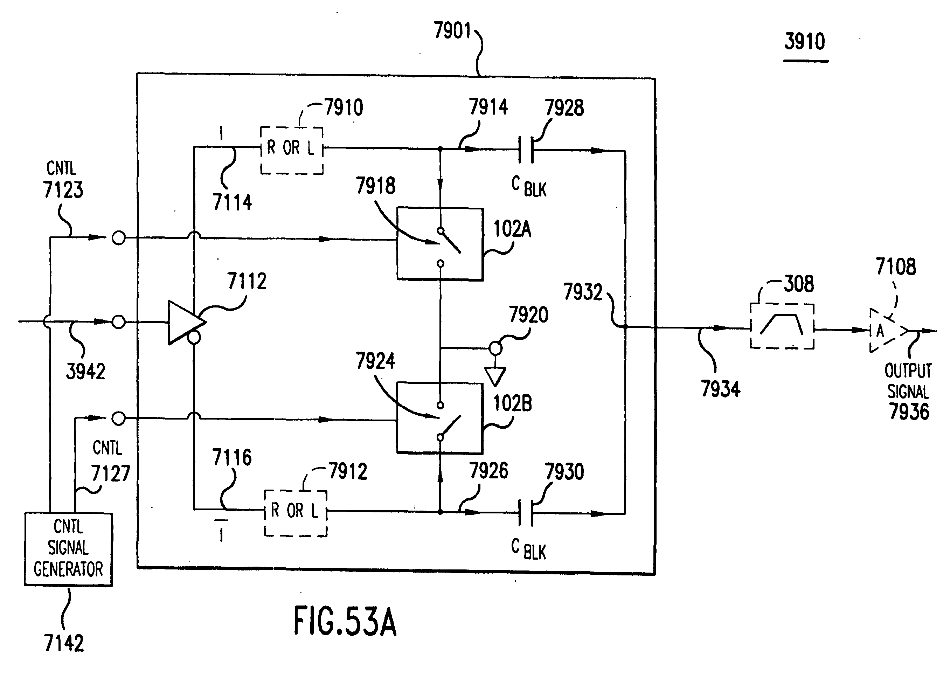

FIG. 53A illustrate a transmitter 3910;

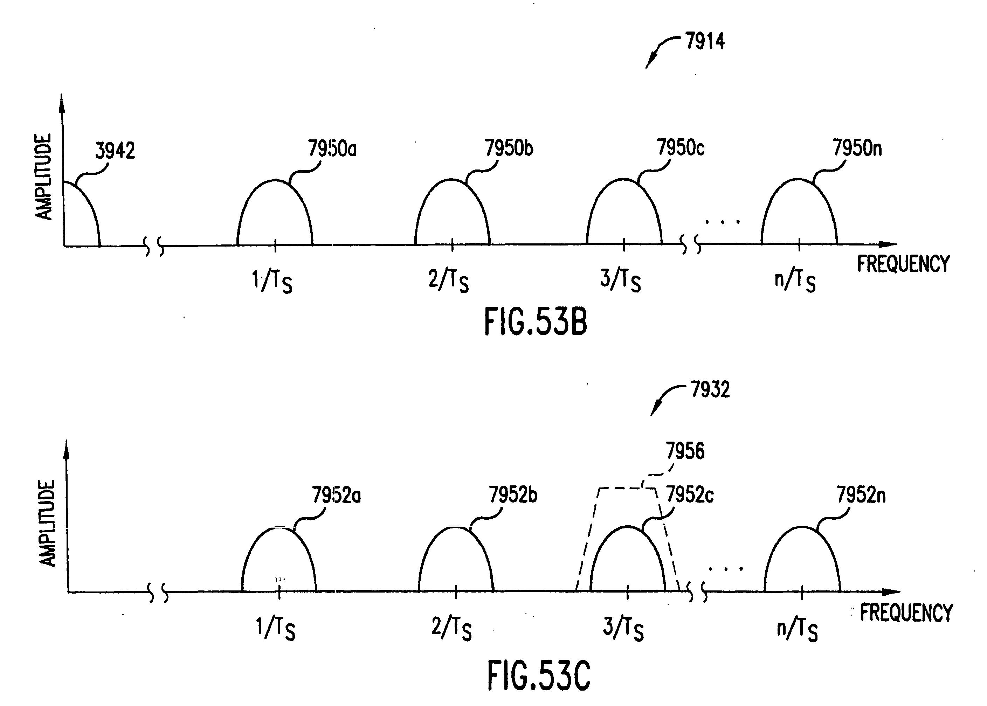

FIGs. 53B-C illustrate various frequency spectrums that are associated with the transmitter 3910;

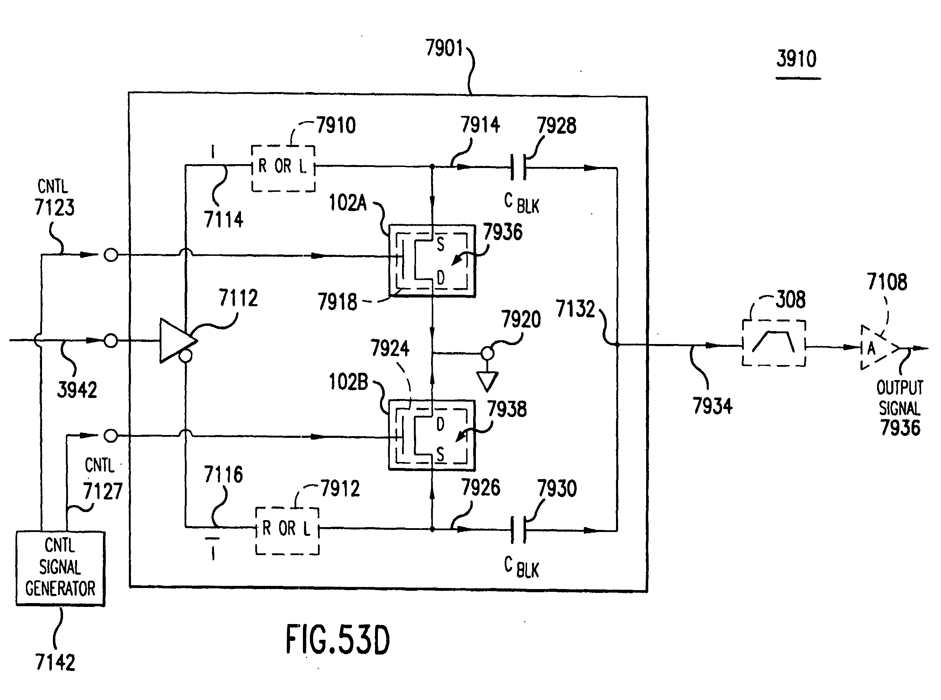

FIG. 53D illustrates a FET configuration for the transmitter 3910;

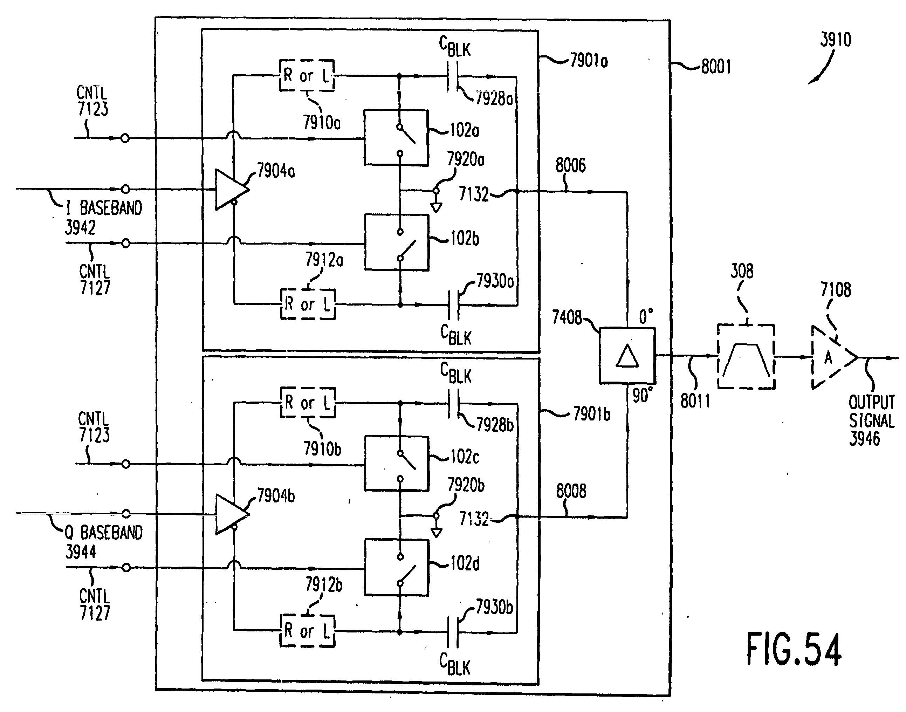

FIG. 54 illustrates an IQ transmitter 3910;

FIGs. 55A-C illustrate various frequency spectrums that are associated with the IQ transmitter 3910;

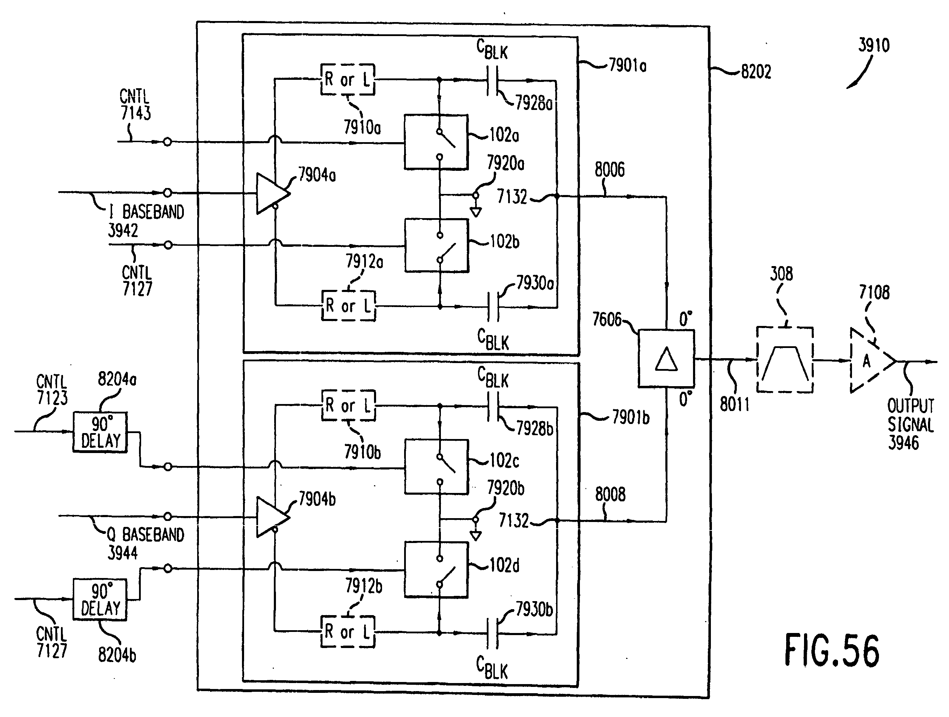

FIG. 56 illustrates an IQ transmitter 8200;

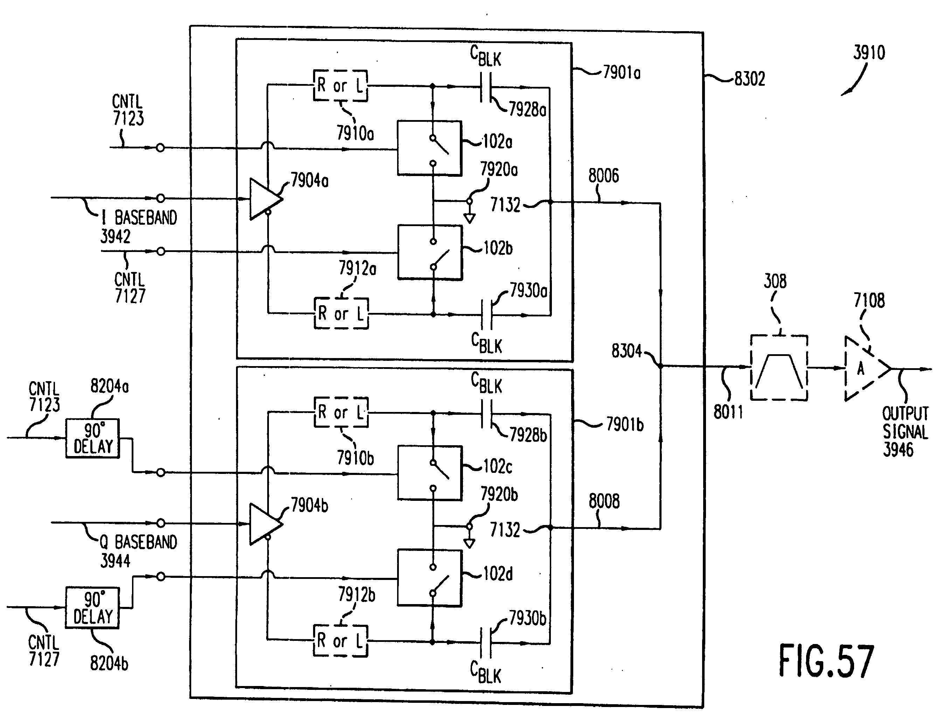

FIG. 57 illustrates an IQ transmitter 8300;

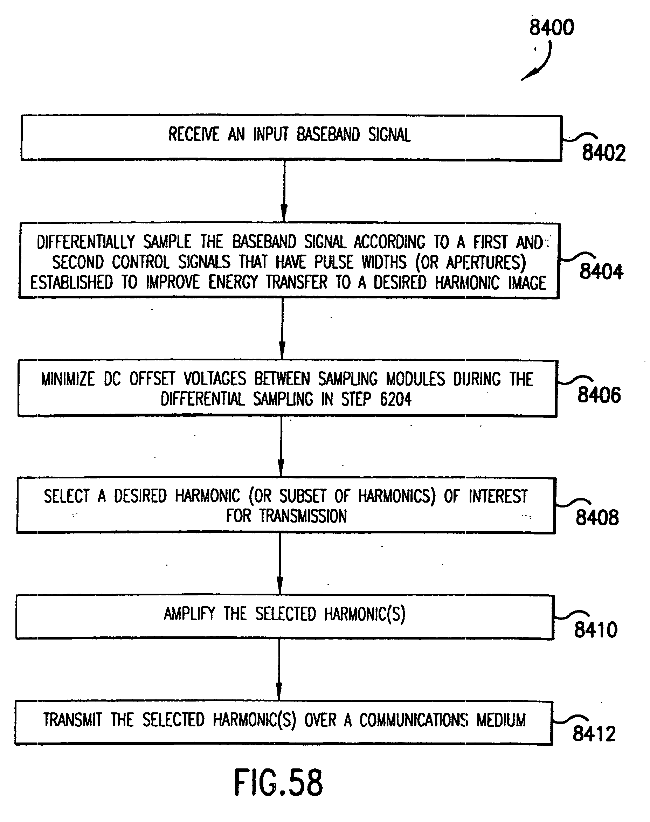

FIG. 58 illustrates a flowchart 8400 that is associated with the transmitter 7102 in the FIG. 45A;

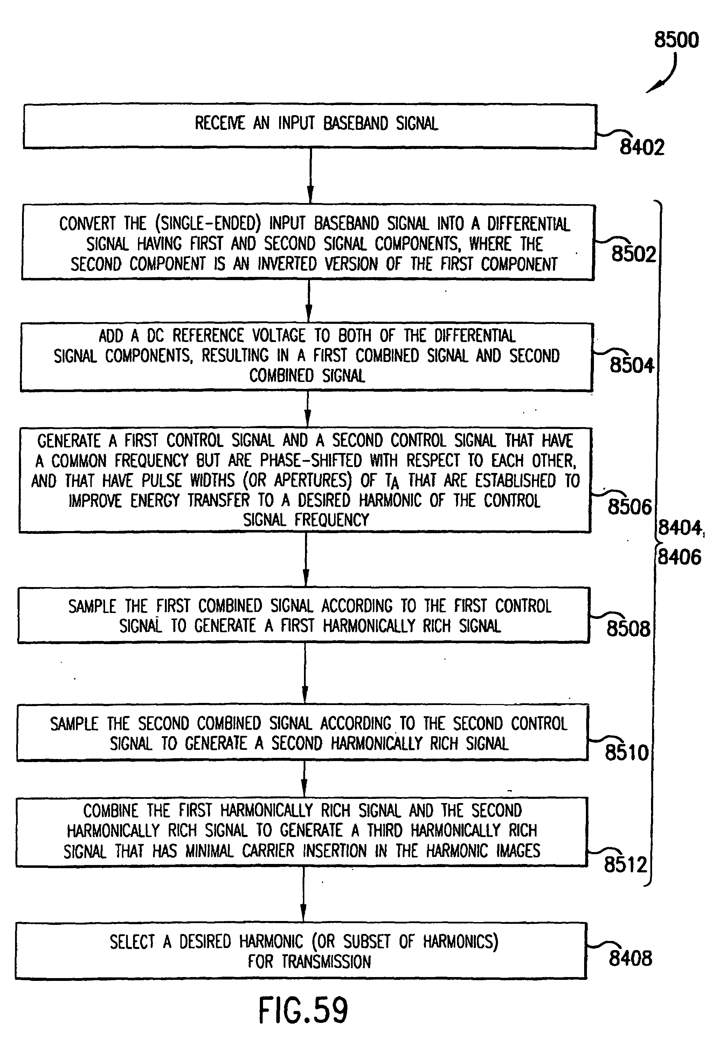

FIG. 59 illustrates a flowchart 8500 that further defines the flowchart 8400 in the FIG. 58, and is associated with the transmitter 7102;

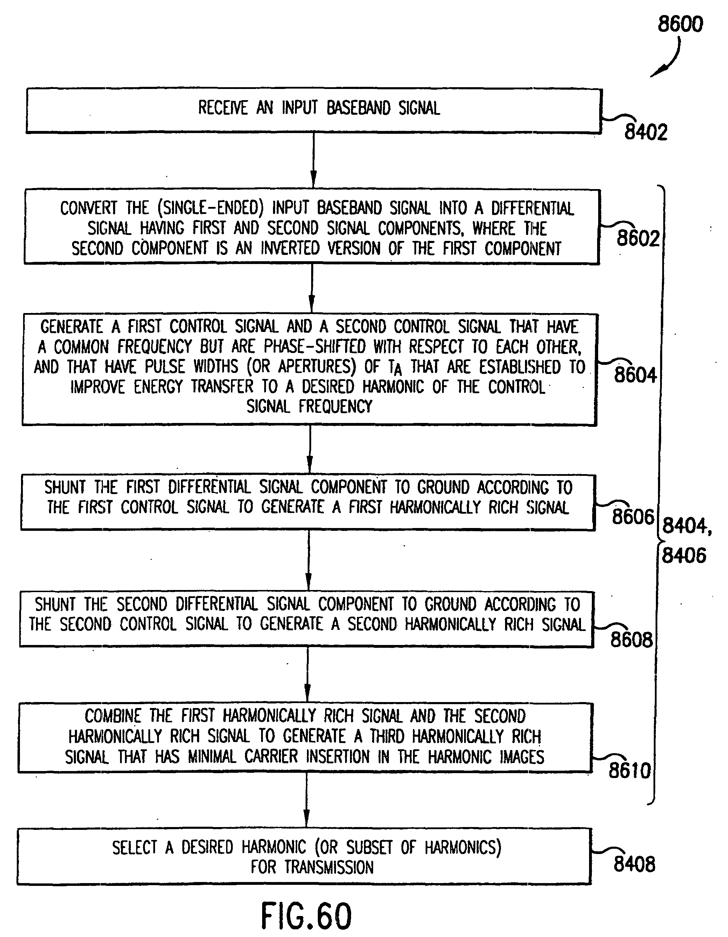

FIG. 60 illustrates a flowchart 8600 that is associated with the transmitter 3910 and further defines the flowchart 8400 in the FIG. 58;

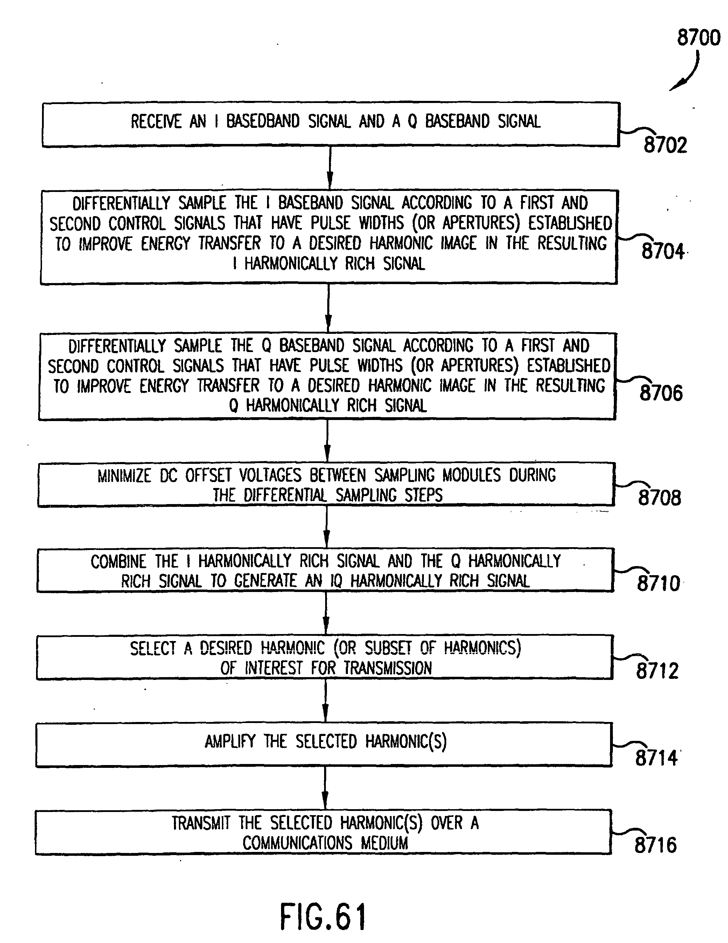

FIG. 61 illustrates a flowchart 8700, that is associated with the transmitter 7420 in the FIG. 48;

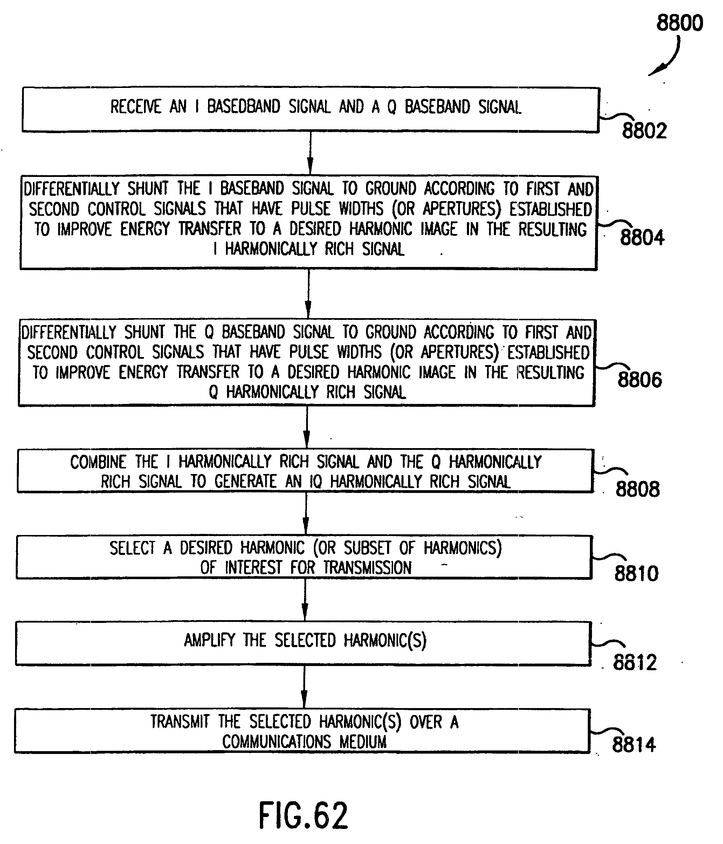

FIG. 62 illustrates a flowchart 8800 that is associated with the transmitter 3910;

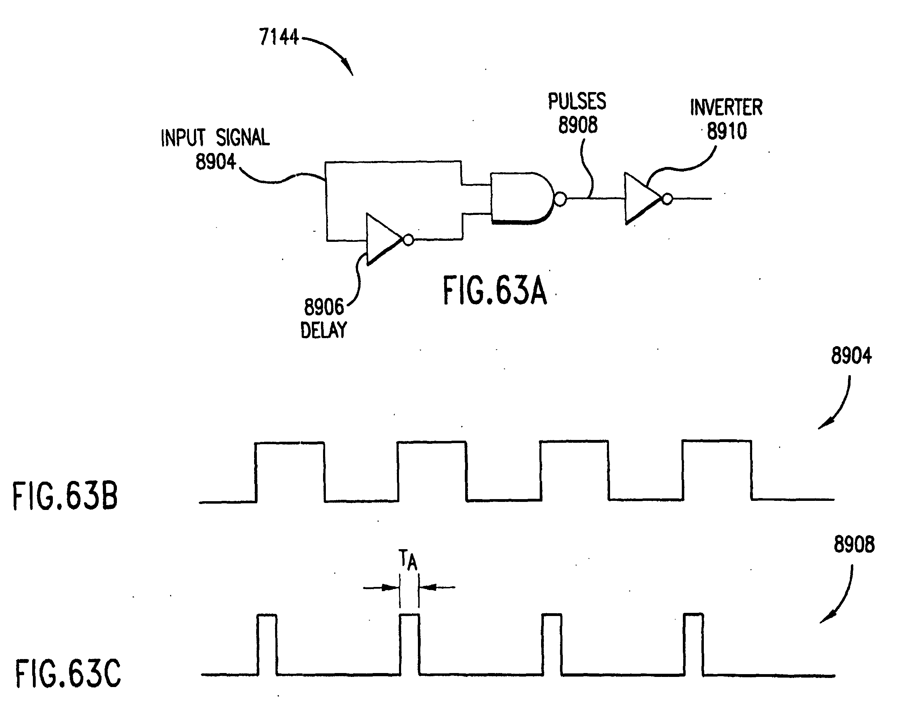

FIG. 63A illustrate a pulse generator,

FIGS. 63B-C illustrate various example signal diagrams associated with the pulse generator in FIG. 63A;

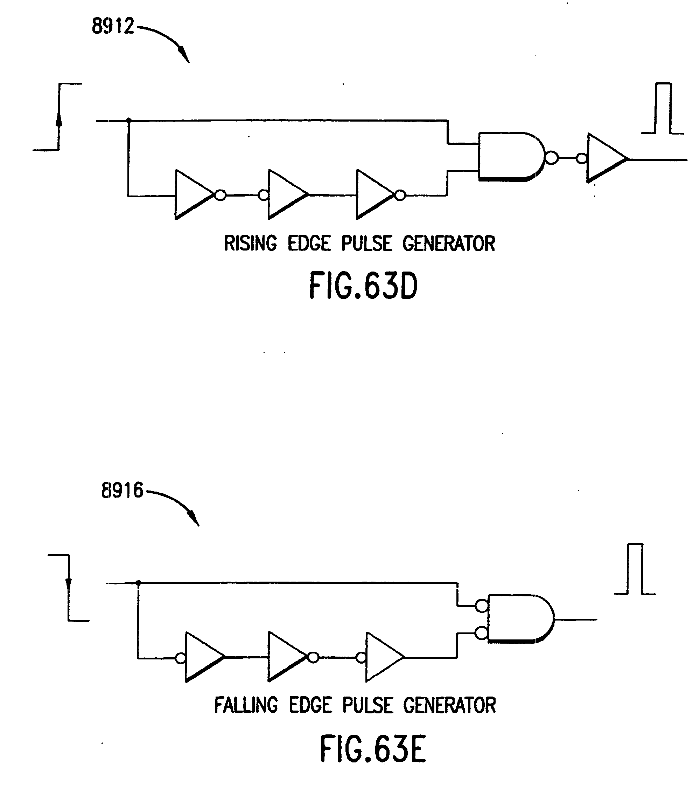

FIG. 63D-E illustrate various example pulse generators;

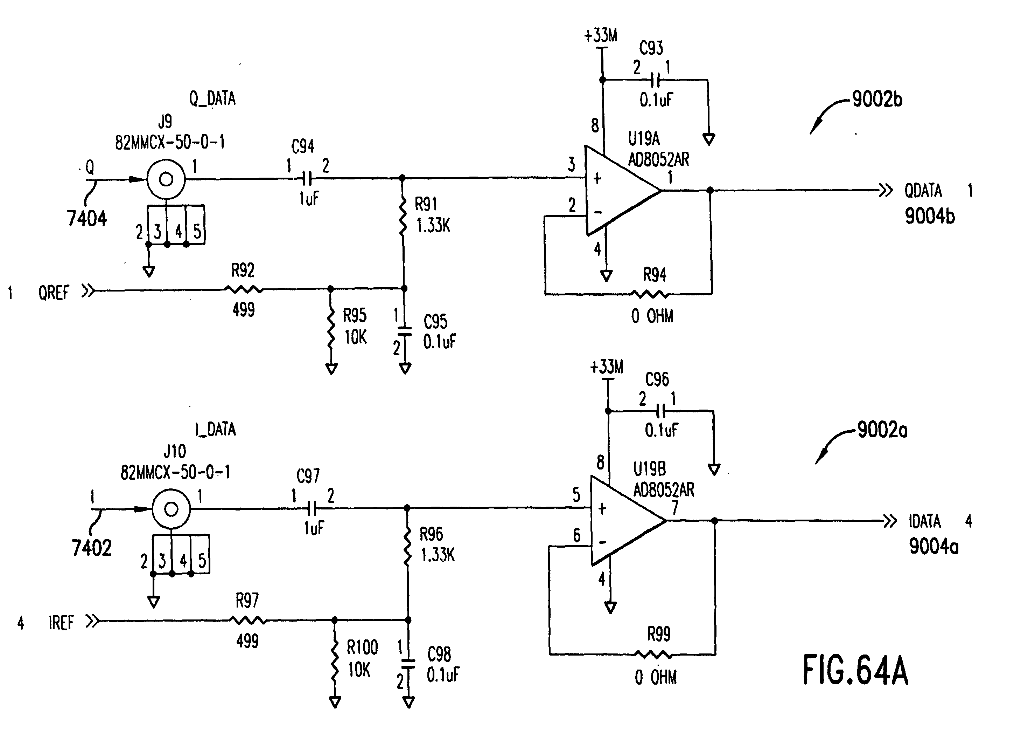

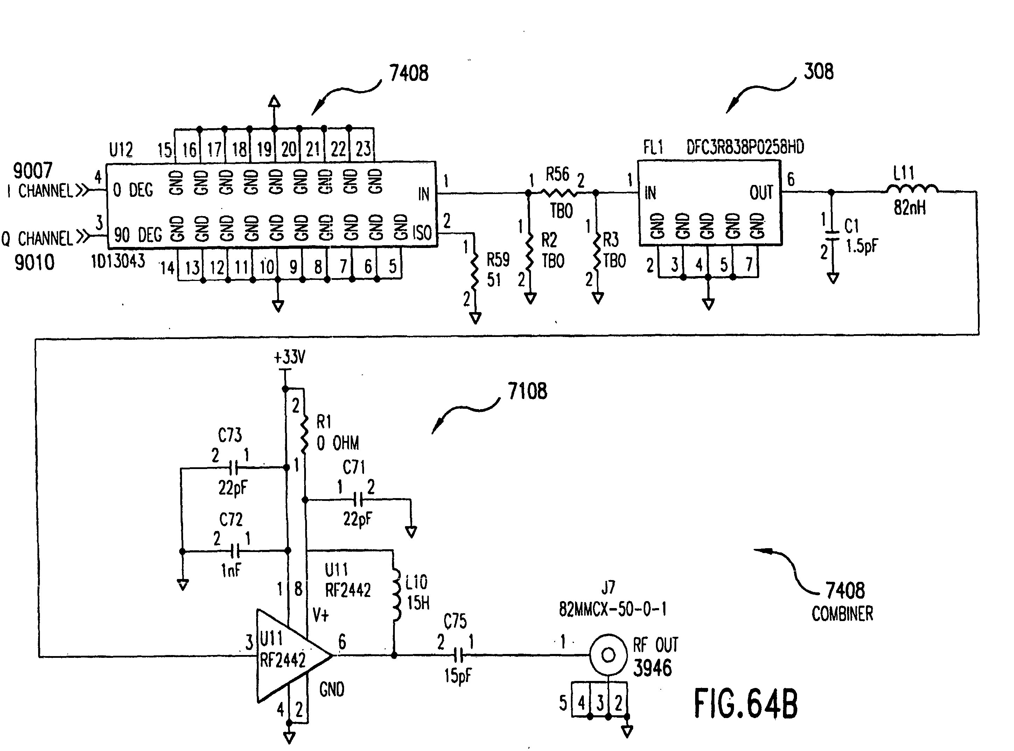

FIGS. 64A and B illustrate various implementation circuits for the modulator 7410;

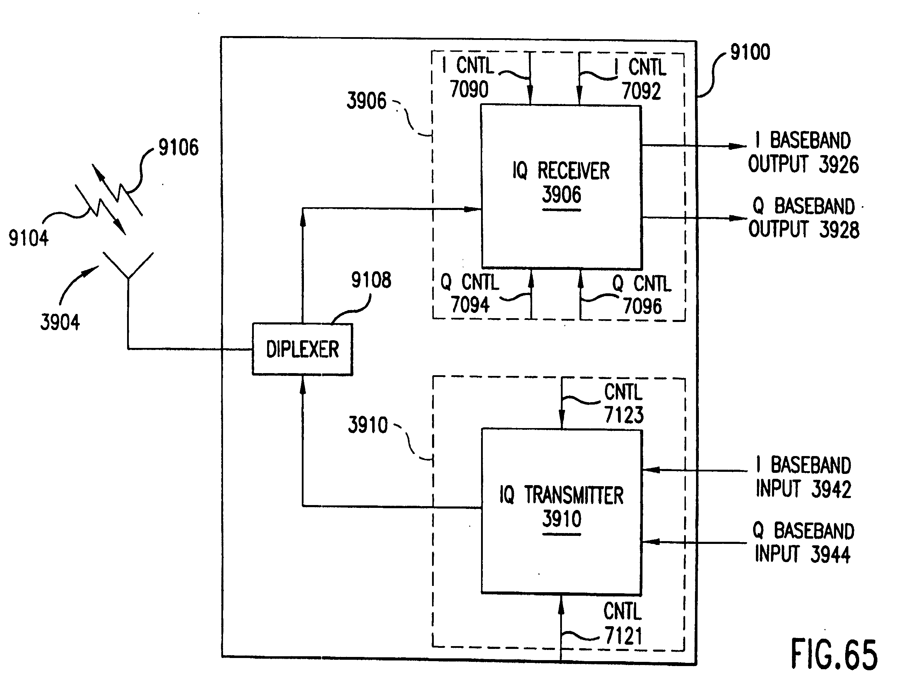

FIG. 65 illustrates an IQ transceiver 9100;

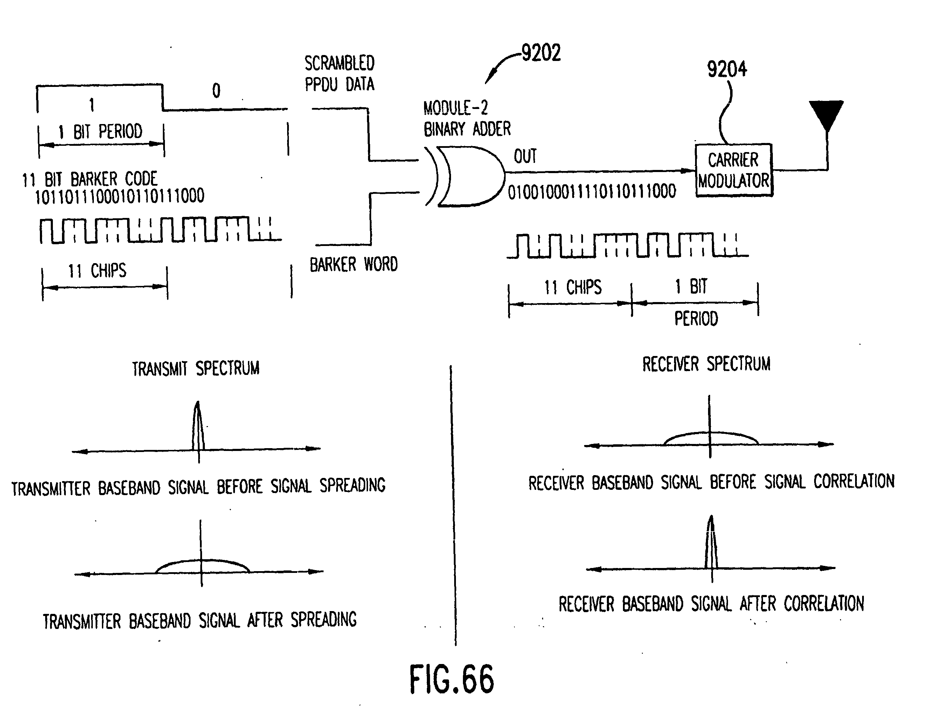

FIG. 66 illustrates direct sequence spread spectrum;

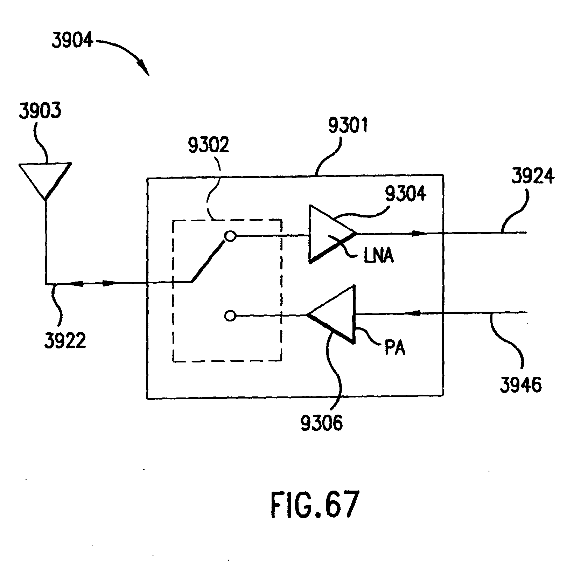

FIG. 67 illustrates the LNA/PA module 3904; and

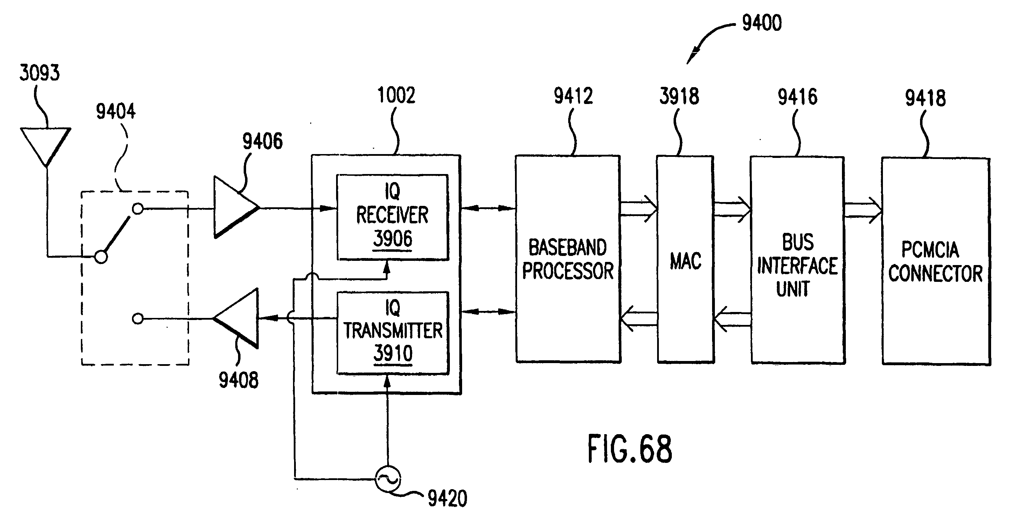

FIG. 68 illustrates a WLAN device 9400.

### *Detailed Description of the Preferred Embodiments*

| | Table of Contents | | | |
|---|---|---|---|---|
| 1. | Universal Frequency Translation | | | |
| 2. | Frequency Down-Conversion | | | |
| 3. | Frequency Up-Conversion | | | |
| 4.0 | Example WLAN Implementation Embodiments | | | |
| | 4.1 | Architecture | | |
| | 4.2 | Receiver | | |
| | | 4.2.1 | IQ Receiver | |
| | | 4.2.2 | Multi-Phase IQ Receiver | |
| | | | 4.2.2.1 | Example I/Q Modulation Control Signal Generator |
| | | | 4.2.2.2 | Implementation of Multi-phase I/Q Modulation Receiver Embodiment with Exemplary Waveforms |
| | | | 4.2.2.3 | Example Single Channel Receiver |
| | | | 4.2.2.4 | Alternative Example I/Q Modulation Receiver |
| | 4.3 | Transmitter | | |
| | | 4.3.1 | Universal Transmitter with 2 UFT Modules | |
| | | | 4.3.1.1 | Balanced Modulator Detailed Description |
| | | | 4.3.1.2 | Balanced Modulator Example Signal Diagrams and Mathematical Description |
| | | | 4.3.1.3 | Balanced Modulator Having a Shunt Configuration |
| | | | 4.3.1.4 | Balanced Modulator FET Configuration |
| | | | 4.3.1.5 | Universal Transmitter Configured for Carrier Insertion |
| | | 4.3.2 | Universal Transmitter In IQ Configuration | |
| | | | 4.3.2.1 | IQ Transmitter Using Series-Type Balanced Modulator |
| | | | 4.3.2.2 | IQ Transmitter Using Shunt-Type Balanced Modulator |
| | | | 4.3.2.3 | IQ Transmitters Configured for Carrier Insertion |
| | 4.4 | Transceiver Embodiments | | |

(continued)

| Table of Contents | | |
|---|---|---|
| | 4.5 | Demodulator/Modulator Facilitation Module |
| | 4.6 | MAC Interface |
| 5.0 | 802.11 | Physical Layer Configurations |
| 6.0 | Conclusions | |

### 1. Universal Frequency Translation

This section is related to frequency translation, and applications of same. Such applications include, but are not limited to, frequency down-conversion, frequency up-conversion, enhanced signal reception, unified down-conversion and filtering, and combinations and applications of same.

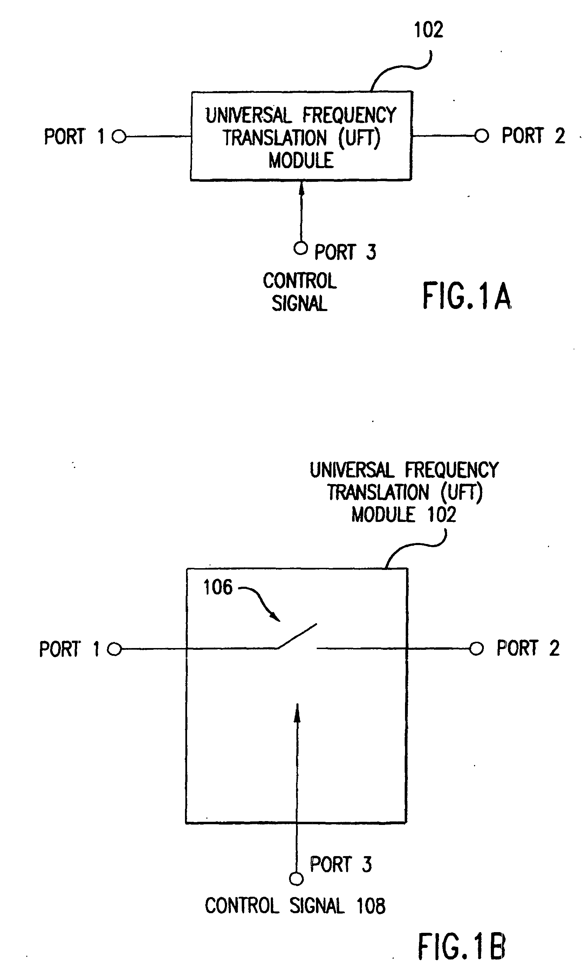

FIG. 1A illustrates a universal frequency translation (UFT) module 102.

As indicated by the example of FIG. 1A, some embodiments of the UFT module 102 include three ports (nodes), designated in FIG. 1A as Port 1, Port 2, and Port 3. Other UFT embodiments include other than three ports.

Generally, the UFT module 102 operates to generate an output signal from an input signal, where the frequency of the output signal differs from the frequency of the input signal. In other words, the UFT module 102 operates to generate the output signal from the input signal by translating the frequency of the input signal to the frequency of the output signal.

An example embodiment of the UFT module 102 is generally illustrated in FIG. 1B. Generally, the UFT module 102 includes a switch 106 controlled by a control signal 108. The switch 106 is said to be a controlled switch.

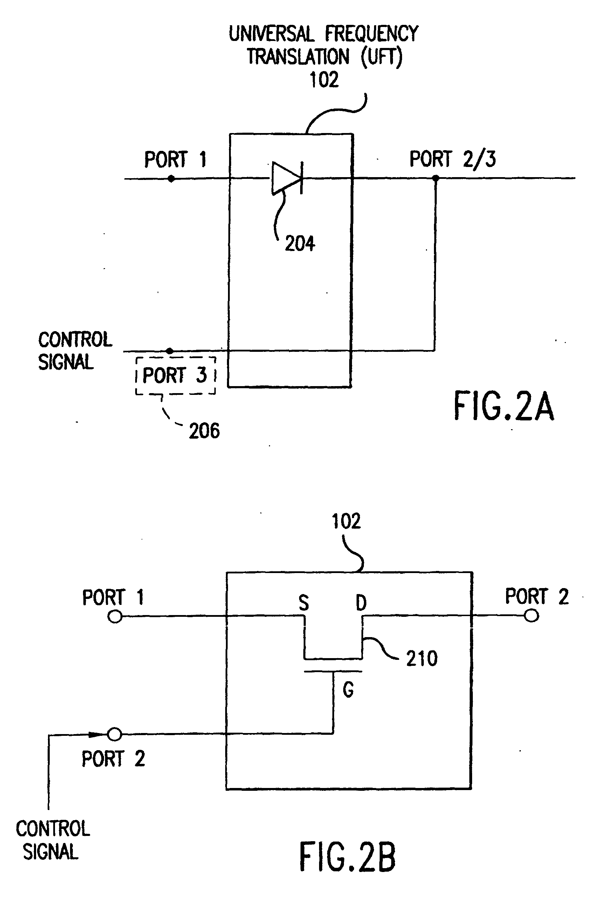

Some UFT embodiments include other than three ports. For example, FIG. 2 illustrates an example UFT module 102. The example UFT module 102 includes a diode 204 having two ports, designated as Port 1 and Port 2/3. This embodiment does not include a third port, as indicated by the dotted line around the "Port 3" label.

The UFT module is a very powerful and flexible device. Its flexibility is illustrated, in part, by the wide range of applications in which it can be used. Its power is illustrated, in part, by the usefulness and performance of such applications.

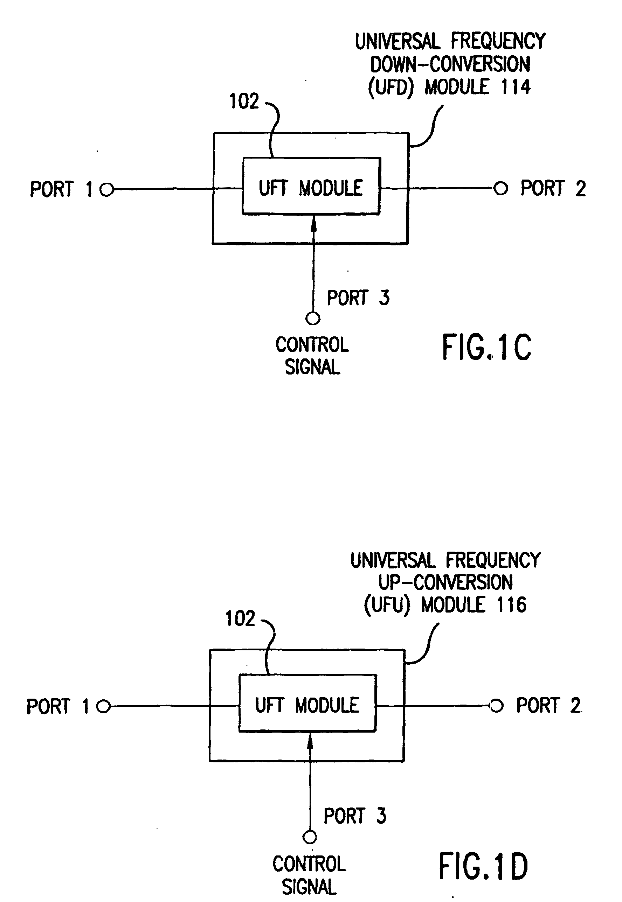

For example, a UFT module 102 can be used in a universal frequency down-conversion (UFD) module 114, an example of which is shown in FIG. 1C. In this capacity, the UFT module 102 frequency down-converts an input signal to an output signal.

As another example, as shown in FIG. 1D, a UFT module 102 can be used in a universal frequency up-conversion (UFU) module 116. In this capacity, the UFT module 102 frequency up-converts an input signal to an output signal.

These and other applications of the UFT module are described below. Additional applications of the UFT module will be apparent to persons skilled in the relevant art(s) based on the teachings contained herein.

### 2. Frequency Down-Conversion

This section is directed to systems and methods of universal frequency down-conversion, and applications of same. More specifically, an input signal is down-converted to produce a down-converted signal that exists at a lower frequency or a baseband signal.

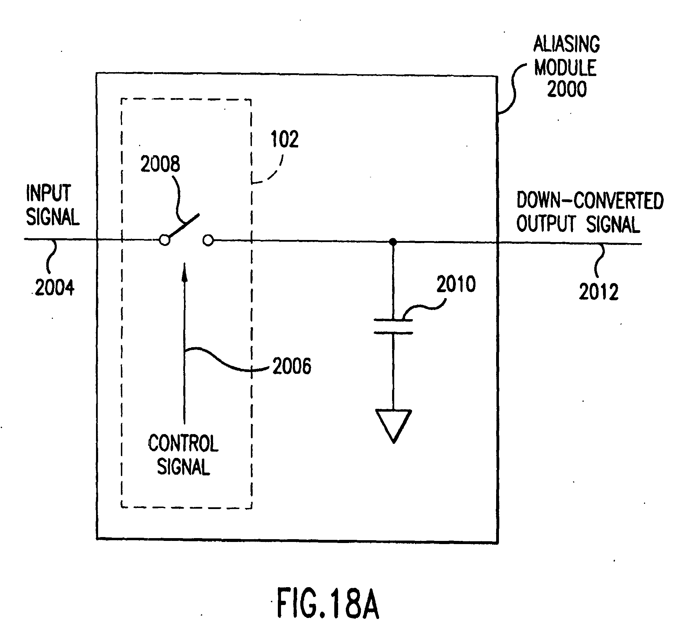

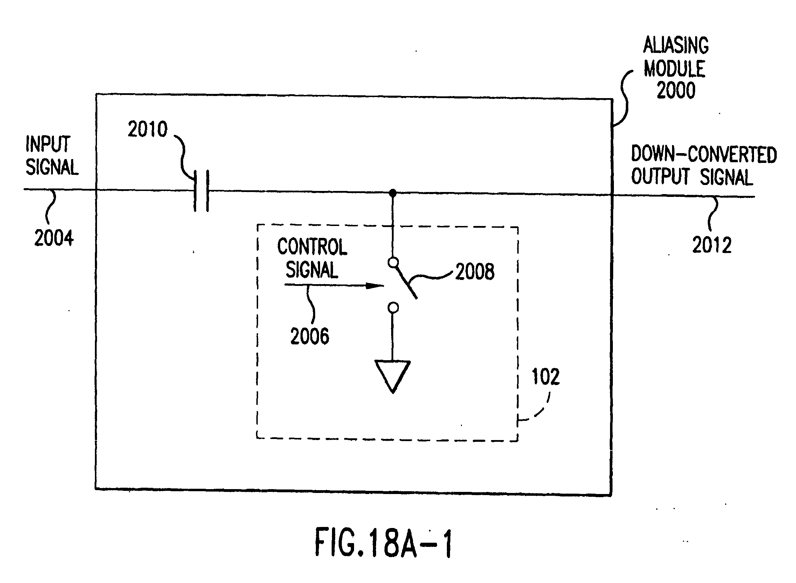

FIG. 18A illustrates an aliasing module 2000 (also called a universal frequency down-conversion module) for down-conversion using a universal frequency translation (UFT) module 102 which down-converts an EM input signal 2004. Aliasing module 2000 includes a switch 2008 and a capacitor 2010. The electronic alignment of the circuit components is flexible. That is, in one example, the switch 2008 is in series with input signal 2004 and capacitor 2010 is shunted to ground (although it may be other than ground in configurations such as differential mode). In a second example (see FIG. 18A-1), the capacitor 2010 is in series with the input signal 2004 and the switch 2008 is shunted to ground (although it may be other than ground in configurations such as differential mode). Aliasing module 2000 with UFT module 102 can be easily tailored to down-convert a wide variety of electromagnetic signals using aliasing frequencies that are well below the frequencies of the EM input signal 2004.

In one implementation, aliasing module 2000 down-converts the input signal 2004 to an intermediate frequency (IF) signal. In another example, the aliasing module 2000 down-converts the input signal 2004 to a demodulated baseband signal. In yet another implementation, the input signal 2004 is a frequency modulated (FM) signal, and the aliasing module 2000 down-converts it to a non-FM signal, such as a phase modulated (PM) signal or an amplitude modulated (AM) signal. Each of the above implementations is described below.

The control signal 2006 includes a train ofpulses that repeat at an aliasing rate that is equal to, or less than, twice the frequency of the input signal 2004. The control signal 2006 is referred to herein as an aliasing signal because it is below the Nyquist rate for the frequency of the input signal 2004. Preferably, the frequency of control signal 2006 is much less than the input signal 2004.

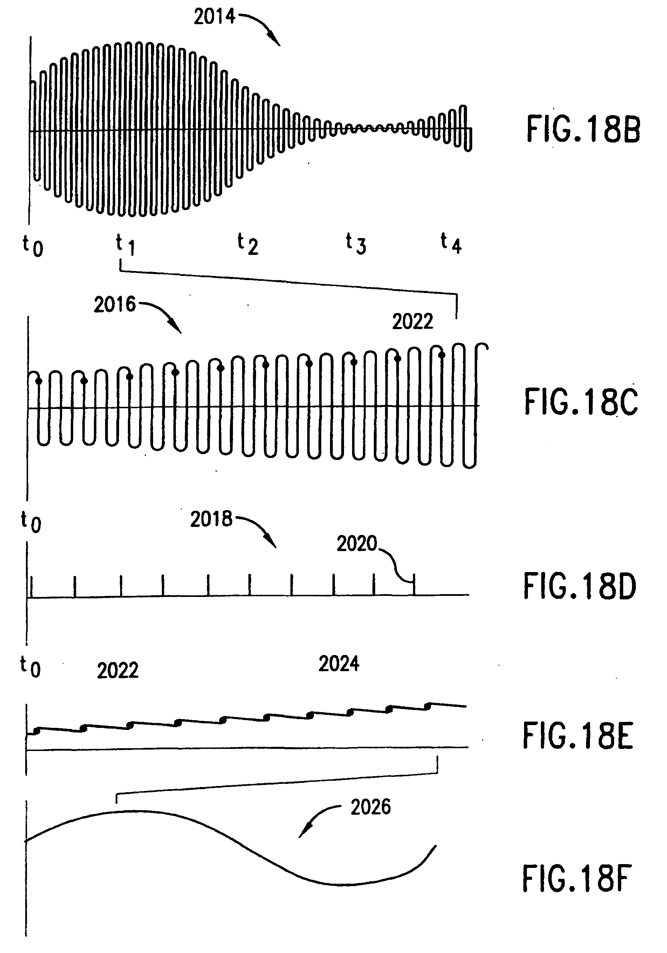

A train of pulses 2018 as shown in FIG. 18D controls the switch 2008 to alias the input signal 2004 with the control signal 2006 to generate a down-converted output signal 2012. More specifically, in an embodiment, switch 2008 closes on a first edge of each pulse 2020 of FIG. 18D and opens on a second edge of each pulse. When the switch 2008 is closed, the input signal 2004 is coupled to the capacitor 2010, and charge is transferred from the input signal to the capacitor 2010. The charge stored during successive pulses forms down-converted output signal 2012.

Exemplary waveforms are shown in FIGS. 18B-18F.

FIG. 18B illustrates an analog amplitude modulated (AM) carrier signal 2014 that is an example of input signal 2004. For illustrative purposes, in FIG. 18C, an analog AM carrier signal portion 2016 illustrates a portion of the analog AM carrier signal 2014 on an expanded time scale. The analog AM carrier signal portion 2016 illustrates the analog AM carrier signal 2014 from time $t_0$ to time $t_1$.

FIG. 18D illustrates an exemplary aliasing signal 2018 that is an example of control signal 2006. Aliasing signal 2018 is on approximately the same time scale as the analog AM carrier signal portion 2016. In the example shown in FIG. 18D, the aliasing signal 2018 includes a train of pulses 2020 having negligible apertures that tend towards zero. The pulse aperture may also be referred to as the pulse width as will be understood by those skilled in the art (s). The pulses 2020 repeat at an aliasing rate, or pulse repetition rate of aliasing signal 2018. The aliasing rate is determined as described below.

As noted above, the train ofpulses 2020 (i.e., control signal 2006) control the switch 2008 to alias the analog AM carrier signal 2016 (i.e., input signal 2004) at the aliasing rate of the aliasing signal 2018. Specifically, in this example, the switch 2008 closes on a first edge of each pulse and opens on a second edge of each pulse. When the switch 2008 is closed, input signal 2004 is coupled to the capacitor 2010, and charge is transferred from the input signal 2004 to the capacitor 2010. The charge transferred during a pulse is referred to herein as an under-sample. Exemplary under-samples 2022 form down-converted signal portion 2024 (FIG. 18E) that corresponds to the analog AM carrier signal portion 2016 (FIG. 18C) and the train of pulses 2020 (FIG. 18D). The charge stored during successive under-samples of AM carrier signal 2014 form the down-converted signal 2024 (FIG. 18E) that is an example of down-converted output signal 2012 (FIG. 18A). In FIG. 18F, a demodulated baseband signal 2026 represents the demodulated baseband signal 2024 after filtering on a compressed time scale. As illustrated, down-converted signal 2026 has substantially the same "amplitude envelope" as AM carrier signal 2014. Therefore, FIGS. 18B-18F illustrate down-conversion of AM carrier signal 2014.

The waveforms shown in FIGS. 18B-18F are discussed herein for illustrative purposes only.

The aliasing rate of control signal 2006 determines whether the input signal 2004 is down-converted to an IF signal, down-converted to a demodulated baseband signal, or down-converted from an FM signal to a PM or an AM signal. Generally, relationships between the input signal 2004, the aliasing rate of the control signal 2006, and the down-converted output signal 2012 are illustrated below:

$$\text{(Freq. of input signal 2004)} = n \text{ (Freq. of control signal 2006)} \pm$$

$$\text{(Freq. of down-converted output signal 2012)}$$

For the examples contained herein, only the "+" condition will be discussed. The value ofn represents a harmonic or sub-harmonic of input signal 2004 (e.g., n = 0.5, 1, 2, 3, ...).

When the aliasing rate of control signal 2006 is off-set from the frequency of input signal 2004, or off-set from a harmonic or sub-harmonic thereof, input signal 2004 is down-converted to an IF signal. This is because the under-sampling pulses occur at different phases of subsequent cycles of input signal 2004. As a result, the under-samples form a lower frequency oscillating pattern. If the input signal 2004 includes lower frequency changes, such as amplitude, frequency, phase, etc., or any combination thereof, the charge stored during associated under-samples reflects the lower frequency changes, resulting in similar changes on the down-converted IF signal. For example, to down-convert a 901 MHZ input signal to a 1 MHZ IF signal, the frequency of the control signal 2006 would be calculated as follows:

$$\text{(Freq}_{input} - \text{Freq}_{IF})/n = \text{Freq}_{control}$$

$$\text{(901 MHZ - 1 MHZ)}/n = 900/n$$

For *n* = 0.5, 1, 2, 3, 4, etc., the frequency of the control signal 2006 would be substantially equal to 1.8 GHz, 900 MHZ, 450 MHZ, 300 MHZ, 225 MHZ, etc.

Alternatively, when the aliasing rate of the control signal 2006 is substantially equal to the frequency of the input signal 2004, or substantially equal to a harmonic or sub-harmonic thereof, input signal 2004 is directly down-converted to a demodulated baseband signal. This is because, without modulation, the under-sampling pulses occur at the same point of subsequent cycles of the input signal 2004. As a result, the under-samples form a constant output baseband signal. If the input signal 2004 includes lower frequency changes, such as amplitude, frequency, phase, etc., or any combination thereof, the charge stored during associated under-samples reflects the lower frequency changes, resulting in similar changes on the demodulated baseband signal. For example, to directly down-convert a 900 MHZ input signal to a demodulated baseband signal (i.e., zero IF), the frequency of the control signal 2006 would be calculated as follows:

$$(\text{Freq}_{\text{input}} - \text{Freq}_{\text{IF}})/n = \text{Freq}_{\text{control}}$$

$$(900 \text{ MHZ} - 0 \text{ MHZ})/n = 900 \text{ MHZ}/n$$

For n = 0.5, 1, 2, 3, 4, etc., the frequency of the control signal 2006 should be substantially equal to 1.8 GHz, 900 MHZ, 450 MHZ, 300 MHZ, 225 MHZ, etc.

Alternatively, to down-convert an input FM signal to a non-FM signal, a frequency within the FM bandwidth must be down-converted to baseband (i.e., zero IF). As an example, to down-convert a frequency shift keying (FSK) signal (a sub-set of FM) to a phase shift keying (PSK) signal (a subset of PM), the mid-point between a lower frequency $F_1$ and an upper frequency $F_2$ (that is, $[(F_1 + F_2) \div 2]$) of the FSK signal is down-converted to zero IF. For example, to down-convert an FSK signal having $F_1$ equal to 899 MHZ and $F_2$ equal to 901 MHZ, to a PSK signal, the aliasing rate of the control signal 2006 would be calculated as follows:

$$\text{Frequency of the input} = \quad (F_1 + F_2) \div 2$$

$$= (899 \text{ MHZ} + 901 \text{ MHZ}) \div 2$$

$$= 900 \text{ MHZ}$$

Frequency of the down-converted signal = 0 (i.e., baseband)

$$(\text{Freq}_{\text{input}} - \text{Freq}_{\text{IF}})/n = \text{Freq}_{\text{control}}$$

$$(900 \text{ MHZ} - 0 \text{ MHZ})/n = 900 \text{ MHZ}/n$$

For *n* = 0.5, I, 2, 3, etc., the frequency of the control signal 2006 should be substantially equal to 1.8 GHz, 900 MHZ, 450 MHZ, 300 MHZ, 225 MHZ, etc. The frequency of the down-converted PSK signal is substantially equal to one half the difference between the lower frequency $F_1$ and the upper frequency $F_2$.

As another example, to down-convert a FSK signal to an amplitude shift keying (ASK) signal (a subset of AM), either the lower frequency $F_1$ or the upper frequency $F_2$ of the FSK signal is down-converted to zero IF. For example, to down-convert an FSK signal having $F_1$ equal to 900 MHZ and $F_2$ equal to 901 MHZ, to an ASK signal, the aliasing rate of the control signal 2006 should be substantially equal to:

$$(900 \text{ MHZ} - 0 \text{ MHZ})/n = 900 \text{ MHZ}/n, \text{ or}$$

$$(901 \text{ MHZ} - 0 \text{ MHZ})/n = 901 \text{ MHZ}/n.$$

For the former case of 900 MHZ/*n*, and for n = 0.5,1,2,3,4, etc., the frequency of the control signal 2006 should be substantially equal to 1.8 GHz, 900 MHZ, 450 MHZ, 300 MHZ, 225 MHZ, etc. For the latter case of 901 MHZ/*n*, and for n = 0.5, 1, 2, 3, 4, etc., the frequency of the control signal 2006 should be substantially equal to 1.802 GHz, 901 MHZ, 450.5 MHZ, 300.333 MHZ, 225.25 MHZ, etc. The frequency of the down-converted AM signal is substantially equal to the difference between the lower frequency $F_1$ and the upper frequency $F_2$ (i.e., 1 MHZ).

In one example, the pulses of the control signal 2006 have negligible apertures that tend towards zero. This makes the UFT module 102 a high input impedance device. This configuration is useful for situations where minimal disturbance of the input signal may be desired.

In another example, the pulses of the control signal 2006 have non-negligible apertures that tend away from zero. More specifically, the pulses of the control signal have apertures that are established to improve energy transfer to the down-converted signal. For example, the apertures can be a fraction of a period associated with the input signal 2004. For example, the apertures can be 1/10, 1/4, ½, etc. of a period of the input signal 2004. Additionally, the non-negligible pulse widths can be any other fraction of a period of the input signal, or a multiple of a period plus a fraction. In other words, any suitable non-negligible pulse duration can be used. This makes the UFT module 102 a lower input impedance device. This allows the lower input impedance of the UFT module 102 to be substantially matched with a source impedance of the input signal 2004. This also improves the energy transfer from the input signal 2004 to the down-converted output signal 2012, and hence the efficiency and signal to noise (s/n) ratio of UFT module 102.

### 3. Frequency Up-Conversion

This section is directed to systems and methods of frequency up-conversion, and applications of same.

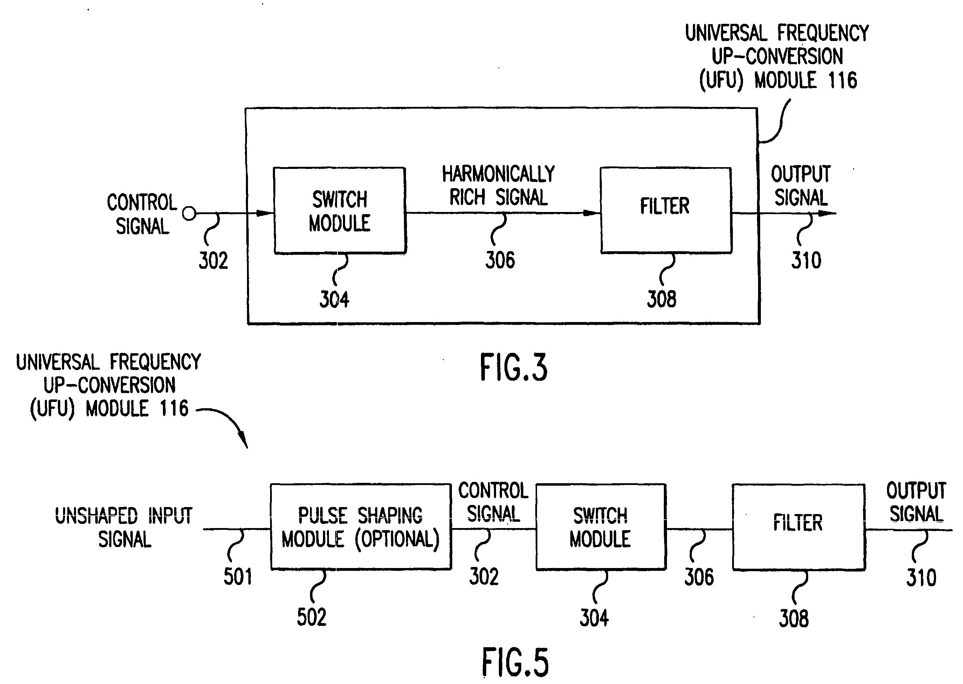

An example frequency up-conversion system 300 is illustrated in FIG. 3. The frequency up-conversion system 300 is now described.

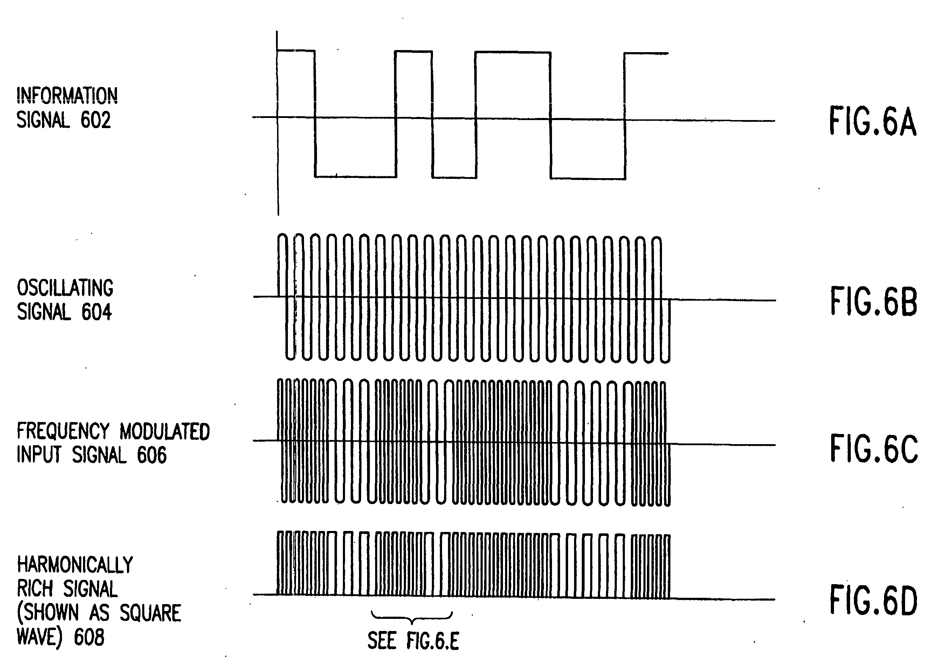

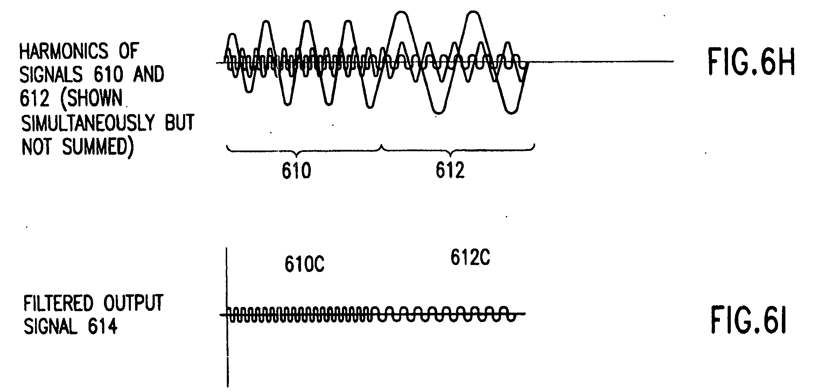

An input signal 302 (designated as "Control Signal" in FIG. 3) is accepted by a switch module 304. For purposes of example only, assume that the input signal 302 is a FM input signal 606, an example of which is shown in FIG. 6C. FM input signal 606 may have been generated by modulating information signal 602 onto oscillating signal 604 (FIGS. 6A and 6B). The information signal 602 can be analog, digital, or any combination thereof, and any modulation scheme can be used.

The output of switch module 304 is a harmonically rich signal 306, shown for example in FIG. 6D as a harmonically rich signal 608. The harmonically rich signal 608 has a continuous and periodic waveform.

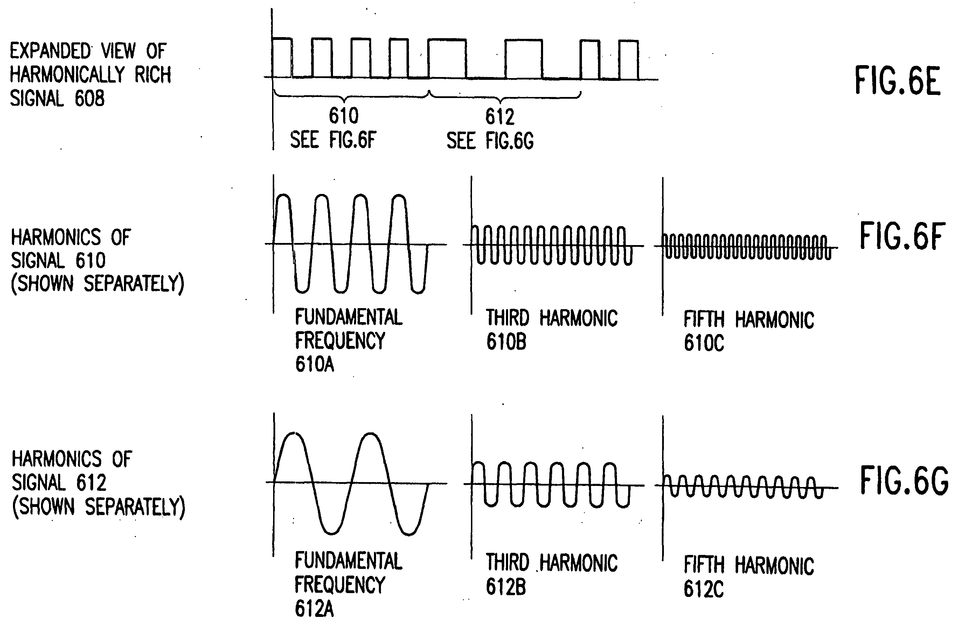

FIG. 6E is an expanded view of two sections of harmonically rich signal 608, section 610 and section 612. The harmonically rich signal 608 may be a rectangular wave, such as a square wave or a pulse. For ease of discussion, the term "rectangular waveform" is used to refer to waveforms that are substantially rectangular. In a similar manner, the term "square wave" refers to those waveforms that are substantially square.

Harmonically rich signal 608 is comprised of a plurality of sinusoidal waves whose frequencies are integer multiples of the fundamental frequency of the waveform of the harmonically rich signal 608. These sinusoidal waves are referred to as the harmonics of the underlying waveform, and the fundamental frequency is referred to as the first harmonic. FIG. 6F and FIG. 6G show separately the sinusoidal components making up the first, third, and fifth harmonics of section 610 and section 612. (Note that in theory there may be an infinite number of harmonics; in this example, because harmonically rich signal 608 is shown as a square wave, there are only odd harmonics). Three harmonics are shown simultaneously (but not summed) in FIG. 6H.

The relative amplitudes of the harmonics are generally a function of the relative widths of the pulses of harmonically rich signal 306 and the period of the fundamental frequency, and can be determined by doing a Fourier analysis of harmonically rich signal 306. The input signal 606 may be shaped to ensure that the amplitude of the desired harmonic is sufficient for its intended use (e.g., transmission).

A filter 308 filters out any undesired frequencies (harmonics), and outputs an electromagnetic (EM) signal at the desired harmonic frequency or frequencies as an output signal 310, shown for example as a filtered output signal 614 in FIG. 6I.

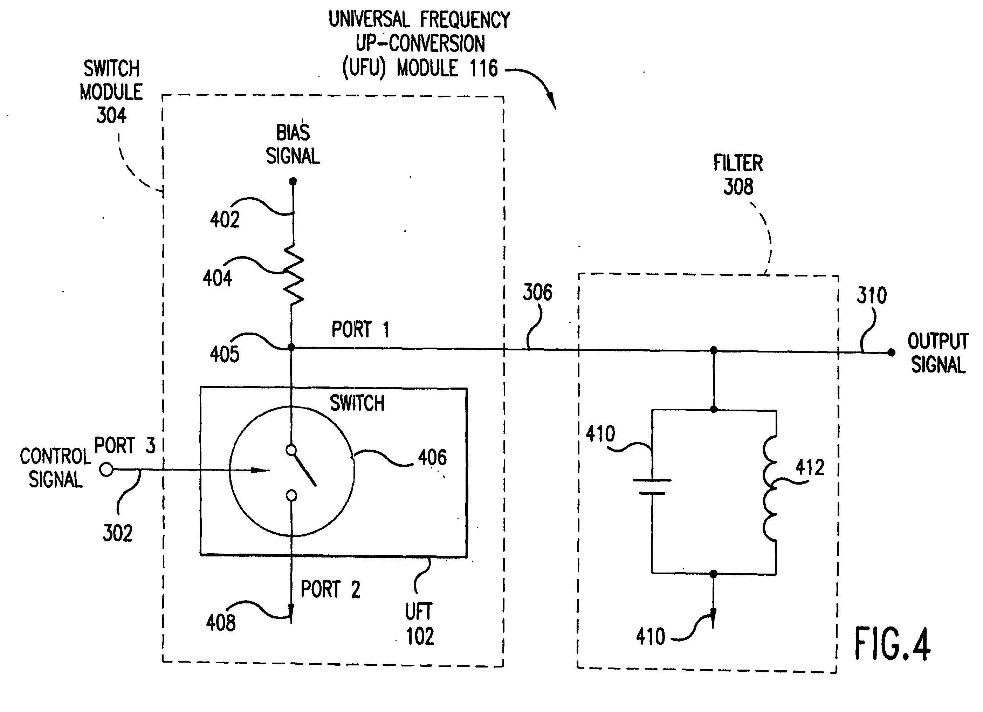

FIG. 4 illustrates an example universal frequency up-conversion (UFU) module 116. The UFU module 116 includes an example switch module 304, which comprises a bias signal 402, a resistor or impedance 404, a universal frequency translator (UFT) 102, and a ground 408. The UFT 102 includes a switch 406. The input signal 302 (designated as "Control Signal" in FIG. 4) controls the switch 406 in the UFT 102, and causes it to close and open. Harmonically rich signal 306 is generated at a node 405 located between the resistor or impedance 404 and the switch 406.

Also in FIG. 4, it can be seen that an example filter 308 is comprised of a capacitor 410 and an inductor 412 shunted to a ground 414. The filter is designed to filter out the undesired harmonics of harmonically rich signal 306.

Alternatively, in FIG. 5, an unshaped input signal 501 is routed to a pulse shaping module 502. The pulse shaping module 502 modifies the unshaped input signal 501 to generate a (modified) input signal 302 (designated as the "Control Signal" in FIG. 5). The input signal 302 is routed to the switch module 304, which operates in the manner described above. Also, the filter 308 of FIG. 5 operates in the manner described above.

The purpose of the pulse shaping module 502 is to define the pulse width of the input signal 302. Recall that the input signal 302 controls the opening and closing of the switch 406 in switch module 304. During such operation, the pulse width of the input signal 302 establishes the pulse width of the harmonically rich signal 306. As stated above, the relative amplitudes of the harmonics of the harmonically rich signal 306 are a function of at least the pulse width of the harmonically rich signal 306. As such, the pulse width of the input signal 302 contributes to setting the relative amplitudes of the harmonics of harmonically rich signal 306.

### 4.0. Example WLAN Implementation Embodiments

### 4.1 Architecture

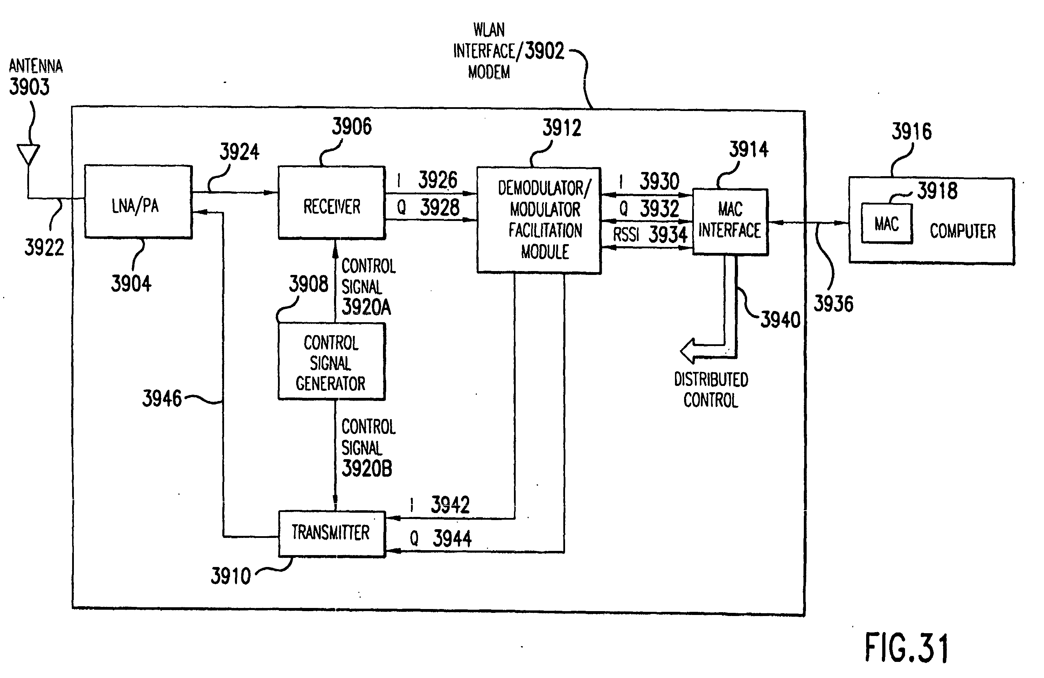

FIG. 31 is a block diagram of a WLAN interface 3902 (also referred to as a WLAN modem herein) according to one implementation of the present invention. The WLAN interface/modem 3902 includes an antenna 3903, a low noise amplifier or power amplifier (LNA/PA) 3904, a receiver 3906, atransmitter 3910, a control signal generator 3908, a demodulator/modulator facilitation module 3912, and a media access controller (MAC) interface 3914. The MAC interface 3914 couples the WLAN interface/modem 3902 to a computer 3916 or other data processing device. The computer 3916 preferably includes a MAC 3918.

The WLAN interface/modem 3902 represents a transmit and receive application that utilizes the universal frequency translation technology described herein. It also represents a zero IF (or direct-to-data) WLAN architecture.

The WLAN interface/modem 3902 also represents a vectormodulatorand a vector demodulator using the universal frequency translation (UFT) technology described herein. Use of the UFT technology enhances the flexibility of the WLAN application (i.e., makes it universal).

For example, in FIG. 31, the WLAN interface/modem 3902 is compliant with WLAN standard IEEE 802.11. The invention is applicable to any communication standard or specification, as will be appreciated by persons skilled in the relevant art(s) based on the teachings contained herein. Any modifications to the invention to operate with other standards or specifications will be apparent to persons skilled in the relevant art(s) based on the teachings contained herein.

In the example shown in FIG. 31, the WLAN interface/modem 3902 provides half duplex communication.

In FIG. 31, the modulation/demodulation performed by the WLAN interface/modem 3902 is preferably direct sequence spread spectrum QPSK (quadrature phase shift keying) with differential encoding. Other modulation and demodulation modes, such as those described herein, as well as frequency hopping according to IEEE 802.11, OFDM (orthogonal frequency division multiplexing), and others, may be used as well. These modulation/demodulation modes will be appreciated by persons skilled in the relevant art(s) based on the teachings contained herein.

The operation of the WLAN interface/modem 3902 when receiving shall now be described.

Signals 3922 received by the antenna 3903 are amplified by the LNA/PA 3904. The amplified signals 3924 are down-converted and demodulated by the receiver 3906. The receiver 3906 outputs I signal 3926 and Q signal 3928.

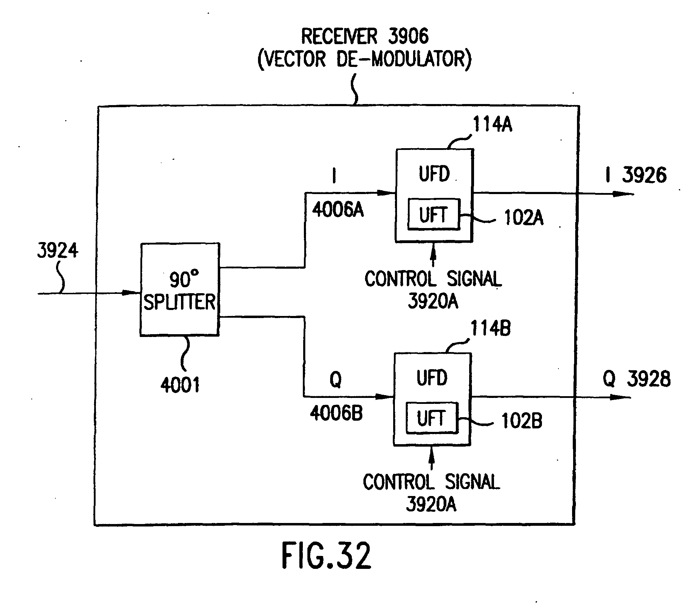

FIG. 32 illustrates an example receiver 3906. It is noted that the receiver 3906 shown in FIG. 32 represents a vector modulator. The "receiving" function performed by the WLAN interface/modem 3902 can be considered to be all processing performed by the WLAN interface/modem 3902 from the LNA/PA 3904 to generation of baseband information.

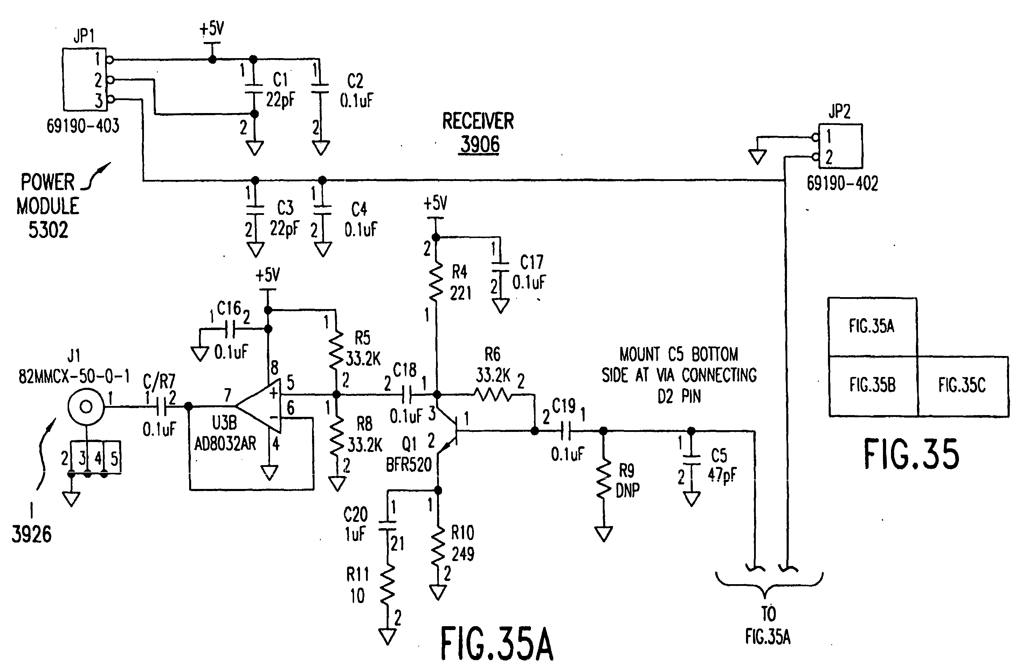

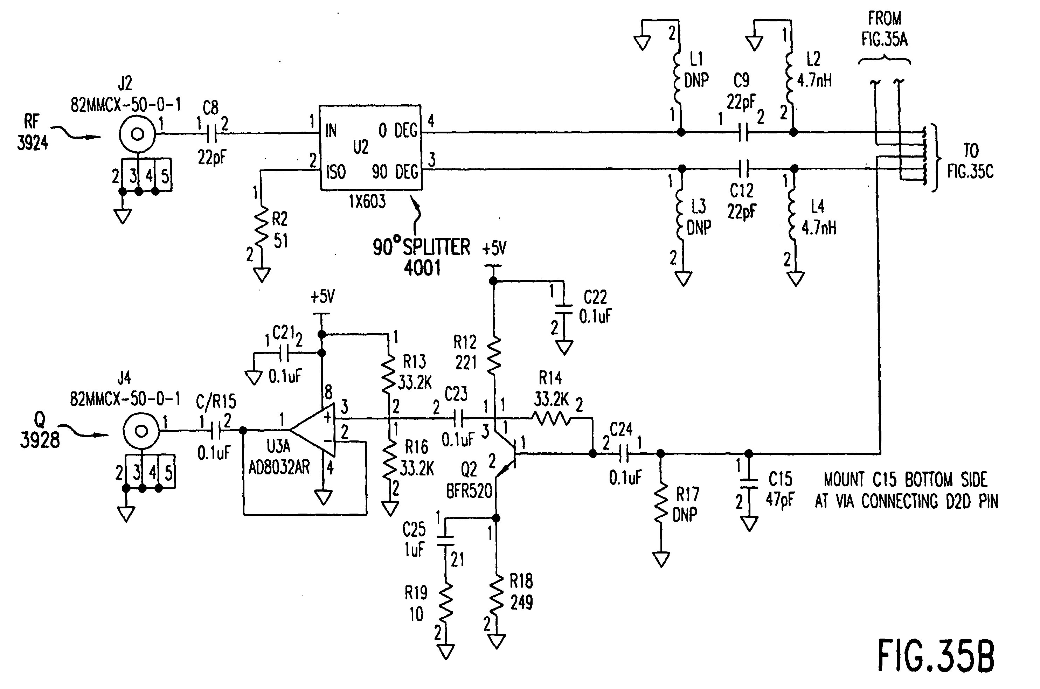

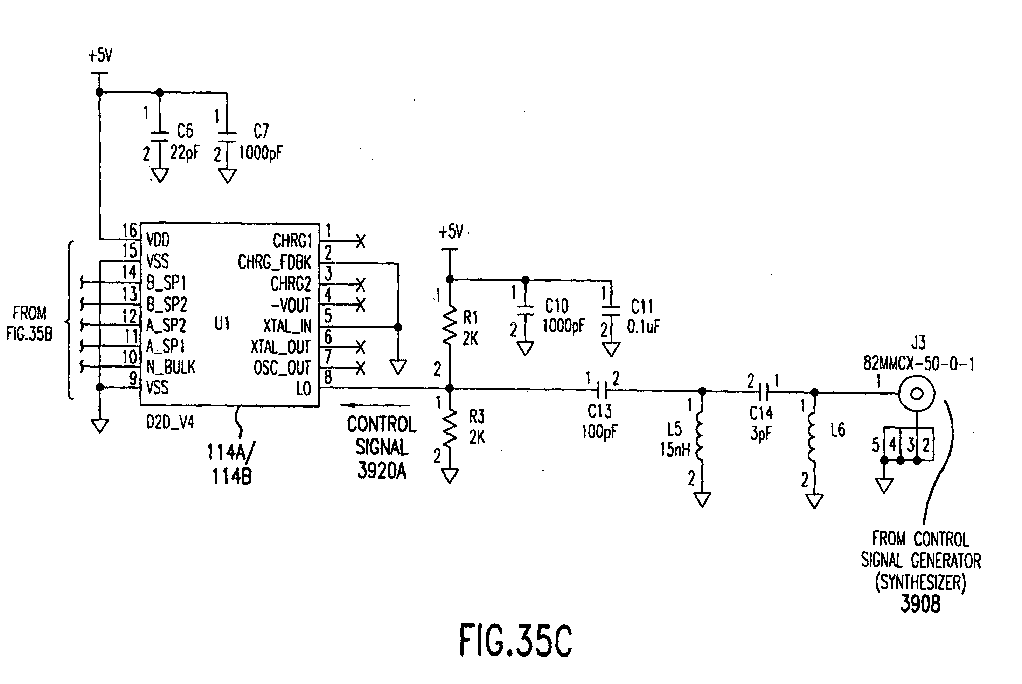

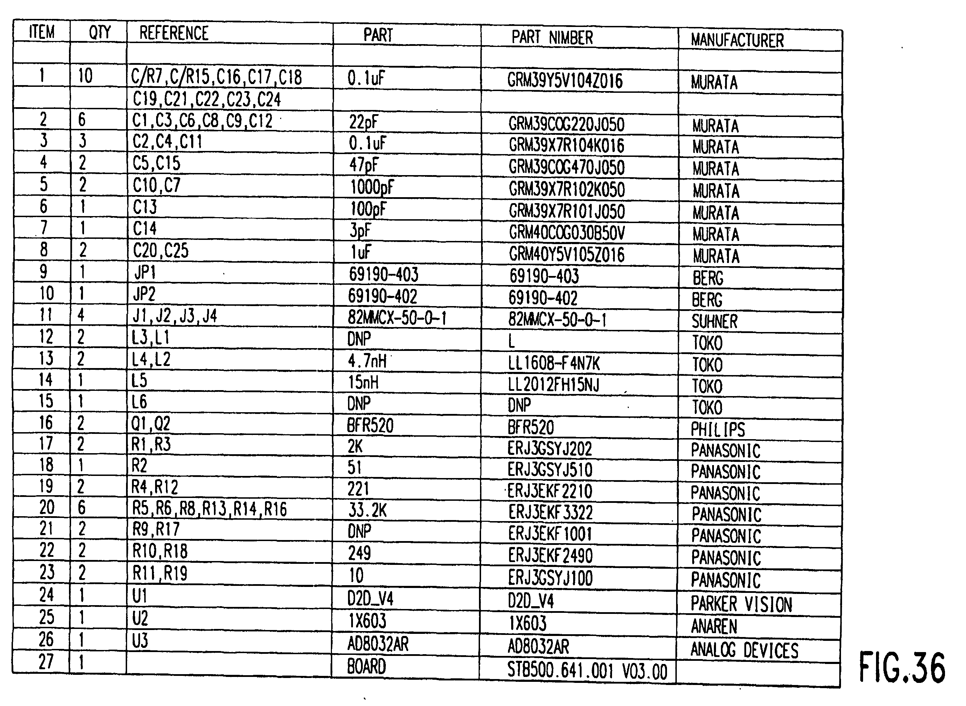

Signal 3924 is split by a 90 degree splitter 4001 to produce an I signal 4006A and Q signal 4006B that are preferably 90 degrees apart in phase. I and Q signals 4006A, 4006B are down-converted by UFD (universal frequency down-conversion) modules 4002A, 4002B. The UFD modules 114A, 114B output down-converted I and Q signals 3926, 3928. The UFD modules 114A, 114B each includes at least one UFT (universal frequency translation) module 102A. UFD and UFT modules are described above. An example implementation of the receiver 3906 (vector demodulator) is shown in FIG. 35. An example BOM list for the receiver 3906 of FIG. 35 is shown in FIG. 36.

The demodulator/modulator facilitation module 3912 receives the I and Q signals 3926, 3928. The demodulator/modulator facilitation module 3912 amplifies and filters the I and Q signals 3926,3928. The demodulator/modulator facilitation module 3912 also performs automatic gain control (AGC) functions. The AGC function is coupled with the universal frequency translation technology described herein. The demodulator/modulator facilitation module 3912 outputs processed I and Q signals 3930, 3932.

The MAC interface 3914 receives the processed I and Q signals 3930, 3932. The MAC interface 3914 preferably includes a baseband processor. The MAC interface 3914 preferably performs functions such as combining the I and Q signals 3930, 3932, and arranging the data according to the protocol/file format being used. Other functions performed by the MAC interface 3914 and the baseband processor contained therein will be apparent to persons skilled in the relevant art(s) based on the teachings contained herein. The MAC interface 3914 outputs the baseband information signal, which is received and processed by the computer 3916 in an implementation and application specific manner.

In FIG. 31, the demodulation function is distributed among the receiver 3906, the demodulator/modulator facilitation module 3912, and a baseband processor contained in the MAC interface 3914. The functions collectively performed by these components include, but are not limited to, despreading the information, differentially decoding the information, tracking the carrier phase, descrambling, recreating the data clock, and combining the I and Q signals.

These demodulation-type functions can be centralized in a single component, or distributed in other ways.

The operation of the WLAN interface/modem 3902 when transmitting shall now be described.

A baseband information signal 3936 is received by the MAC interface 3914 from the computer 3916. The MAC interface 3914 preferably performs functions such as splitting the baseband information signal to form I and Q signals 3930, 3932, and arranging the data according to the protocol/file format being used. Other functions performed by the MAC interface 3914 and the baseband processor contained therein will be apparent to persons skilled in the relevant art(s) based on the teachings contained herein.

The demodulator/modulator facilitation module 3912 filters and amplifies the I and Q signals 3930, 3932. The demodulator/modulator facilitation module 3912 outputs processed I and Q signals 3942, 3944. Preferably, at least some filtering and/or amplifying components in the demodulator/modulator facilitation module 3912 are used for both the transmit and receive paths.

The transmitter 3910 up-converts the processed I and Q signals 3942, 3944, and combines the up-converted I and Q signals. This up-converted/combined signal is amplified by the LNA/PA 3904, and then transmitted via the antenna 3903.

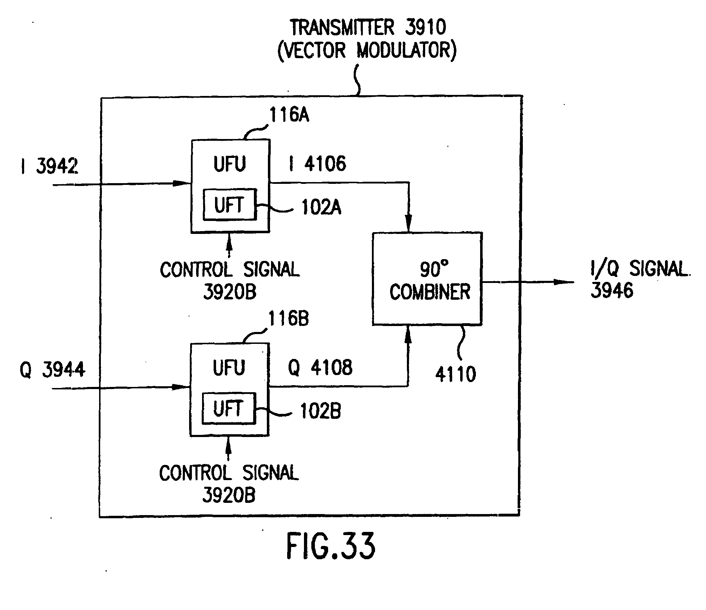

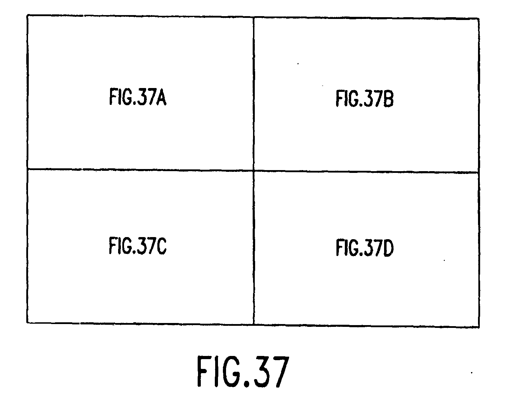

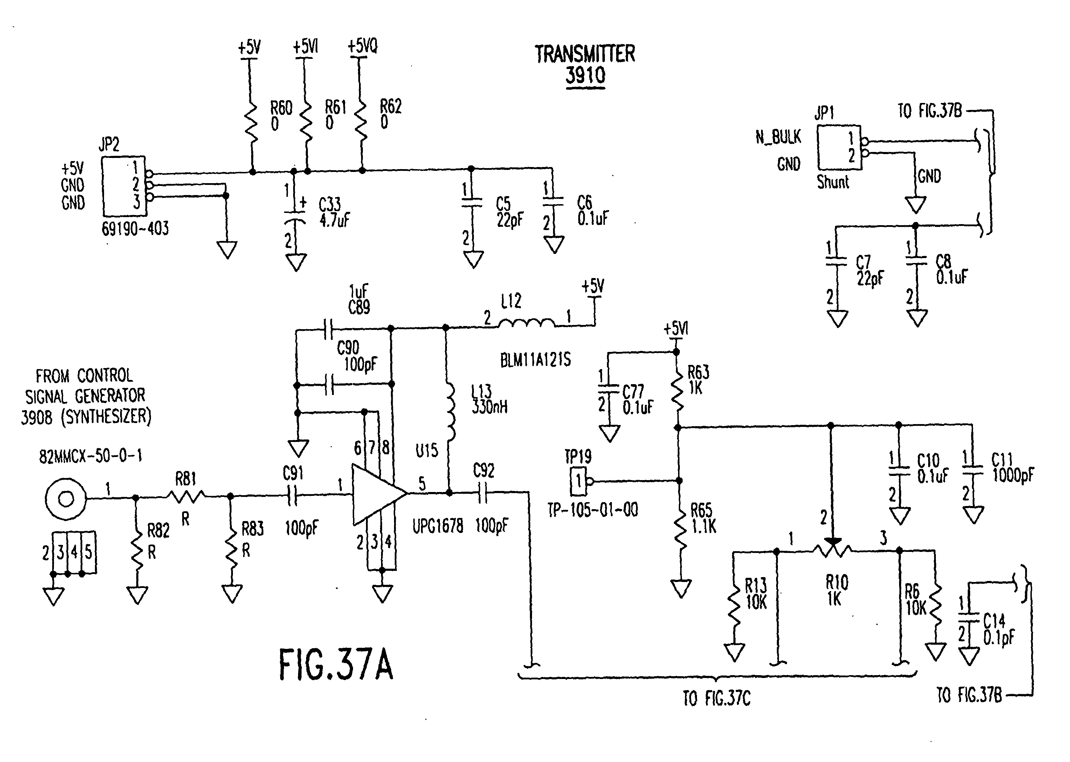

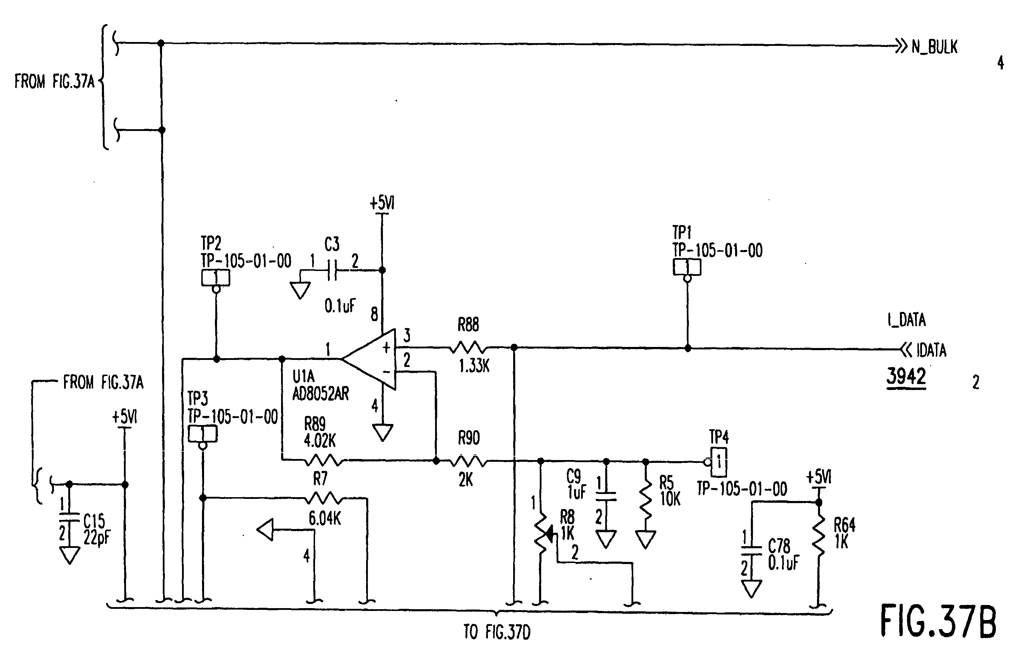

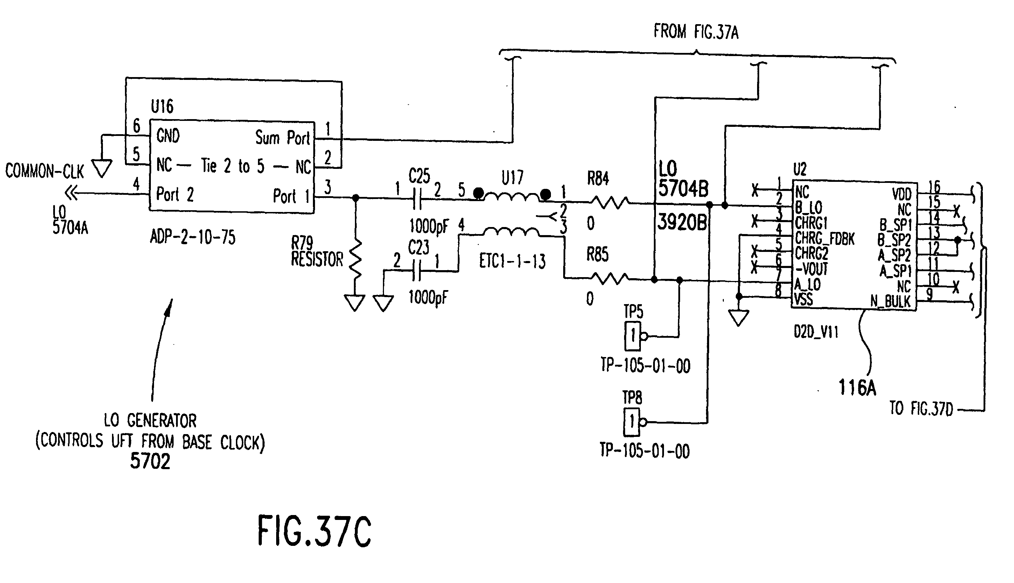

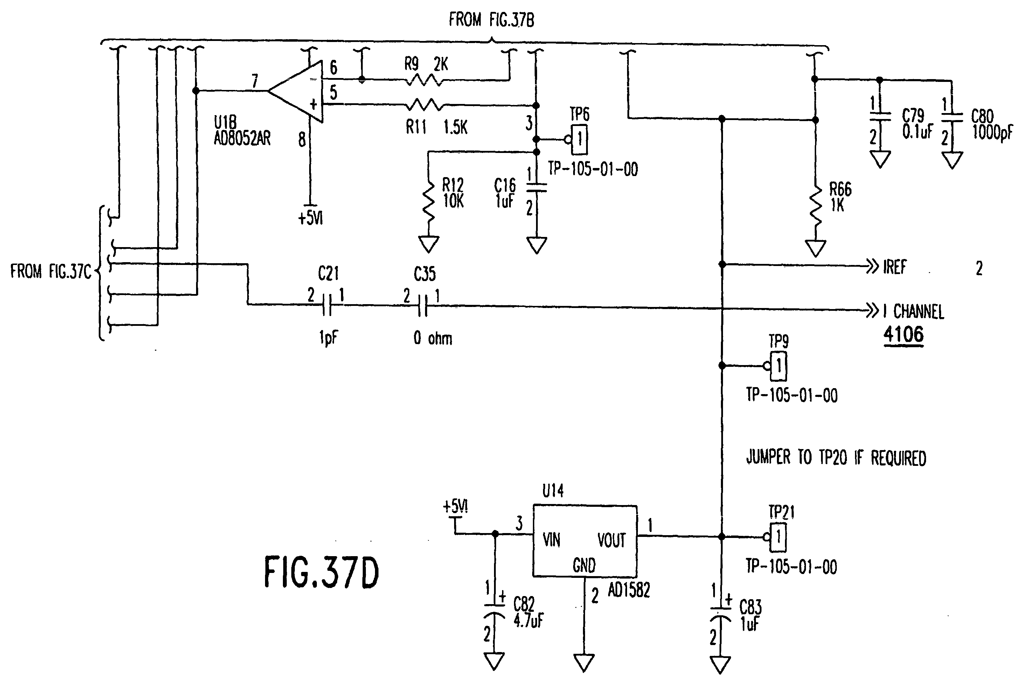

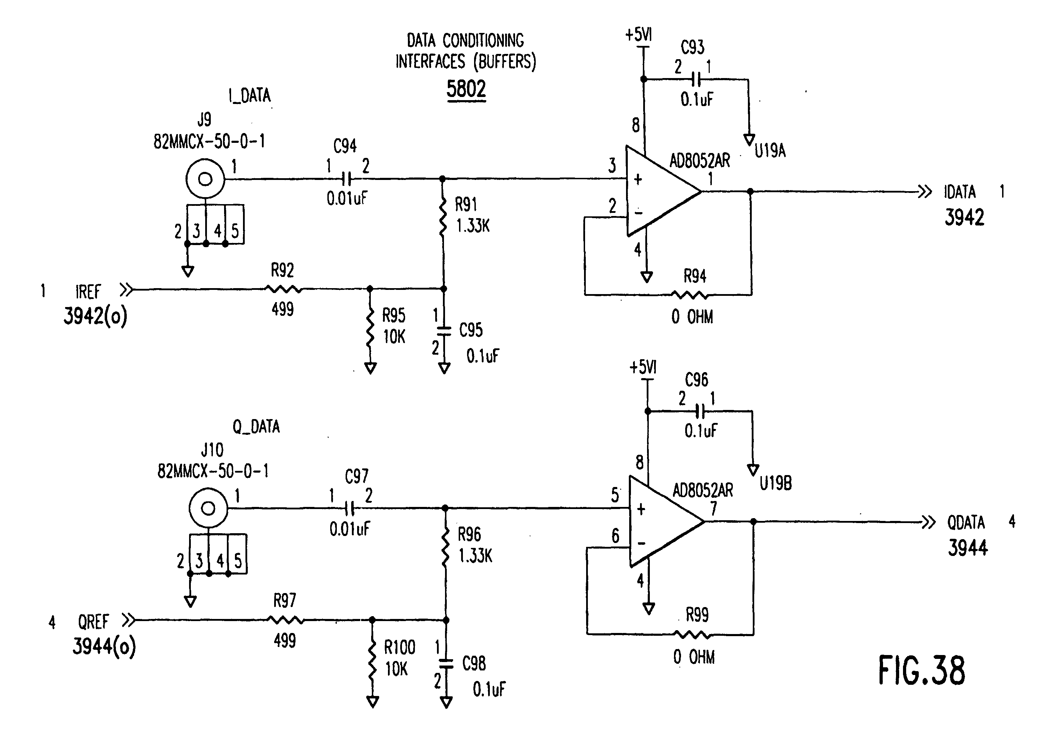

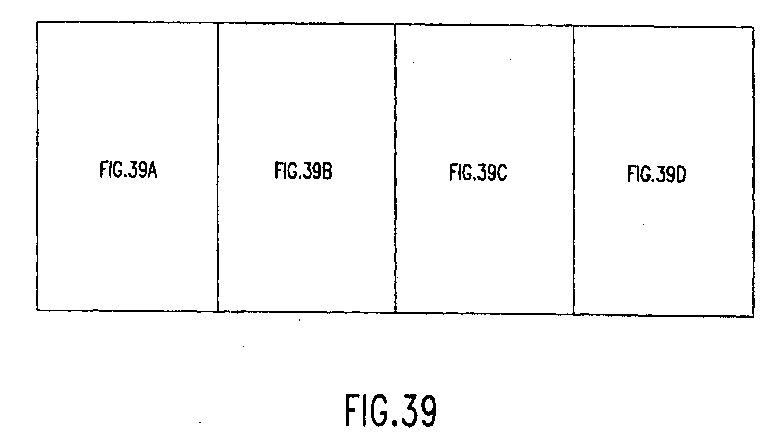

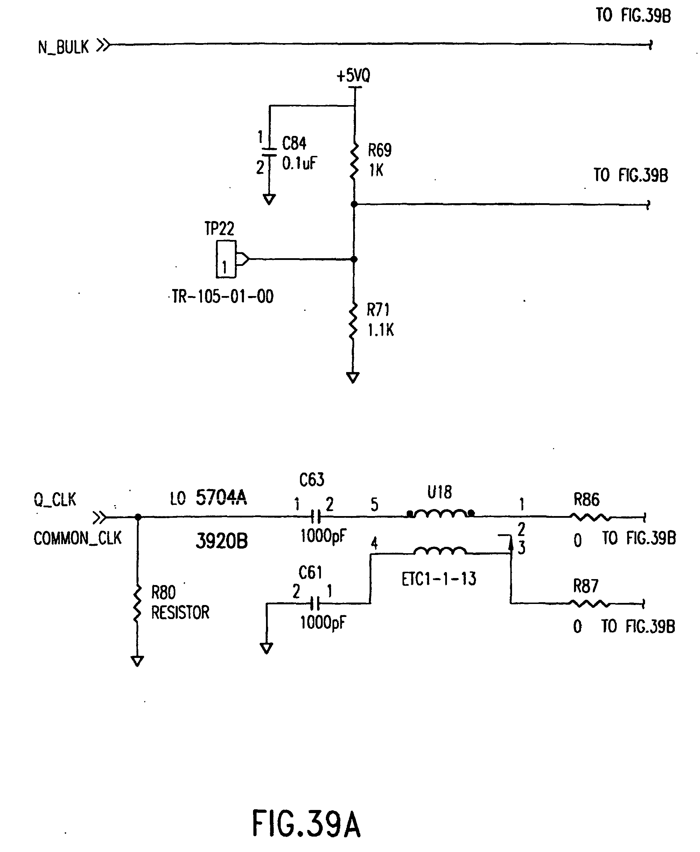

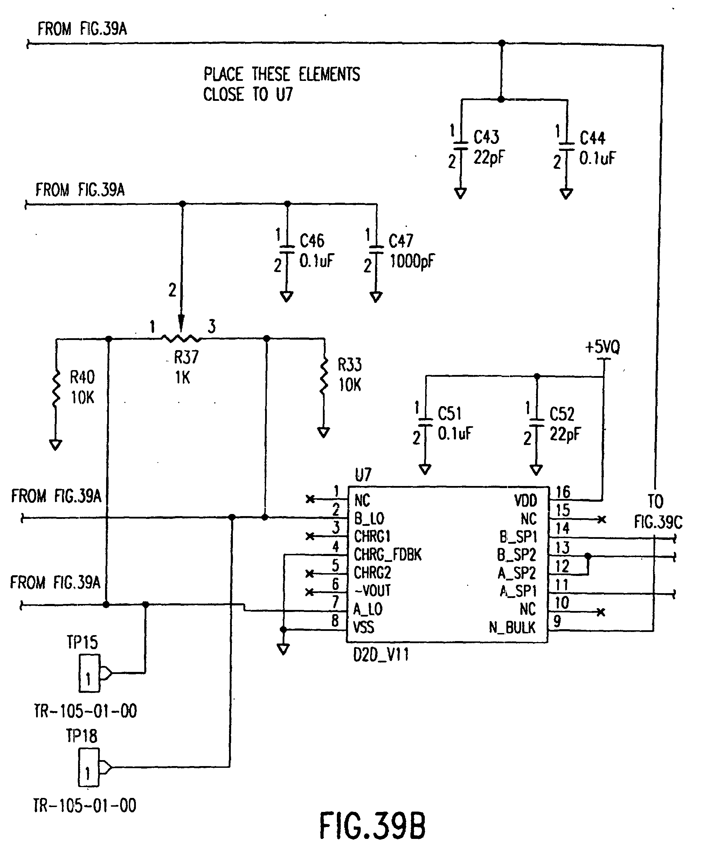

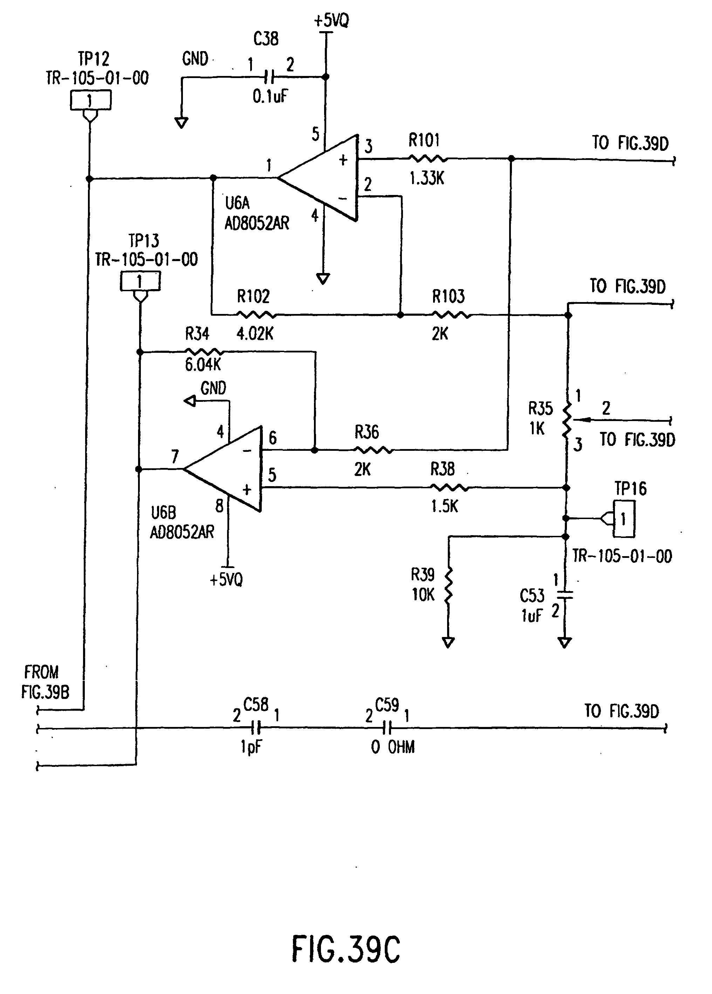

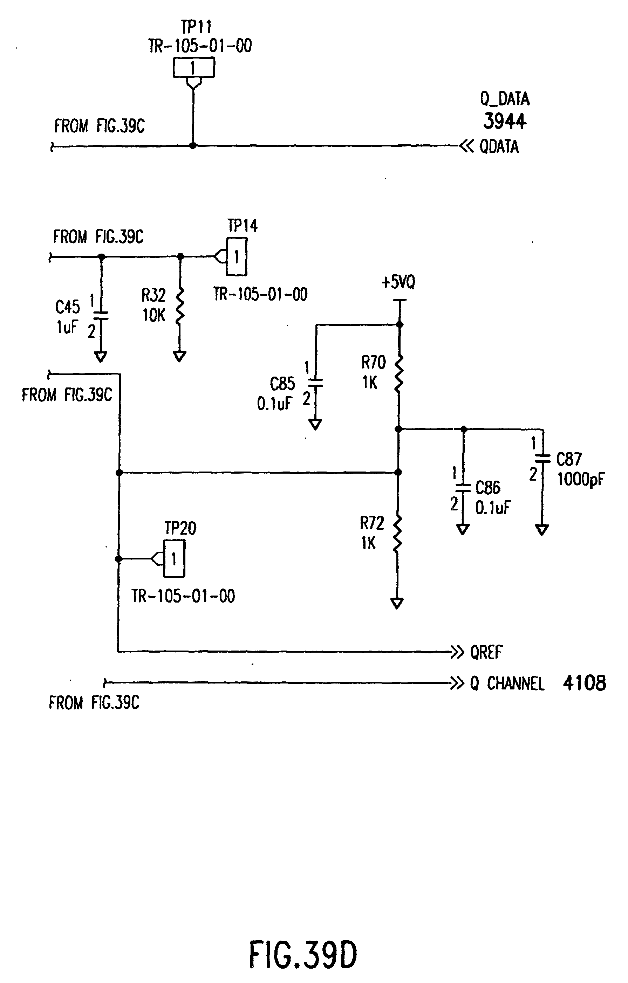

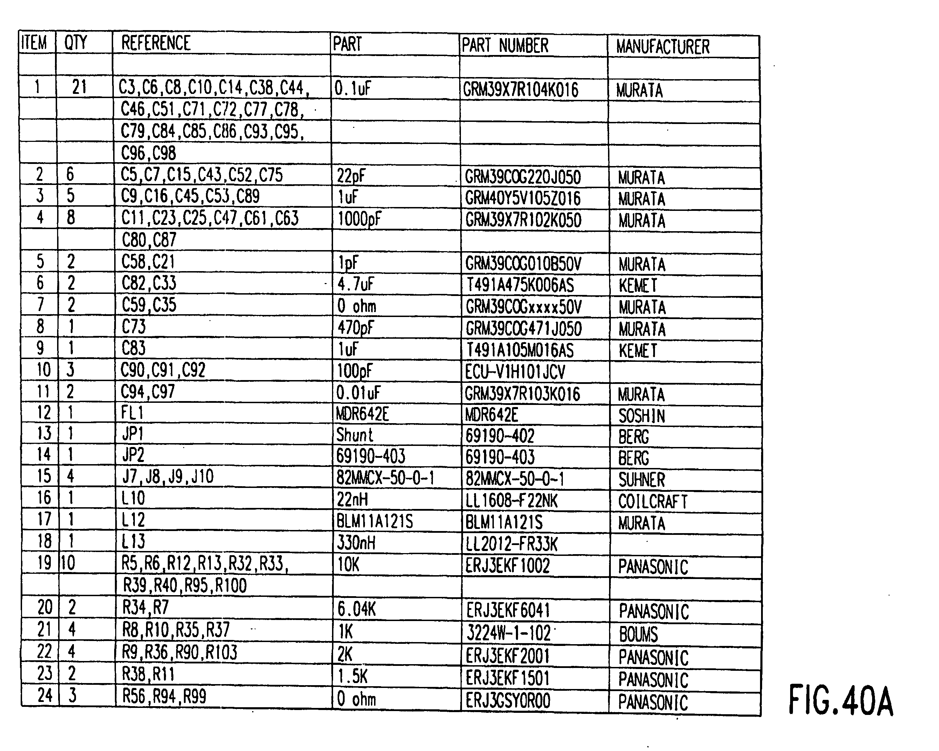

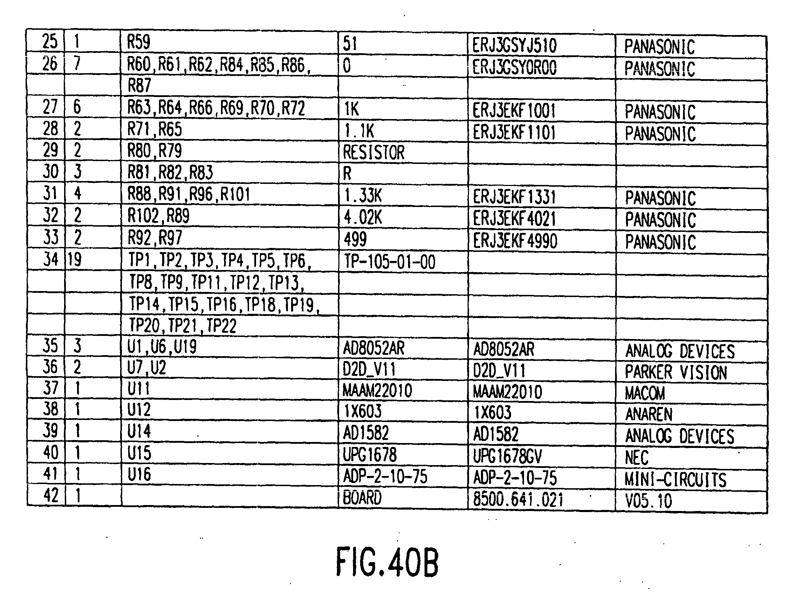

FIG. 33 illustrates an example transmitter 3910 according to an embodiment of the invention. The device in FIG. 33 can also be called a vector modulator. In an embodiment, the "transmit" function performed by the WLAN interface/modem 3902 can be considered to be all processing performed by the WLAN interface/modem 3902 from receipt ofbaseband information through the LNA/PA 3904. An example implementation of the transmitter 3910 (vector modulator) is shown in FIGS. 37, 38 and 39. The data conditioning interfaces 5802 in FIG. 38 effectively pre-process the I and Q signals 3942, 3944 before being received by the UFU modules 116. An example BOM list for the transmitter 3910 of FIGS. 37, 38 and 39 are shown in FIGS. 40A and 40B.

I and Q signals 3942, 3944 are received by UFU (universal frequency up-conversion) modules 116A, 116B. The UFU modules 116A, 116B each includes at least one UFT module 102A, 102B. The UFU modules 116A, 116B up-convert I and Q signals 3942, 3944. The UFU modules 116A, 116B output up-converted I and Q signals 4106, 4108. The 90 degree combiner 4110 effectively phase shifts either the I signal 4106 or the Q signal 4108 by 90 degrees, and then combines the phase shifted signal with the unshifted signal to generate a combined, up-converted I/Q signal 3946.

In FIG. 31, the modulation function is distributed among the transmitter 3910, the demodulator/modulator facilitation module 3912, and a baseband processor contained in the MAC interface 3914. The functions collectively performed by these components include, but are not limited to, differentially encoding data, splitting the baseband information signal into I and Q signals, scrambling data, and data spreading. These modulation-type functions can be centralized in a single component, or distributed in other ways.

An example implementation of the transmitter 3910 (vector modulator) is shown in FIGS. 37A-D, 38 and 39. The data conditioning interfaces 5802 in FIG. 38 effectively pre-process the I and Q signals 3942, 3944 before being received by the UFU modules 116. An example BOM list for the transmitter 3910 of FIGS. 37, 38 and 39 are shown in FIGS. 40A and 40B.

The components in the WLAN interface/modem 3902 are preferably controlled by the MAC interface 3914 in operation with the MAC 3918 in the computer 3916. This is represented by the distributed control arrow 3940 in FIG. 31. Such control includes setting the frequency, data rate, whether receiving or transmitting, and other communication characteristics/modes that will be apparent to persons skilled in the relevant art(s) based on the teachings contained herein. Control signals are sent over the corresponding wireless medium and received by the antenna 3903, and sent to the MAC 3918.

In some applications, it is desired to separate the receive path and the transmit path.

### 4.2 Receiver

Example embodiments and implementations of the IQ receiver 3906 will be discussed as follows. The example embodiments and implementations include multi-phase embodiments that are useful for reducing or eliminating unwanted DC offsets and circuit re-radiation. Other receiver embodiments will be understood by those skilled in the relevant arts based on the discussion given herein.

### 4.2.1 IQ Receiver

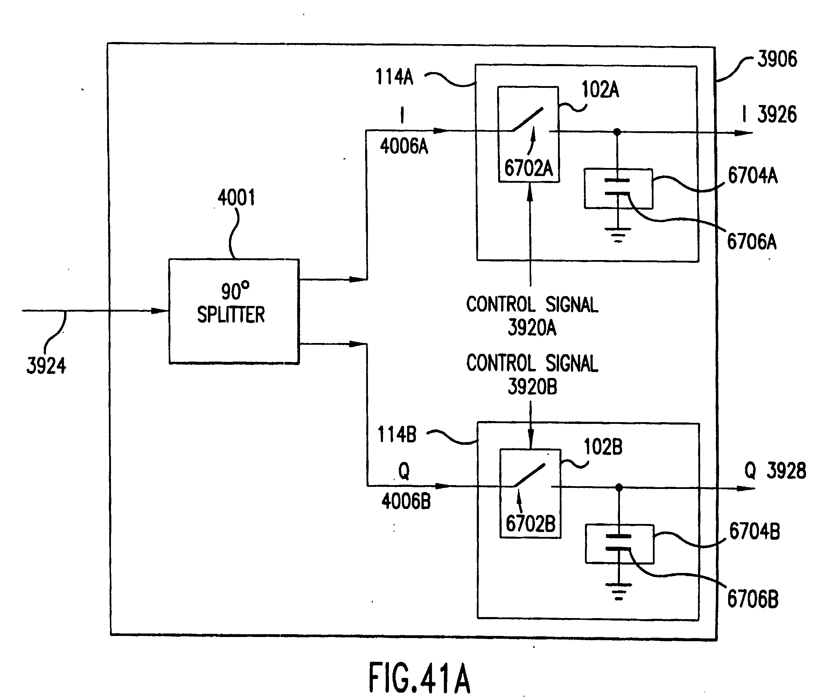

Receiver 3906 is shown in FIGS. 41A. Referring to FIGS. 41A, the UFD module 114A (FIG. 32) is configured so that the UFT module 102A is coupled to a storage module 6704A. The UFT module 102A is a controlled switch 6702A that is controlled by the control signal 3920A. The storage module 6704A is a capacitor 6706A. However, other storage modules could be used including an inductor, as will be understood by those skilled in the relevant arts. Likewise, the UFD module 114B (FIG. 32) is configured so that the UFT module 102B is coupled to a storage module 6704B. The UFT module 102B is a controlled switch 6702B that is controlled by the control signal 3920B. The storage module 6704B is a capacitor 6706B. However, other storage modules could be used including an inductor, as will be understood by those skilled in the relevant arts. The operation of the receiver 3906 is discussed as follows.

The 90 degree splitter 4001 receives the received signal 3924 from the LNA/PA module 3904. The 90 degree splitter 4001 divides the signal 3924 into an I signal 4006A and a Q signal 4006B.

The UFD module 114A receives the I signal 4006A and down-converts the I signal 4006A using the control signal 3920A to a lower frequency signal I 3926. More specifically, the controlled switch 6702A samples the I signal 4006A according to the control signal 3920A, transferring charge (or energy) to the storage module 6704A. The charge stored during successive samples of the I signal 4006A, results in the down-converted signal I signal 3926. Likewise, UFD module 114B receives the Q signal 4006B and down-converts the Q signal 4006B using the control signal 3920B to a lower frequency signal Q 3928. More specifically, the controlled switch 6702B samples the Q signal 4006B according to the control signal 3920B, resulting in charge (or energy) that is stored in the storage module 6704B. The charge stored during successive samples of the I signal 4006A, results in the down-converted signal Q signal 3928.

Down-conversion utilizing a UFD module (also called an aliasing module) is further described herein. As described herein, the control signals 3920A,B can be configured as a plurality of pulses that are established to improve energy transfer from the signals 4006A,B to the down-converted signals 3926 and 3928, respectively. In other words, the pulse widths of the control signals 3920 can be adjusted to increase and/or optimize the energy transfer from the signals 4006 to the down-converted output signals 3926 and 3938, respectively. Preferably, the pulse width is a fraction of a period of the input signals 4006A,B. For example, the non-negligible pulse widths can be 1/10, 1/4, ½, etc. of a period of the input signal(s). Additionally, the non-negligible pulse widths can be any other fraction of a period of the input EM signal, or a multiple of a period plus a fraction. In other words, any suitable non-negligible pulse duration can be used. Additionally, matched filter principles can be implemented to shape the sampling pulses of the control signal 3920, and therefore further improve energy transfer to the down-converted output signal 3106.

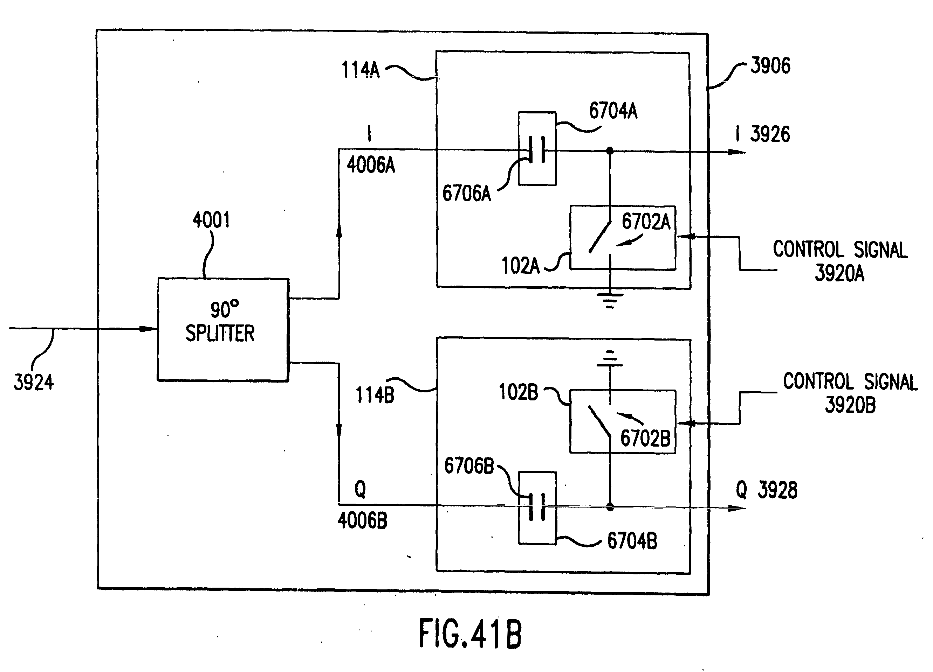

The configuration of the UFT based receiver 3906 is flexible. In FIGS. 41A, the controlled switches 6702 are in a series configuration relative to the signals 4006. Alternatively, FIG 41B illustrates the controlled switches 6702 in a shunt configuration so that the switches 6702 shunt the signals 4006 to ground.

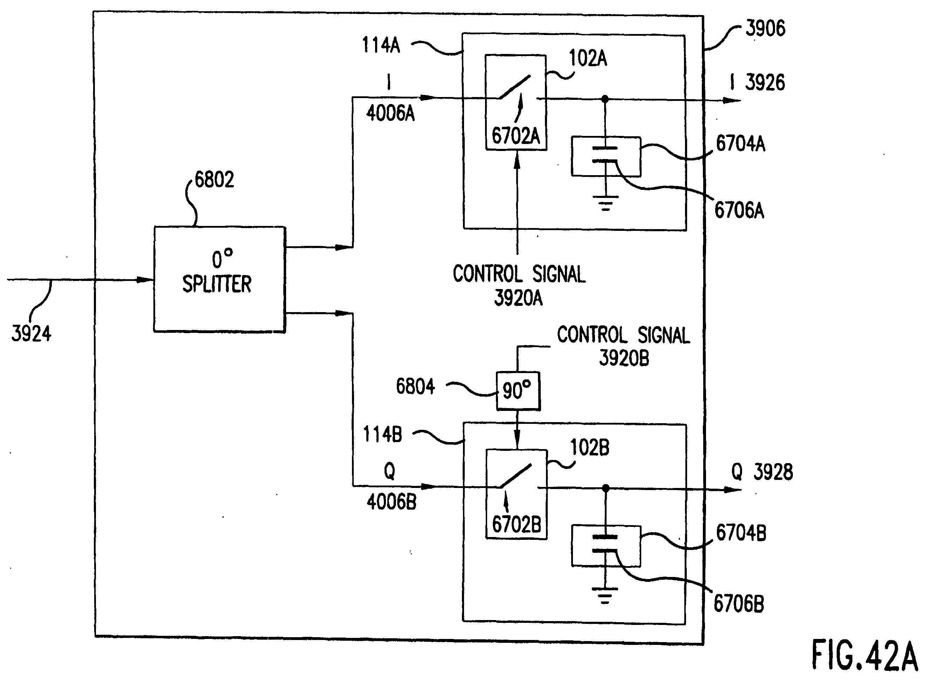

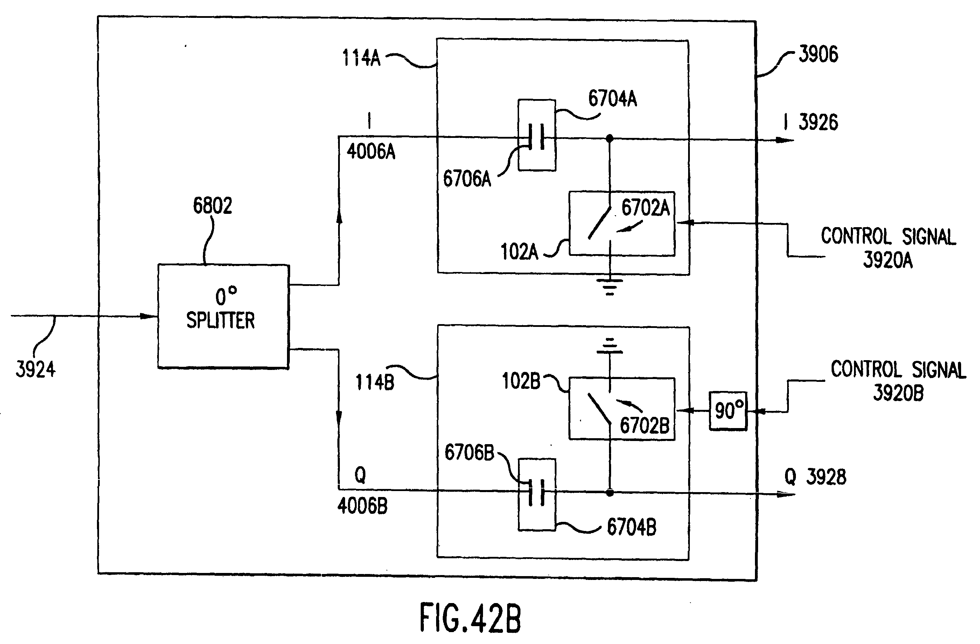

Additionally in FIGS. 41 A-B, the 90 degree phase shift between the I and Q channels is realized with the 90 degree splitter 4001. Alternatively, FIGS. 42A illustrates receiver 3906 in series configuration, where the 90 degree phase shift is realized by shifting the control signal 3920B by 90 degrees relative to the control signal 3920A. More specifically, the 90 degree shifter 6804 is added to shift the control signal 3920B by 90 degrees relative to the control signal 3920A. As such, the splitter 6802 is an in-phase (i.e. 0 degree) signal splitter. FIGS. 42B illustrates an embodiment of the receiver 3906 in a shunt configuration with 90 degree delays on the control signal.

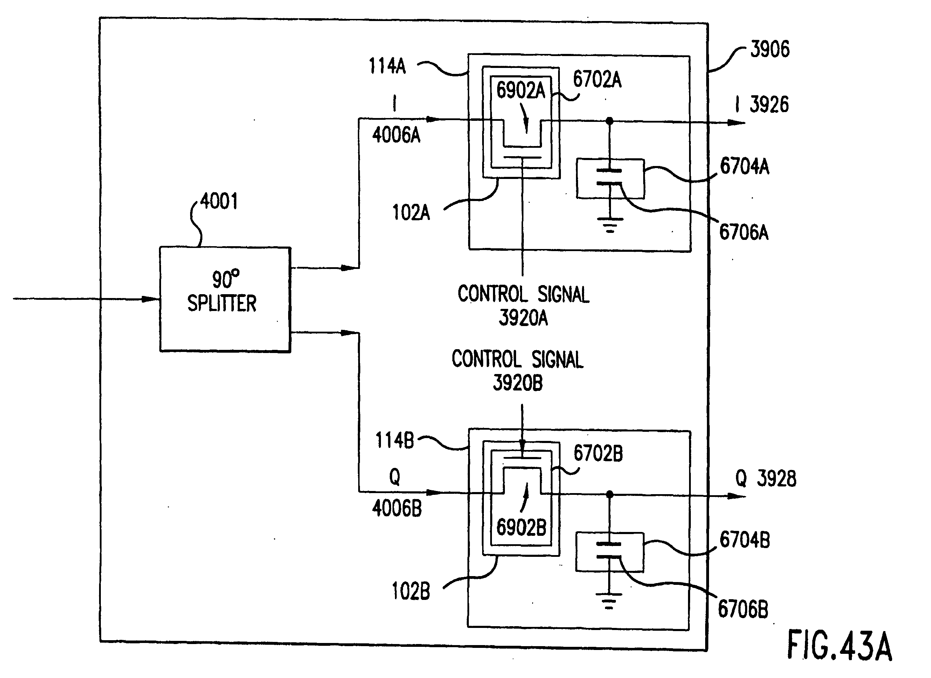

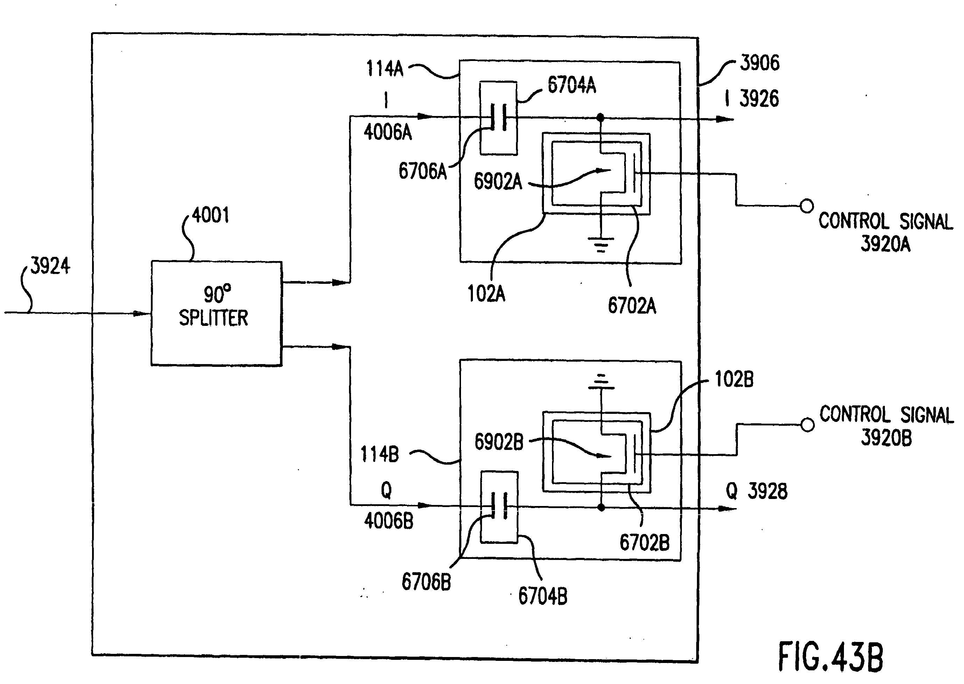

Furthermore, the configuration of the controlled switch 6702 is also flexible. More specifically, the controlled switches 6702 can be implemented in many different ways, including transistor switches. FIGS. 43A illustrates the UFT modules in a series configuration and implemented as FETs 6902, where the gate of each FET 6902 is controlled by the respective control signal 3920. As such, the FET 6902 samples the respective signal 4006, according to the respective control signal 3920. FIGS. 43B illustrates the shunt configuration.

### 4.2.2 Multi-Phase IQ Receiver

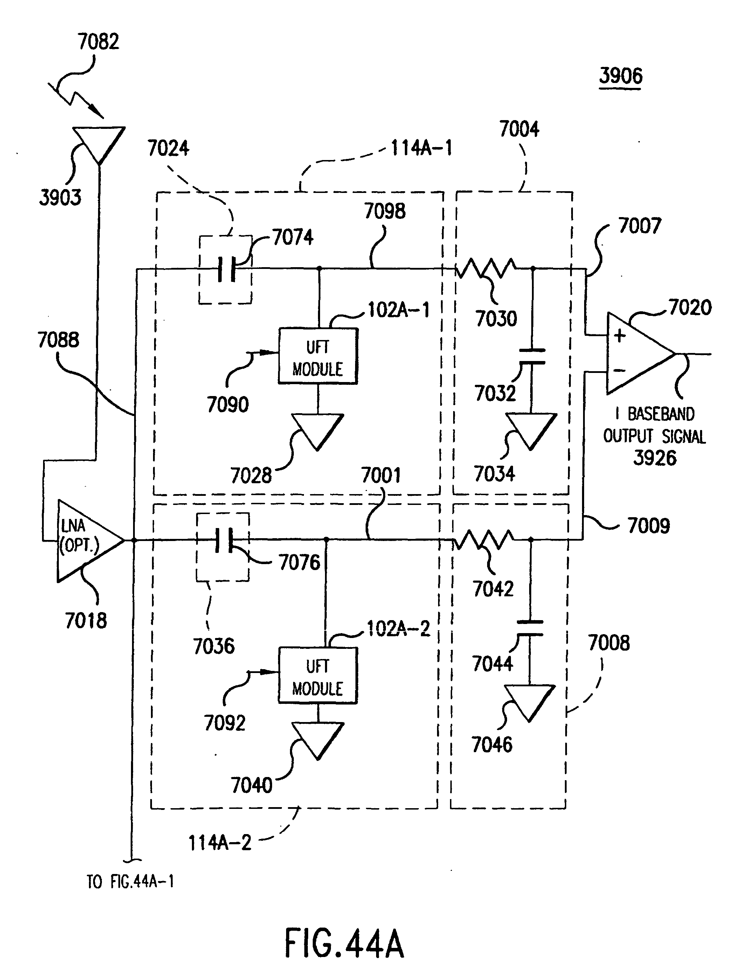

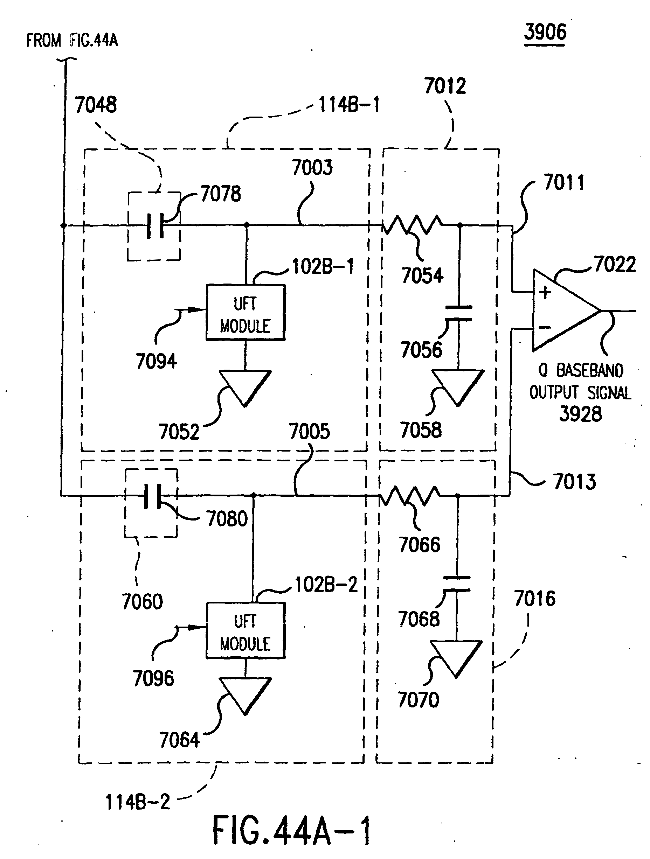

FIG. 44A and 44A-1 illustrate an exemplary I/Q modulation receiver 3906. I/Q modulation receiver 3906, as show in FIG. 44A and 44A-1, has additional advantages of reducing or eliminating unwanted DC offsets and circuit re-radiation. As will be apparent, the IQ receiver 3906 can be described as a multi-phase receiver to those skilled in the arts.

I/Q modulation receiver 3906 comprises a first UFD module 114A-1, a first optional filter 7004, a second UFD module 114A-2, a second optional filter 7008, a third UFD module 114B-1, a third optional filter 7012, a fourth UFD module 114B-2, a fourth filter 7016, an optional LNA 7018, a first differential amplifier 7020, a second differential amplifier 7022, and an antenna 3903.

I/Q modulation receiver 3906 receives, down-converts, and demodulates a I/Q modulated RF input signal 7082 to an I baseband output signal 7084, and a Q baseband output signal 7086. I/Q modulated RF input signal 7082 comprises a first information signal and a second information signal that are I/Q modulated onto an RF carrier signal. I baseband output signal 7084 comprises the first baseband information signal. Q baseband output signal 7086 comprises the second baseband information signal.

Antenna 3903 receives I/Q modulated RF input signal 7082. I/Q modulated RF input signal 7082 is output by antenna 3903 and received by optional LNA 7018. When present, LNA 7018 amplifies I/Q modulated RF input signal 7082, and outputs amplified I/Q signal 7088.

First UFD module 114A-1 receives amplified I/Q signal 7088. First UFD module 114A-1 down-converts the I-phase signal portion of amplified input I/Q signal 7088 according to an I control signal 7090. First UFD module 114A-1 outputs an I output signal 7098.

Preferably, first UFD module 114A-1 comprises a first storage module 7024, a first UFT module 102A-1, and a first voltage reference 7028. Preferably, a switch contained within first UFT module 102A-1 opens and closes as a function of I control signal 7090. As a result of the opening and closing of this switch, which respectively couples and de-couples first storage module 7024 to and from first voltage reference 7028, a down-converted signal, referred to as I output signal 7098, results. First voltage reference 7028 may be any reference voltage, and is preferably ground. I output signal 7098 is stored by first storage module 7024.

Preferably, first storage module 7024 comprises a first capacitor 7074. In addition to storing I output signal 7098, first capacitor 7074 reduces or prevents a DC offset voltage resulting from charge injection from appearing on I output signal 7098.

I output signal 7098 is received by optional first filter 7004. When present, first filter 7004 is preferably a high pass filter to at least filter I output signal 7098 to remove any carrier signal "bleed through". Preferably, when present, first filter 7004 comprises a first resistor 7030, a first filter capacitor 7032, and a first filter voltage reference 7034. Preferably, first resistor 7030 is coupled between I output signal 7098 and a filtered I output signal 7007, and first filter capacitor 7032 is coupled between filtered I output signal 7007 and first filter voltage reference 7034. Alternately, first filter 7004 may comprise any other applicable filter configuration as would be understood by persons skilled in the relevant art(s). First filter 7004 outputs filtered I output signal 7007.

Second UFD module 114A-2 receives amplified I/Q signal 7088. Second UFD module 114A-2 down-converts the inverted I-phase signal portion of amplified input I/Q signal 7088 according to an inverted I control signal 7092. Second UFD module 114A-2 outputs an inverted I output signal 7001.

Preferably, second UFD module 114A-2 comprises a second storage module 7036, a second UFT module 102A-2, and a second voltage reference 7040. A switch contained within second UFT module 102A-2 opens and closes as a function of inverted I control signal 7092. As a result of the opening and closing of this switch, which respectively couples and de-couples second storage module 7036 to and from second voltage reference 7040, a down-converted signal, referred to as inverted I output signal 7001, results. Second voltage reference 7040 may be any reference voltage, and is preferably ground. Inverted I output signal 7001 is stored by second storage module 7036. Second storage module 7036 comprises a second capacitor 7076. In addition to storing inverted I output signal 7001, second capacitor 7076 reduces or prevents a DC offset voltage resulting from charge injection from appearing on inverted I output signal 7001.

Inverted I output signal 7001 is received by optional second filter 7008. When present, second filter 7008 is a high pass filter to at least filter inverted I output signal 7001 to remove any carrier signal "bleed through". Preferably, when present, second filter 7008 comprises a second resistor 7042, a second filter capacitor 7044, and a second filter voltage reference 7046. Preferably, second resistor 7042 is coupled between inverted I output signal 7001 and a filtered inverted I output signal 7009, and second filter capacitor 7044 is coupled between filtered inverted I output signal 7009 and second filter voltage reference 7046. Alternately, second filter 7008 may comprise any other applicable filter configuration as would be understood by persons skilled in the relevant art(s). Second filter 7008 outputs filtered inverted I output signal 7009.

First differential amplifier 7020 receives filtered I output signal 7007 at its non-inverting input and receives filtered inverted I output signal 7009 at its inverting input. First differential amplifier 7020 subtracts filtered inverted I output signal 7009 from filtered I output signal 7007, amplifies the result, and outputs I baseband output signal 7084. Because filtered inverted I output signal 7009 is substantially equal to an inverted version of filtered I output signal 7007, I baseband output signal 7084 is substantially equal to filtered I output signal 7009, with its amplitude doubled. Furthermore, filtered I output signal 7007 and filtered inverted I output signal 7009 may comprise substantially equal noise and DC offset contributions from prior down-conversion circuitry, including first UFD module 114A-1 and second UFD module 114A-2, respectively. When first differential amplifier 7020 subtracts filtered inverted I output signal 7009 from filtered I output signal 7007, these noise and DC offset contributions substantially cancel each other.

Third UFD module 114B-1 receives amplified I/O signal 7088. Third UFD module 114B-1 down-converts the Q-phase signal portion of amplified input I/Q signal 7088 according to an Q control signal 7094. Third UFD module 114B-1 outputs an Q output signal 7003.

Preferably, third UFD module 114B-1 comprises a third storage module 7048, a third UFT module 102A, and a third voltage reference 7052. A switch contained within third UFT module 102A opens and closes as a function of Q control signal 7094. As a result of the opening and closing of this switch, which respectively couples and de-couples third storage module 7048 to and from third voltage reference 7052, a down-converted signal, referred to as Q output signal 7003, results. Third voltage reference 7052 may be any reference voltage, and is preferably ground. Q output signal 7003 is stored by third storage module 7048.

Preferably, third storage module 7048 comprises a third capacitor 7078. In addition to storing Q output signal 7003, third capacitor 7078 reduces or prevents a DC offset voltage resulting from charge injection from appearing on Q output signal 7003.

Q output signal 7003 is received by optional third filter 7012. When present, third filter 7012 is a high pass filter to at least filter Q output signal 7003 to remove any carrier signal "bleed through". Preferably, when present, third filter 7012 comprises a third resistor 7054, a third filter capacitor 7056, and a third filter voltage reference 7058. Preferably, third resistor 7054 is coupled between Q output signal 7003 and a filtered Q output signal 7011, and third filter capacitor 7056 is coupled between filtered Q output signal 7011 and third filter voltage reference 7058. Alternately, third filter 7012 may comprise any other applicable filter configuration as would be understood by persons skilled in the relevant art(s). Third filter 7012 outputs filtered Q output signal 7011.

Fourth UFD module 114B-2 receives amplified I/Q signal 7088. Fourth UFD module 114B-2 down-converts the inverted Q-phase signal portion of amplified input I/Q signal 7088 according to an inverted Q control signal 7096. Fourth UFD module 114B-2 outputs an inverted Q output signal 7005.

Preferably, fourth UFD module 114B-2 comprises a fourth storage module 7060, a fourth UFT module 102B-2, and a fourth voltage reference 7064. In an embodiment, a switch contained within fourth UFT module 102B-2 opens and closes as a function of inverted Q control signal 7096. As a result of the opening and closing of this switch, which respectively couples and de-couples fourth storage module 7060 to and from fourth voltage reference 7064, a down-converted signal, referred to as inverted Q output signal 7005, results. Fourth voltage reference 7064 may be any reference voltage, and is preferably ground. Inverted Q output signal 7005 is stored by fourth storage module 7060.

Preferably, fourth storage module 7060 comprises a fourth capacitor 7080. In addition to storing inverted Q output signal 7005, fourth capacitor 7080 reduces or prevents a DC offset voltage resulting from charge injection from appearing on inverted Q output signal 7005.

Inverted Q output signal 7005 is received by optional fourth filter 7016. When present, fourth filter 7016 is a high pass filter to at least filter inverted Q output signal 7005 to remove any carrier signal "bleed through". When present, fourth filter 7016 comprises a fourth resistor 7066, a fourth filter capacitor 7068, and a fourth filter voltage reference 7070. Preferably, fourth resistor 7066 is coupled between inverted Q output signal 7005 and a filtered inverted Q output signal 7013, and fourth filter capacitor 7068 is coupled between filtered inverted Q output signal 7013 and fourth filter voltage reference 7070. Alternately, fourth filter 7016 may comprise any other applicable filter configuration as would be understood by persons skilled in the relevant art(s). Fourth filter 7016 outputs filtered inverted Q output signal 7013.

Second differential amplifier 7022 receives filtered Q output signal 7011 at its non-inverting input and receives filtered inverted Q output signal 7013 at its inverting input. Second differential amplifier 7022 subtracts filtered inverted Q output signal 7013 from filtered Q output signal 7011, amplifies the result, and outputs Q baseband output signal 7086. Because filtered inverted Q output signal 7013 is substantially equal to an inverted version of filtered Q output signal 7011, Q baseband output signal 7086 is substantially equal to filtered Q output signal 7013, with its amplitude doubled. Furthermore, filtered Q output signal 7011 and filtered inverted Q output signal 7013 may comprise substantially equal noise and DC offset contributions of the same polarity from prior down-conversion circuitry, including third UFD module 114B-1 and fourth UFD module 114B-2, respectively. When second differential amplifier 7022 subtracts filtered inverted Q output signal 7013 from filtered Q output signal 7011, these noise and DC offset contributions substantially cancel each other.

### 4.2.2.1 Example I/Q Modulation Control Signal Generator Embodiments

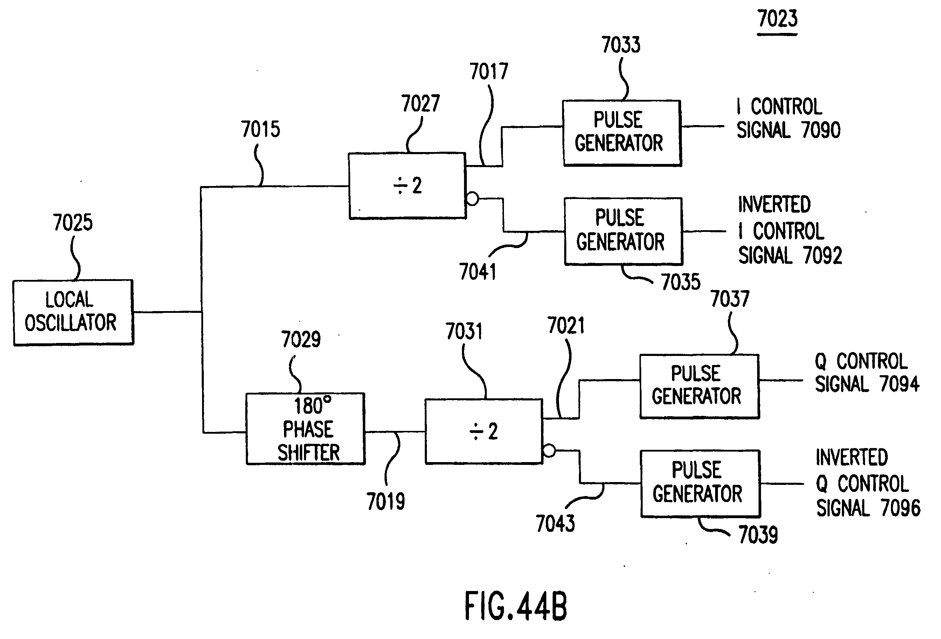

FIG. 44B illustrates an exemplary block diagram for I/Q modulation control signal generator 7023. I/Q modulation control signal generator 7023 generates I control signal 7090, inverted I control signal 7092, Q control signal 7094, and inverted Q control signal 7096 used by I/Q modulation receiver 3906 of FIG. 44A and 44A-1. I control signal 7090 and inverted I control signal 7092 operate to down-convert the I-phase portion of an input I/Q modulated RF signal. Q control signal 7094 and inverted Q control signal 7096 act to down-convert the Q-phase portion of the input I/Q modulated RF signal. Furthermore, I/Q modulation control signal generator 7023 has the advantage of generating control signals in a manner such that resulting collective circuit re-radiation is radiated at one or more frequencies outside of the frequency range of interest. For instance, potential circuit re-radiation is radiated at a frequency substantially greater than that of the input RF carrier signal frequency.

I/Q modulation control signal generator 7023 comprises a local oscillator 7025, a first divide-by-two module 7027, a 180 degree phase shifter 7029, a second divide-by-two module 7031, a first pulse generator 7033, a second pulse generator 7035, a third pulse generator 7037, and a fourth pulse generator 7039.

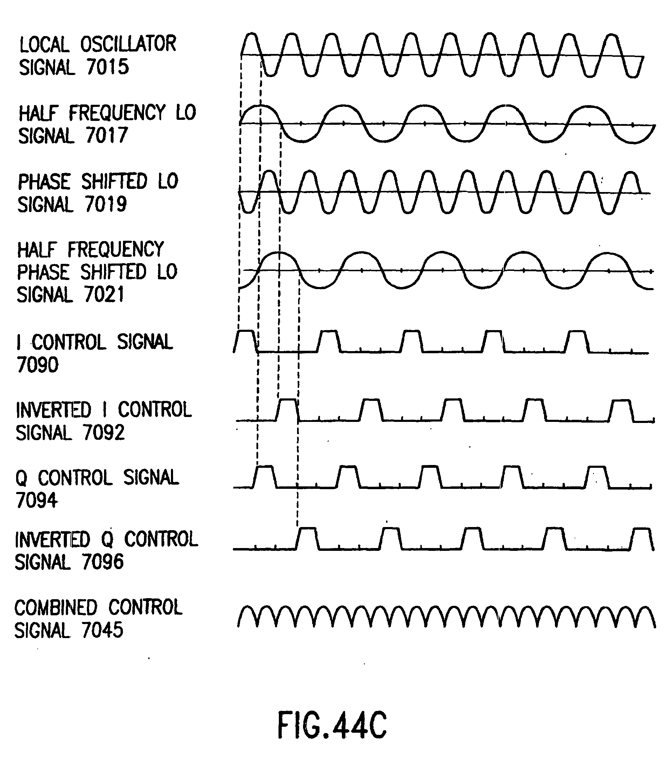

Local oscillator 7025 outputs an oscillating signal 7015. FIG. 44C shows an exemplary oscillating signal 7015.

First divide-by-two module 7027 receives oscillating signal 7015, divides oscillating signal 7015 by two, and outputs a half frequency LO signal 7017 and a half frequency inverted LO signal 7041. FIG. 44C shows an exemplary half frequency LO signal 7017. Half frequency inverted LO signal 7041 is an inverted version of half frequency LO signal 7017. First divide-by-two module 7027 may be implemented in circuit logic, hardware, software, or any combination thereof, as would be known by persons skilled in the relevant art(s).

180 degree phase shifter 7029 receives oscillating signal 7015, shifts the phase of oscillating signal 7015 by 180 degrees, and outputs phase shifted LO signal 7019. 180 degree phase shifter 7029 may be implemented in circuit logic, hardware, software, or any combination thereof, as would be known by persons skilled in the relevant art(s). Other amounts of phase shift may be used.

Second divide-by two module 7031 receives phase shifted LO signal 7019, divides phase shifted LO signal 7019 by two, and outputs a half frequency phase shifted LO signal 7021 and a half frequency inverted phase shifted LO signal 7043. FIG. 44C shows an exemplary half frequency phase shifted LO signal 7021. Half frequency inverted phase shifted LO signal 7043 is an inverted version of half frequency phase shifted LO signal 7021. Second divide-by-two module 7031 may be implemented in circuit logic, hardware, software, or any combination thereof, as would be known by persons skilled in the relevant art(s).

First pulse generator 7033 receives half frequency LO signal 7017, generates an output pulse whenever a rising edge is received on half frequency LO signal 7017, and outputs I control signal 7090. FIG. 44C shows an exemplary I control signal 7090.

Second pulse generator 7035 receives half frequency inverted LO signal 7041, generates an output pulse whenever a rising edge is received on half frequency inverted LO signal 7041, and outputs inverted I control signal 7092. FIG. 44C shows an exemplary inverted I control signal 7092.

Third pulse generator 7037 receives half frequency phase shifted LO signal 7021, generates an output pulse whenever a rising edge is received on half frequency phase shifted LO signal 7021, and outputs Q control signal 7094. FIG. 44C shows an exemplary Q control signal 7094.

Fourth pulse generator 7039 receives half frequency inverted phase shifted LO signal 7043, generates an output pulse whenever a rising edge is received on half frequency inverted phase shifted LO signal 7043, and outputs inverted Q control signal 7096. FIG. 44C shows an exemplary inverted Q control signal 7096.

Control signals 7090, 7021, 7041 and 7043 include pulses having a width equal to one-half of a period of I/Q modulated RF input signal 7082. These signals are exemplary and are not limited to these pulse widths, and control signals 7090, 7021, 7041, and 7043 may comprise pulse widths of any fraction of, or multiple and fraction of, a period of I/Q modulated RF input signal 7082.

First, second, third, and fourth pulse generators 7033, 7035, 7037, and 7039 may be implemented in circuit logic, hardware, software, or any combination thereof, as would be known by persons skilled in the relevant art(s).

As shown in FIG. 44C, in an embodiment, control signals 7090, 7021, 7041, and 7043 comprise pulses that are non-overlapping; in other embodiments the pulses may overlap. Furthermore, in this example, pulses appear on these signals in the following order: I control signal 7090, Q control signal 7094, inverted I control signal 7092, and inverted Q control signal 7096. Potential circuit re-radiation from I/Q modulation receiver 3906 may comprise frequency components from a combination of these control signals.

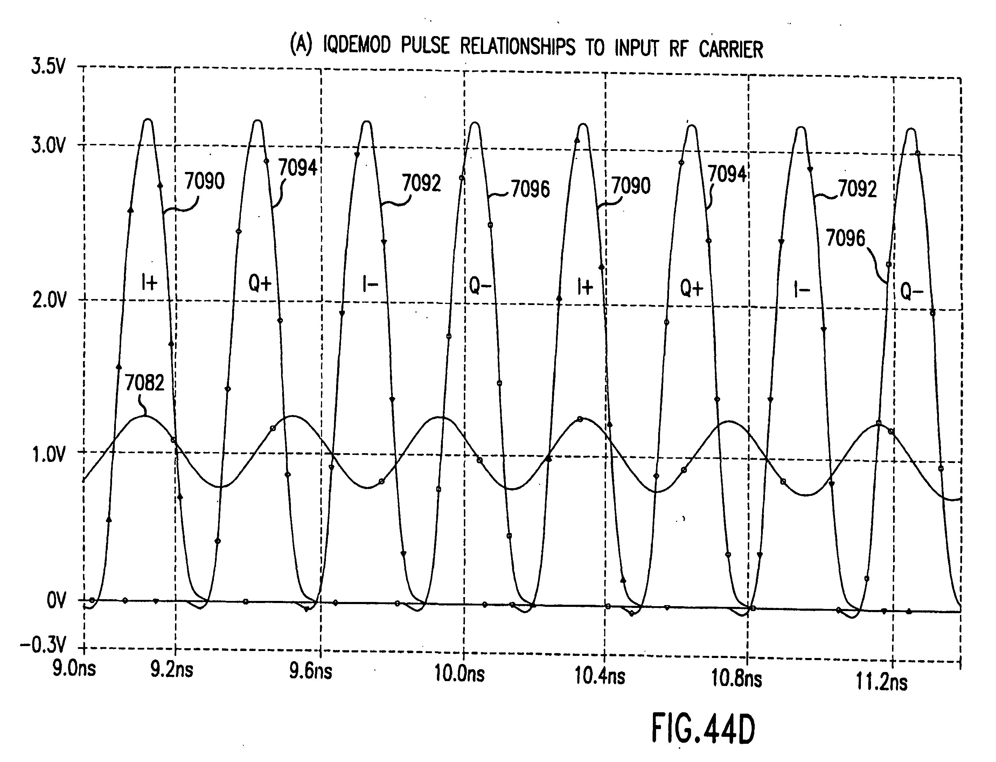

For example, FIG. 44D shows an overlay of pulses from I control signal 7090, Q control signal 7094, inverted I control signal 7092, and inverted Q control signal 7096. When pulses from these control signals leak through first, second, third, and/or fourth UFD modules 114A-1,114A-2,114B-1, and 114B-2 to antenna 3903 (shown in FIG. 44A and 44A-1), they may be radiated from I/Q modulation receiver 3906, with a combined waveform that appears to have a primary frequency equal to four times the frequency of any single one of control signals 7090, 7021, 7041, and 7043. FIG. 44 shows an example combined control signal 7045.

FIG. 44D also shows an example I/Q modulation RF input signal 7082 overlaid upon control signals 7090, 7094, 7092, and 7096. As shown in FIG. 44D, pulses on I control signal 7090 overlay and act to down-convert a positive I-phase portion of I/Q modulation RF input signal 7082. Pulses on inverted I control signal 7092 overlay and act to down-convert a negative I-phase portion of I/Q modulation RF input signal 7082. Pulses on Q control signal 7094 overlay and act to down-convert a rising Q-phase portion of I/Q modulation RF input signal 7082. Pulses on inverted Q control signal 7096 overlay and act to down-convert a falling Q-phase portion of I/Q modulation RF input signal 7082.

As FIG. 44D further shows in this example, the frequency ratio between the combination of control signals 7090, 7021, 7041, and 7043 and I/Q modulation RF input signal 7082 is approximately 4:3. Because the frequency of the potentially re-radiated signal, i.e., combined control signal 7045, is substantially different from that of the signal being down-converted, i.e., I/Q modulation RF input signal 7082, it does not interfere with signal down-conversion as it is out of the frequency band of interest, and hence may be filtered out. In this manner, I/Q modulation receiver 3906 reduces problems due to circuit re-radiation. As will be understood by persons skilled in the relevant art(s) from the teachings herein, frequency ratios other than 4:3 may be implemented to achieve similar reduction of problems of circuit re-radiation.

FIG. 44S and 44S-1 illustrate the receiver 3906, where the UFT modules 102A-1, 102A-2, 102B-1, and 102B-2 are configured with FETs 7099a-d.

### 4.2.2.2 Implementation of Multi-phase I/Q Modulation Receiver Embodiment with Exemplary Waveforms

FIG. 44E illustrates a more detailed example circuit implementation of I/Q modulation receiver 3906, according to an embodiment of the present invention. FIGS. 44F-P show example waveforms related to an example implementation of I/Q modulation receiver 3906 of FIG. 44E.

FIGS. 44F and 44G show first and second input data signals 7047 and 7049 to be I/Q modulated with a RF carrier signal frequency as the I-phase and Q-phase information signals, respectively.

FIGS. 44I and 44J show the signals of FIG. 44F and 44G after modulation with a RF carrier signal frequency, respectively, as I-modulated signal 7051 and Q-modulated signal 7053.

FIG. 44H shows an I/Q modulation RF input signal 7082 formed from I-modulated signal 7051 and Q-modulated signal 7053 of FIGS. 44I and 44J, respectively.

FIG. 44O shows an overlaid view of filtered I output signal 7007 and filtered inverted I output signal 7009.

FIG. 44P shows an overlaid view of filtered Q output signal 7011 and filtered inverted Q output signal 7013.

FIGS. 44K and 44L show I baseband output signal 7084 and Q baseband output signal 7086, respectfully. A data transition 7055 is indicated in both I baseband output signal 7084 and Q baseband output signal 7086. The corresponding data transition 7055 is indicated in I-modulated signal 7051 of FIG. 44I, Q-modulated signal 7053 of FIG. 44J, and I/Q modulation RF input signal 7082 of FIG. 44H.

FIGS. 44M and 44N show I baseband output signal 7084 and Q baseband output signal 7086 over a wider time interval.

### 4.2.2.3 Example Single Channel Receiver Embodiment

FIG. 44Q illustrates an example single channel receiver 7091, corresponding to either the I or Q channel of I/Q modulation receiver 3906. Single channel receiver 7091 can down-convert an input RF signal 7097 modulated according to AM, PM, FM, and other modulation schemes. Refer to section 7.2.1 above for further description on the operation of single channel receiver 7091. In other words, the single channel receiver 7091 is one channel of the IQ receiver 3906 that was discussed in section 7.2.1.

### 4.2.2.4 Alternative Example I/Q Modulation Receiver Embodiment

FIG. 44R illustrates an exemplary I/Q modulation receiver 7089 I/Q modulation receiver 7089 receives, down-converts, and demodulates an I/Q modulated RF input signal 7082 to an I baseband output signal 7084, and a Q baseband output signal 7086. I/Q modulation receiver 7089 has additional advantages of reducing or eliminating unwanted DC offsets and circuit re-radiation, in a similar fashion to that of I/Q modulation receiver 3906 described above.

### 4.3 Transmitter

Example embodiments and implementations of the IQ transmitter 3910 will be discussed as follows. The example embodiments and implementations include multi-phase embodiments that are useful for reducing or eliminating unwanted DC offsets that can result in unwanted carrier insertion.

### 4.3.1 Universal Transmitter with 2 UFT Modules

FIG. 45A illustrates a transmitter 3910. Transmitter 3910 includes a balanced modulator/up-converter 7104, a control signal generator 7142, an optional filter 7106, and an optional amplifier 7108. Transmitter 3910 up-converts a baseband signal 3942 to produce an output signal 7140 that is conditioned for wireless or wire line transmission. In doing so, the balanced modulator 7104 receives the baseband signal 3942 and samples the baseband signal in a differential and balanced fashion to generate a harmonicallyrich signal 7138. The harmonically rich signal 7138 includes multiple harmonic images, where each image contains the baseband information in the baseband signal 3942. The optional bandpass filter 308 may be included to select a harmonic of interest (or a subset of harmonics) in the signal 7138 for transmission. The optional amplifier 7108 may be included to amplify the selected harmonic prior to transmission. The universal transmitter is further described at a high level by the flowchart 8400 that is shown in FIG. 58. A more detailed structural and operational description of the balanced modulator follows thereafter.

Referring to flowchart 8400, in step 8402, the balanced modulator 7104 receives the baseband signal 3942.

In step 8404, the balanced modulator 7104 samples the baseband signal in a differential and balanced fashion according to a first and second control signals that are phase shifted with respect to each other. The resulting harmonically rich signal 7138 includes multiple harmonic images that repeat at harmonics of the sampling frequency, where each image contains the necessary amplitude and frequency information to reconstruct the baseband signal 3942U.

The control signals include pulses having pulse widths (or apertures) that are established to improve energy transfer to a desired harmonic of the harmonically rich signal 713 8. In further embodiments ofthe invention, DC offset voltages are minimized between sampling modules as indicated in step 8406, thereby minimizing carrier insertion in the harmonic images of the harmonically rich signal 7138.

In step 8408, the optional bandpass filter 308 selects the desired harmonic of interest (or a subset of harmonics) in from the harmonically rich signal 7138 for transmission.

In step 8410, the optional amplifier 7108 amplifies the selected harmonic(s) prior to transmission.

In step 8412, the selected harmonic(s) is transmitted over a communications medium.

### 4.3.1.1 Balanced Modulator Detailed Description

Referring to the example embodiment shown in FIG. 45A, the balanced modulator 7104 includes the following components: a buffer/inverter 7112; summer amplifiers 7118, 7119; UFT modules 102A and 102B having controlled switches 7148A and 7148B, respectively; an inductor 7126; a blocking capacitor 7136; and a DC terminal 7111. As stated above, the balanced modulator 7104 differentially samples the baseband signal 3942 to generate a harmonically rich signal 7138. More specifically, the UFT modules 102A and 102B sample the baseband signal in differential fashion according to control signals 7123 and 7127, respectively. A DC reference voltage 7113 is applied to terminal 7111 and is uniformly distributed to the UFT modules 102A and 102B. The distributed DC voltage 7113 prevents any DC offset voltages from developing between the UFT modules, which can lead to carrier insertion in the harmonically rich signal 7138. The operation of the balanced modulator 7104 is discussed in greater detail with reference to flowchart 8500 (FIG. 59), as follows.

In step 8402, the buffer/inverter 7112 receives the input baseband signal 3942 and generates input signal 7114 and inverted input signal 7116. Input signal 7114 is substantially similar to signal 3942, and inverted signal 7116 is an inverted version of signal 7114. As such, the buffer/inverter 7112 converts the (single-ended) baseband signal 3942 into differential input signals 7114 and 7116 that will be sampled by the UFT modules. Buffer/inverter 7112 can be implemented using known operational amplifier (op amp) circuits, as will be understood by those skilled in the arts.

In step 8504, the summer amplifier 7118 sums the DC reference voltage 7113 applied to terminal 7111 with the input signal 7114, to generate a combined signal 7120. Likewise, the summer amplifier 7119 sums the DC reference voltage 7113 with the inverted input signal 7116 to generate a combined signal 7122. Summer amplifiers 7118 and 7119 can be implemented using known op amp summer circuits, and can be designed to have a specified gain or attenuation, including unity gain. The DC reference voltage 7113 is also distributed to the outputs of both UFT modules 102A and 102B through the inductor 7126 as is shown.

In step 8506, the control signal generator 7142 generates control signals 7123 and 7127 that are shown by way of example in FIG. 46B and FIG. 46C, respectively. As illustrated, both control signals 7123 and 7127 have the same period TS as a master clock signal 7145 (FIG.72A), but have a pulse width (or aperture) of TA. In the example, control signal 7123 triggers on the rising pulse edge of the master clock signal 7145, and control signal 7127 triggers on the falling pulse edge of the master clock signal 7145. Therefore, control signals 7123 and 7127 are shifted in time by 180 degrees relative to each other. In embodiments of invention, the master clock signal 7145 (and therefore the control signals 7123 and 7127) have a frequency that is a sub-harmonic of the desired output signal 7140.

Preferably, the control signal generator 7142 includes an oscillator 7146, pulse generators 7144a and 7144b, and an inverter 7147 as shown. In operation, the oscillator 7146 generates the master clock signal 7145, which is illustrated in FIG. 46A as a periodic square wave having pulses with a period of TS. Other clock signals could be used including but not limited to sinusoidal waves, as will be understood by those skilled in the arts. Pulse generator 7144a receives the master clock signal 7145 and triggers on the rising pulse edge, to generate the control signal 7123. Inverter 7147 inverts the clock signal 7145 to generate an inverted clock signal 7143. The pulse generator 7144b receives the inverted clock signal 7143 and triggers on the rising pulse edge (which is the falling edge of clock signal 7145), to generate the control signal 7127.

FIGS. 63A-E illustrate example embodiments for the pulse generator 7144. FIG. 63A illustrates a pulse generator 8902. The pulse generator 8902 generates pulses 8908 having pulse width TA from an input signal 8904. Example input signals 8904 and pulses 8908 are depicted in FIGS. 63B and 63C, respectively. The input signal 8904 can be any type of periodic signal, including, but not limited to, a sinusoid, a square wave, a saw-tooth wave etc. The pulse width (or aperture) TA of the pulses 8908 is determined by delay 8906 of the pulse generator 8902. The pulse generator 8902 also includes an optional inverter 8910, which is optionally added for polarity considerations as understood by those skilled in the arts. The actual logic employed can take many forms. Additional examples of pulse generation logic are shown in FIGS. 63D and 63E. FIG. 63D illustrates a rising edge pulse generator 8912 that triggers on the rising edge of input signal 8904. FIG. 63E illustrates a falling edge pulse generator 8916 that triggers on the falling edge of the input signal 8904.

In step 8508, the UFT module 102A samples the combined signal 7120 according to the control signal 7123 to generate harmonically rich signal 7130. More specifically, the switch 7148A closes during the pulse widths TA of the control signal 7123 to sample the combined signal 7120 resulting in the harmonically rich signal 7130. FIG. 45B illustrates an exemplary frequency spectrum for the harmonically rich signal 7130 having harmonic images 7152a-n. The images 7152 repeat at harmonics of the sampling frequency 1/TS, at infinitum, where each image 7152 contains the necessary amplitude, frequency, and phase information to reconstruct the baseband signal 7110. As discussed further below, the relative amplitude of the frequency images is generally a function of the harmonic number and the pulse width TA. As such, the relative amplitude of a particular harmonic 7152 can be increased (or decreased) by adjusting the pulse width TA of the control signal 7123. In general, shorter pulse widths of TA shift more energy into the higher frequency harmonics, and longer pulse widths of TA shift energy into the lower frequency harmonics. The generation of harmonically rich signals by sampling an input signal according to a controlled aperture have been described earlier in this application in the section titled, "Frequency Up-conversion Using Universal Frequency Translation", and is illustrated by FIGs. 3-6.

In step 8510, the UFT module 102B samples the combined signal 7122 according to the control signal 7127 to generate harmonically rich signal 7134. More specifically, the switch 7148B closes during the pulse widths TA of the control signal 7127 to sample the combined signal 7122 resulting in the harmonically rich signal 7134. The harmonically rich signal 7134 includes multiple frequency images of baseband signal 3942 that repeat at harmonics of the sampling frequency (1/TS), similar to that for the harmonically rich signal 7130. However, the images in the signal 7134 are phase-shifted compared to those in signal 7130 because of the inversion of signal 7116 compared to signal 7114, and because of the relative phase shift between the control signals 7123 and 7127.

In step 8512, the node 7132 sums the harmonically rich signals 7130 and 7134 to generate harmonically rich signal 7133. FIG. 45C illustrates an exemplary frequency spectrum for the harmonically rich signal 7133 that has multiple images 7154a-n that repeat at harmonics of the sampling frequency 1/TS. Each image 7154 includes the necessary amplitude, frequency and phase information to reconstruct the baseband signal 3942 The capacitor 7136 operates as a DC blocking capacitor and substantially passes the harmonics in the harmonically rich signal 7133 to generate harmonically rich signal 7138 at the output of the modulator 7104.

In step 8408, the optional filter 7106 can be used to select a desired harmonic image for transmission. This is represented for example by a passband 7156 that selects the harmonic image 7154c for transmission in FIG. 45C.

An advantage of the modulator 7104 is that it is fully balanced, which substantially minimizes (or eliminates) any DC voltage offset between the two UFT modules 102A and 102B. DC offset is minimized because the reference voltage 7113 contributes a consistent DC component to the input signals 7120 and 7122 through the summing amplifiers 7118 and 7119, respectively. Furthermore, the reference voltage 7113 is also directly coupled to the outputs of the UFT modules 102A and 102B through the inductor 7126 and the node 7132. The result of controlling the DC offset between the UFT modules is that carrier insertion is minimized in the harmonic images of the harmonically rich signal 7138. As discussed above, carrier insertion is substantially wasted energy because the information for a modulated signal is carried in the sidebands of the modulated signal and not in the carrier. Therefore, it is often desirable to minimize the energy at the carrier frequency by controlling the relative DC offset.

### 4.3.1.2 Balanced Modulator Example Signal Diagrams and Mathematical Description

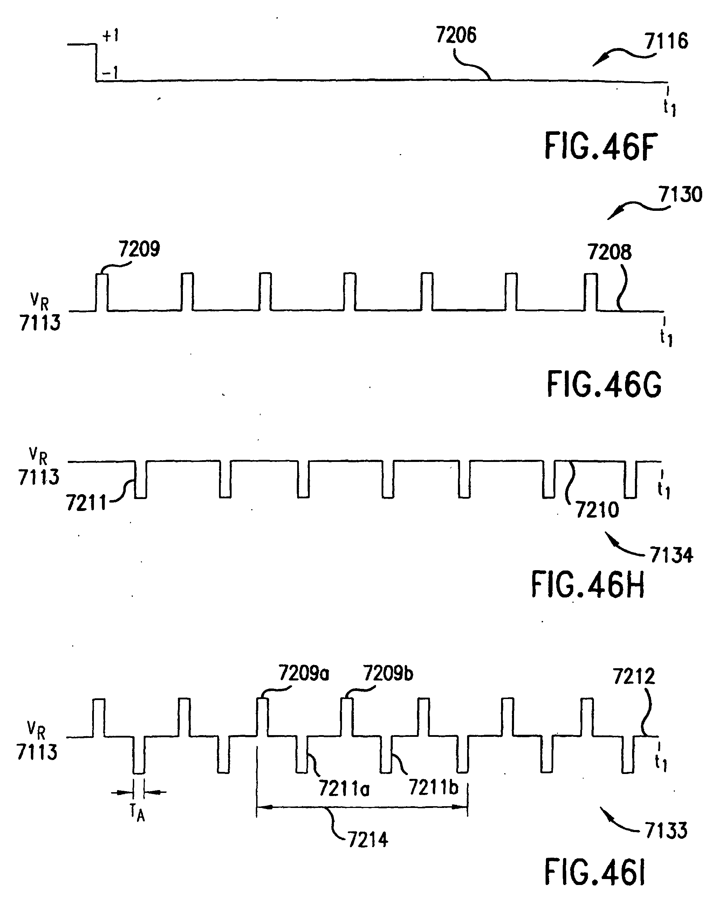

In order to further describe the invention, FIGs.46D-46I illustrate various example signal diagrams (vs. time) that are representative of the invention. FIG. 46D illustrates a signal 7202 that is representative of the input baseband signal 3942 (FIG. 45A). FIG. 46E illustrates a step function 7204 that is an expanded portion of the signal 7202 from time $t_0$ to $t_1$, and represents signal 7114 at the output of the buffer/inverter 7112. Similarly, FIG. 46F illustrates a signal 7206 that is an inverted version of the signal 7204, and represents the signal 7116 at the inverted output of buffer/inverter 7112. For analysis purposes, a step function is a good approximation for a portion of a single bit of data (for the baseband signal 7110) because the clock rates of the control signals 7123 and 7127 are significantly higher than the data rates of the baseband signal 7110. For example, if the data rate is in the KHz frequency range, then the clock rate will preferably be in MHZ frequency range in order to generate an output signal in the GHz frequency range.

Still referring to FIGs.46D-I, FIG. 46G illustrates a signal 7208 that an example of the harmonically rich signal 7130 when the step function 7204 is sampled according to the control signal 7123 in FIG. 46B. The signal 7208 includes positive pulses 7209 as referenced to the DC voltage 7113. Likewise, FIG. 46H illustrates a signal 7210 that is an example of the harmonically rich signal 7134 when the step function 7206 is sampled according to the control signal 7127. The signal 7210 includes negative pulses 7211 as referenced to the DC voltage 7113, which are time-shifted relative to the positive pulses 7209 in signal 7208.

Still referring to FIGs.46D-I, the FIG. 46I illustrates a signal 7212 that is the combination of signal 7208 (FIG. 46G) and the signal 7210 (FIG. 46H), and is an example of the harmonically rich signal 7133 at the output of the summing node 7132. As illustrated, the signal 7212 spends approximately as much time above the DC reference voltage 7113 as below the DC reference voltage 7113 over a limited time period. For example, over a time period 7214, the energy in the positive pulses 7209a-b is canceled out by the energy in the negative pulses 7211a-b. This is indicative of minimal (or zero) DC offset between the UFT modules 102A and 102B, which results in minimal carrier insertion during the sampling process.

Still referring to FIG. 46I, the time axis of the signal 7212 can be phased in such a manner to represent the waveform as an odd function. For such an arrangement, the Fourier series is readily calculated to obtain:

$$I_c(t) = \sum_{n-1}^{\infty} \left( \frac{4\sin\left(\frac{n\pi T_A}{T_S}\right) \cdot \sin\left(\frac{n\pi}{2}\right)}{n\pi} \right) \cdot \sin\left(\frac{2n\pi t}{T_S}\right) \quad \textit{Equation 1}$$

where:

$T_S$ = period of the master clock 7145
$T_A$ = pulse width of the control signals 7123 and 7127
n= harmonic number

[0153]    As shown by Equation 1, the relative amplitude of the frequency images is generally a function of the harmonic number n, and the ratio of $T_A/T_S$. As indicated, the $T_A/T_S$ ratio represents the ratio of the pulse width of the control signals relative to the period of the sub-harmonic master clock. The $T_A/T_S$ ratio can be optimized in order to maximize the amplitude of the frequency image at a given harmonic. For example, if a passband waveform is desired to be created at 5x the frequency of the sub-harmonic clock, then a baseline power for that harmonic extraction may be calculated for the fifth harmonic (n=5) as:

$$I_c(t) = \left( \frac{4\sin\left(\frac{5\pi T_A}{T_S}\right)}{5\pi} \right) \cdot \sin(5\omega_s t) \quad \textit{Equation 2.}$$

As shown by Equation 2, $I_C(t)$ for the fifth harmonic is a sinusoidal function having an amplitude that is proportional to the sin $(5\pi T_A/T_S)$. The signal amplitude can be maximized by setting $T_A = (1/10 \cdot T_S)$ so that sin $(5\pi T_A/T_S)$= sin $(\pi/2)$= 1. Doing so results in the equation:

$$\left. I_c(t) \right|_{n=5} = \frac{4}{5\pi} \left( \sin(5\omega_s t) \right) \quad \textit{Equation 3.}$$

This component is a frequency at 5x of the sampling frequency of sub-harmonic clock, and can be extracted from the Fourier series via a bandpass filter (such as bandpass filter 7106) that is centered around $5f_S$. The extracted frequency component can then be optionally amplified by the amplifier 7108 prior to transmission on a wireless or wire-line communications channel or channels.

Equation 3 can be extended to reflect the inclusion of a message signal as illustrated by equation 4 below:

$$m(t) \cdot \left. I_c(t) \right|_{\substack{n=5 \\ \theta=\theta(t)}} = \frac{4 \cdot m(t)}{5\pi} \left( \sin(5\omega_s t + 5\theta(t)) \right) \quad \textit{Equation 4.}$$

Equation 4 illustrates that a message signal can be carried in harmonically rich signals 7133 such that both amplitude and phase can be modulated. In other words, m($t$) is modulated for amplitude and θ($t$) is modulated for phase. In such cases, it should be noted that θ($t$) is augmented modulo n while the amplitude modulation m($t$) is simply scaled. Therefore, complex waveforms may be reconstructed from their Fourier series with multiple aperture UFT combinations.

As discussed above, the signal amplitude for the 5th harmonic was maximized by setting the sampling aperture width $T_A$= 1/10 $T_S$, where $T_S$ is the period of the master clock signal. This can be restated and generalized as setting $T_A$=½ the period (or radians) at the harmonic of interest. In other words, the signal amplitude of any harmonic n can be maximized by sampling the input waveform with a sampling aperture of $T_A$= ½ the period of the harmonic of interest (n). Based on this discussion, it is apparent that varying the aperture changes the harmonic and amplitude content of the output waveform. For example, if the sub-harmonic clock has a frequency of 200 MHZ, then the fifth harmonic is at 1 GHz. The amplitude of the fifth harmonic is maximized by setting the aperture width $T_A$= 500 picoseconds, which equates to ½ the period (or radians) at 1 GHz.

FIG. 46J depicts a frequency plot 7216 that graphically illustrates the effect of varying the sampling aperture of the control signals on the harmonically rich signal 7133 given a 200 MHZ harmonic clock. The frequency plot 7216 compares two frequency spectrums 7218 and 7220 for different control signal apertures given a 200 MHZ clock. More specifically, the frequency spectrum 7218 is an example spectrum for signal 7133 given the 200 MHZ clock with the aperture $T_A$ = 500 psec (where 500 psec is radians at the 5th harmonic of 1GHz). Similarly, the frequency spectrum 7220 is an example spectrum for signal 7133 given a 200 MHZ clock that is a square wave (so $T_A$ = 5000 psec). The spectrum 7218 includes multiple harmonics 7218a-I, and the frequency spectrum 7220 includes multiple harmonics 7220a-e. At 1 Ghz (which is the 5th harmonic), the signal amplitude of the two frequency spectrums 7218e and 7220c are approximately equal. However, at 200 MHZ, the frequency spectrum 7218a has a much lower amplitude than the frequency spectrum 7220a, and therefore the frequency spectrum 7218 is more efficient than the frequency spectrum 7220, assuming the desired harmonic is the 5th harmonic. In other words, assuming 1 Ghz is the desired harmonic, the frequency spectrum 7218 wastes less energy at the 200 MHZ fundamental than does the frequency spectrum 7218.

### 4.3.1.3 Balanced Modulator Having a Shunt Configuration

FIG. 53A illustrates a universal transmitter 3910 that is a second embodiment of a universal transmitter having a balanced modulator 7901, with two balanced UFT modules in a shunt configuration. (In contrast, the balanced modulator 7104 can be described as having a series configuration based on the orientation of the UFT modules.) Transmitter 3910 includes a balanced modulator 7901, the control signal generator 7142, the optional bandpass filter 308, and the optional amplifier 7108. The balanced modulator 7901 up-converts a baseband signal 3942 to produce an output signal 7936 that is conditioned for wireless or wire line transmission. In doing so, the balanced modulator 7901 receives the baseband signal 3942 and shunts the baseband signal to ground in a differential and balanced fashion to generate a harmonically rich signal 7934. The harmonically rich signal 7934 includes multiple harmonic images, where each image contains the baseband information in the baseband signal 3942. In other words, each harmonic image includes the necessary amplitude, frequency, and phase information to reconstruct the baseband signal 3942. The optional bandpass filter 308 may be included to select a harmonic of interest (or a subset of harmonics) in the signal 7934 for transmission. The optional amplifier 7108 may be included to amplify the selected harmonic prior to transmission, resulting in the output signal 7936.

The balanced modulator 7901 includes the following components: a buffer/inverter 7112; optional impedances 7910, 7912; UFT modules 102A and 102B having controlled switches 7918 and 7924, respectively; blocking capacitors 7928 and 7930; and a terminal 7920 that is tied to ground. As stated above, the balanced modulator 7901 differentially shunts the baseband signal 3942 to ground, resulting in a harmonically rich signal 7934. More specifically, the UFT modules 102A and 102B alternately shunt the baseband signal to terminal 7920 according to control signals 7123 and 7127, respectively. Terminal 7920 is tied to ground and prevents any DC offset voltages from developing between the UFT modules 102A and 102B. As described above, a DC offset voltage can lead to undesired carrier insertion. The operation of the balanced modulator 7901 is described in greater detail according to the flowchart 8600 (FIG. 60) as follows.

In step 8402, the buffer/inverter 7112 receives the input baseband signal 3942 and generates I signal 7114 and inverted I signal 7116. I signal 7114 is substantially similar to the baseband signal 3942, and the inverted I signal 7116 is an inverted version of signal 3942. As such, the buffer/inverter 7112 converts the (single-ended) baseband signal 3942 into differential signals 7114 and 7116 that are sampled by the UFT modules. Buffer/inverter 7112 can be implemented using known operational amplifier (op amp) circuits, as will be understood by those skilled in the arts.

In step 8604, the control signal generator 7142 generates control signals 7123 and 7127 from the master clock signal 7145. Examples of the master clock signal 7145, control signal 7123, and control signal 7127 are shown in FIGs. 46A-C, respectively. As illustrated, both control signals 7123 and 7127 have the same period $T_S$ as a master clock signal 7145, but have a pulse width (or aperture) of $T_A$. Control signal 7123 triggers on the rising pulse edge of the master clock signal 7145, and control signal 7127 triggers on the falling pulse edge of the master clock signal 7145.

Therefore, control signals 7123 and 7127 are shifted in time by 180 degrees relative to each other. A specific example of the control signal generator 7142 is illustrated in FIG. 45A, and was discussed in detail above.

In step 8606, the UFT module 102A shunts the signal 7114 to ground according to the control signal 7123, to generate a harmonically rich signal 7914. More specifically, the switch 7918 closes and shorts the signal 7114 to ground (at terminal 7920) during the aperture width $T_A$ of the control signal 7123, to generate the harmonically rich signal 7914. FIG. 53B illustrates an exemplary frequency spectrum for the harmonically rich signal 7918 having harmonic images 7950a-n. The images 7950 repeat at harmonics of the sampling frequency $1/T_S$, at infinitum, where each image 7950 contains the necessary amplitude, frequency, and phase information to reconstruct the baseband signal 3942. The generation of harmonically rich signals by sampling an input signal according to a controlled aperture have been described earlier in this application in the section titled, "Frequency Up-conversion Using Universal Frequency Translation", and is illustrated by FIGs. 3-6.

The relative amplitude of the frequency images 7950 are generally a function of the harmonic number and the pulse width $T_A$. As such, the relative amplitude of a particular harmonic 7950 can be increased (or decreased) by adjusting the pulse width $T_A$ of the control signal 7123. In general, shorter pulse widths of $T_A$ shift more energy into the higher frequency harmonics, and longer pulse widths of $T_A$ shift energy into the lower frequency harmonics, as described by equations 1-4 above. Additionally, the relative amplitude of a particular harmonic 7950 can also be adjusted by adding/tuning an optional impedance 7910. Impedance 7910 operates as a filter that emphasizes a particular harmonic in the harmonically rich signal 7914.

In step 8608, the UFT module 102B shunts the inverted signal 7908 to ground according to the control signal 7127, to generate a harmonically rich signal 7926. More specifically, the switch 7924 closes during the pulse widths $T_A$ and shorts the inverted I signal 7908 to ground (at terminal 7920), to generate the harmonically rich signal 7926. At any given time, only one of input signals 7114 or 7116 is shorted to ground because the pulses in the control signals 7123 and 7127 are phase shifted with respect to each other, as shown in FIGs. 46B and 46C.

The harmonically rich signal 7926 includes multiple frequency images of baseband signal 3942 that repeat at harmonics of the sampling frequency ($1/T_S$), similar to that for the harmonically rich signal 7914. However, the images in the signal 7926 are phase-shifted compared to those in signal 7914 because of the inversion of the signal 7908 compared to the signal 7114, and because of the relative phase shift between the control signals 7123 and 7127. The optional impedance 7912 can be included to emphasis a particular harmonic of interest, and is similar to the impedance 7910 above.

In step 8610, the node 7932 sums the harmonically rich signals 7914 and 7926 to generate the harmonically rich signal 7934. The capacitors 7928 and 7930 operate as blocking capacitors that substantiallypass the respective harmonically rich signals 7914 and 7926 to the node 7932. (The capacitor values may be chosen to substantially block baseband frequency components as well.) FIG. 53C illustrates an exemplary frequency spectrum for the harmonically rich signal 7934 that has multiple images 7952a-n that repeat at harmonics of the sampling frequency $1/T_S$. Each image 7952 includes the necessary amplitude, frequency, and phase information to reconstruct the baseband signal 3942. The optional filter 308 can be used to select the harmonic image of interest for transmission. This is represented by a passband 7956 that selects the harmonic image 7932c for transmission.

An advantage of the modulator 7901 is that it is fully balanced, which substantially minimizes (or eliminates) any DC voltage offset between the two UFT modules 102A and 102B. DC offset is minimized because the UFT modules 102A and 102B are both connected to ground at terminal 7920. The result of controlling the DC offset between the UFT modules is that carrier insertion is minimized in the harmonic images of the harmonically rich signal 7934. As discussed above, carrier insertion is substantially wasted energy because the information for a modulated signal is carried in the sidebands of the modulated signal and not in the carrier. Therefore, it is often desirable to minimize the energy at the carrier frequency by controlling the relative DC offset.

### 4.3.1.4 Balanced Modulator FET Configuration

As described above, the balanced modulators 7104 and 7901 utilize two balanced UFT modules to sample the input baseband signals to generate harmonically rich signals that contain the up-converted baseband information. More specifically, the UFT modules include controlled switches that sample the baseband signal in a balanced and differential fashion. FIGs. 45D and 79D illustrate embodiments of the controlled switch in the UFT module.

FIG. 45D illustrates an example embodiment of the modulator 7104 (FIG. 45B) where the controlled switches in the UFT modules are field effect transistors (FET). More specifically, the controlled switches 7148A and 7148B are embodied as FET 7158 and FET 7160, respectively. The FET 7158 and 7160 are oriented so that their gates are controlled by the control signals 7123 and 7127, so that the control signals control the FET conductance. For the FET 7158, the combined baseband signal 7120 is received at the source of the FET 7158 and is sampled according to the control signal 7123 to produce the harmonically rich signal 7130 at the drain of the FET 7158. Likewise, the combined baseband signal 7122 is received at the source of the FET 7160 and is sampled according to the control signal 7127

to produce the harmonically rich signal 7134 at the drain of FET 7160. The source and drain orientation that is illustrated is not limiting, as the source and drains can be switched for most FETs. In other words, the combined baseband signal can be received at the drain of the FETs, and the harmonically rich signals can be taken from the source of the FETs, as will be understood by those skilled in the relevant arts.

FIG. 53D illustrates an embodiment of the modulator 7901 (FIG. 53A) where the controlled switches in the UFT modules are field effect transistors (FET). More specifically, the controlled switches 7918 and 7924 are embodied as FET 7936 and FET 7938, respectively. The FETs 7936 and 7938 are oriented so that their gates are controlled by the control signals 7123 and 7127, respectively, so that the control signals determine FET conductance. For the FET 7936, the baseband signal 7114 is received at the source of the FET 7936 and shunted to ground according to the control signal 7123, to produce the harmonically rich signal 7914. Likewise, the baseband signal 7116 is received at the source of the FET 7938 and is shunted to ground according to the control signal 7127, to produce the harmonically rich signal 7926. The source and drain orientation that is illustrated is not limiting, as the source and drains can be switched for most FETs, as will be understood by those skilled in the relevant arts.

### 4.3.1.5 Universal Transmitter Configured for Carrier Insertion

As discussed above, the modulators 7104 and 7901 of transmitter 3910 have a balanced configuration that substantially eliminates any DC offset and results in minimal carrier insertion in the output signal. Minimal carrier insertion is generally desired for most applications because the carrier signal carries no information and reduces the overall transmitter efficiency. However, some applications require the received signal to have sufficient carrier energy for the receiver to extract the carrier for coherent demodulation. In support thereof, the present invention can be configured to provide the necessary carrier insertion by implementing a DC offset between the two sampling UFT modules.

FIG. 47A illustrates a modulator 7304 of transmitter 3910 that up-converts a baseband signal 3942 to an output signal 7322 having carrier insertion. As is shown, the modulator 7304 is similar to the modulator 7104 (FIG. 45A) with the exception that the up-converter/modulator 7304 is configured to accept two DC references voltages. In contrast, modulator 7104 was configured to accept only one DC reference voltage. More specifically, the modulator 7304 includes a terminal 7309 to accept a DC reference voltage 7308, and a terminal 7313 to accept a DC reference voltage 7314. Vr 7308 appears at the UFT module 120A though summer amplifier 7118 and the inductor 7310. Vr 7314 appears at UFT module 102B through the summer amplifier 7119 and the inductor 7316. Capacitors 7312 and 7318 operate as blocking capacitors. If Vr 7308 is different from Vr 7314 then a DC offset voltage will be exist between UFT module 102A and UFT module 102B, which will be up-converted at the carrier frequency in the harmonically rich signal 7320. More specifically, each harmonic image in the harmonically rich signal 7320 will include a carrier signal as depicted in FIG. 47B.

FIG. 47B illustrates an exemplary frequency spectrum for the harmonically rich signal 7320 that has multiple harmonic images 7324a-n. In addition to carrying the baseband information in the sidebands, each harmonic image 7324 also includes a carrier signal 7326 that exists at respective harmonic of the sampling frequency $1/T_S$. The amplitude of the carrier signal increases with increasing DC offset voltage. Therefore, as the difference between Vr 7308 and Vr 7314 widens, the amplitude of each carrier signal 7326 increases. Likewise, as the difference between Vr 7308 and Vr 7314 shrinks, the amplitude of each carrier signal 7326 shrinks. As with modulator 7304, the optional bandpass filter 308 can be included to select a desired harmonic image for transmission. This is represented by passband 7328 in FIG. 47B.

### 4.3.2 Universal Transmitter In IQ Configuration:

As described above, the balanced modulators 7104 and 7901 up-convert a baseband signal to a harmonically rich signal having multiple harmonic images of the baseband information. By combining two balanced modulators, IQ configurations can be formed for up-converting I and Q baseband signals. In doing so, either the (series type) balanced modulator 7104 or the (shunt type) balanced modulator 7901 can be utilized. IQ modulators having both series and shunt configurations are described below.

### 4.3.2.1 IQ Transmitter Using Series-Type Balanced Modulator

FIG. 48 illustrates an IQ transmitter 3910 with modulator 7410 with an in-phase (I) and quadrature (Q) configuration. The transmitter 3910 includes an IQ balanced modulator 7410, an optional filter 308, and an optional amplifier 7108. The transmitter 3910 with modulator 7401 is useful for transmitting complex I Q waveforms and does so in a balanced manner to control DC offset and carrier insertion. In doing so, the modulator 7410 receives an I baseband signal 3942 and a Q baseband signal 3944 and up-converts these signals to generate a combined harmonically rich signal 7412. The harmonically rich signal 7412 includes multiple harmonics images, where each image contains the baseband information in the I signal 3942 and the Q signal 3944. The optional bandpass filter 308 may be included to select a harmonic of interest (or subset of harmonics) from the signal 7412 for transmission. The optional amplifier 7108 may be included to amplify the selected harmonic prior to transmission, to generate the IQ output signal 7418.

As stated above, the balanced IQ modulator 7410 up-converts the I baseband signal 3942 and the Q baseband signal 3944 in a balanced manner to generate the combined harmonically rich signal 7412 that carries the I and Q baseband information. To do so, the modulator 7410 utilizes two balanced modulators 7104 from FIG. 45A, a signal combiner 7408, and a DC terminal 7407. The operation of the balanced modulator 7410 and other circuits in the transmitter is described according to the flowchart 8700 in FIG. 61, as follows.

In step 8702, the IQ modulator 7410 receives the I baseband signal 3942 and the Q baseband signal 3944.

In step 8704, the I balanced modulator 7104a samples the I baseband signal 3942 in a differential fashion using the control signals 7123 and 7127 to generate a harmonically rich signal 7411a. The harmonically rich signal 7411 a contains multiple harmonic images of the I baseband information, similar to the harmonically rich signal 7130 in FIG. 45B.

In step 8706, the balanced modulator 7104b samples the Q baseband signal 3944 in a differential fashion using control signals 7123 and 7127 to generate harmonically rich signal 7411b, where the harmonically rich signal 7411b contains multiple harmonic images of the Q baseband signal 3944. The operation of the balanced modulator 7104 and the generation of harmonically rich signals was fully described above and illustrated in FIGs. 45A-C, to which the reader is referred for further details.

In step 8708, the DC terminal 7407 receives a DC voltage 7406 that is distributed to both modulators 7104a and 7104b. The DC voltage 7406 is distributed to both the input and output of both UFT modules 102A and 102B in each modulator 7104. This minimizes (or prevents) DC offset voltages from developing between the four UFT modules, and thereby minimizes or prevents any carrier insertion during the sampling steps 8704 and 8706.

In step 8710, the 90 degree signal combiner 7408 combines the harmonically rich signals 7411a and 7411b to generate IQ harmonically rich signal 7412. This is further illustrated in FIGs. 49A-C. FIG. 49A depicts an exemplary frequency spectrum for the harmonically rich signal 7411a having harmonic images 7502a-n. The images 7502 repeat at harmonics of the sampling frequency $1/T_S$, where each image 7502 contains the necessary amplitude and frequency information to reconstruct the I baseband signal 3942. Likewise, FIG. 49B depicts an exemplary frequency spectrum for the harmonically rich signal 7411b having harmonic images 7504a-n. The harmonic images 7504a-n also repeat at harmonics of the sampling frequency $1/T_S$, where each image 7504 contains the necessary amplitude, frequency, and phase information to reconstruct the Q baseband signal 3944. FIG.75C illustrates an exemplary frequency spectrum for the combined harmonically rich signal 7412 having images 7506. Each image 7506 carries the I baseband information and the Q baseband information from the corresponding images 7502 and 7504, respectively, without substantially increasing the frequency bandwidth occupied by each harmonic 7506. This can occur because the signal combiner 7408 phase shifts the Q signal 7411b by 90 degrees relative to the I signal 7411a. The result is that the images 7502a-n and 7504a-n effectively share the signal bandwidth due to their orthogonal relationship. For example, the images 7502a and 7504a effectively share the frequency spectrum that is represented by the image 7506a.

In step 8712, the optional filter 7414 can be included to select a harmonic of interest, as represented by the passband 7508 selecting the image 7506c in FIG. 49C.

In step 8714, the optional amplifier 7416 can be included to amplify the harmonic (or harmonics) of interest prior to transmission.

In step 8716, the selected harmonic (or harmonics) is transmitted over a communications medium.

FIG. 50A illustrates a transmitter 3910 having modulator 7602 that is a second example of an I Q transmitter having a balanced configuration. Modulator 7602 is similar to the modulator 7410 except that the 90 degree phase shift between the I and Q channels is achieved by phase shifting the control signals instead of using a 90 degree signal combiner to combine the harmonically rich signals. More specifically, delays 7604a and 7604b delay the control signals 7123 and 7127 for the Q channel modulator 7104b by 90 degrees relative the control signals for the I channel modulator 7104a. As a result, the Q modulator 7104b samples the Q baseband signal 3944 with 90 degree delay relative to the sampling of the I baseband signal 3942 by the I channel modulator 7104a. Therefore, the Q harmonically rich signal 7411b is phase shifted by 90 degrees relative to the I harmonically rich signal. Since the phase shift is achieved using the control signals, an in-phase signal combiner 7606 combines the harmonically rich signals 7411a and 7411b, to generate the harmonically rich signal 7412.

FIG. 50B illustrates a transmitter 3910 having modulator 7620 that is similar to modulator 7602 in FIG. 50A. The difference being that modulator 7620 utilizes a summing node 7622 to sum the signals 7411a and 7411b instead of the in-phase signal combiner 7606 that is used in modulator 7602.

FIG. 64A and 64D illustrate various detailed circuit implementations of the transmitter 3910 in FIG. 48. These circuit implementations are meant for example purposes only, and are not meant to be limiting.

FIG. 64A illustrates I input circuitry 9002a and Q input circuitry 9002b that receive the I and Q input signals 3942 and 3944, respectively.

FIG. 64D illustrates the output combiner circuit 9012 that combines the I channel data 9007 and the Q channel data 9010 to generate the output signal 7418.

### 4.3.2.2 IQ Transmitter Using Shunt-Type Balanced Modulator

FIG. 54 illustrates an IQ transmitter 3910 having modulator 8001 that is another IQ transmitter example. The transmitter 3910 includes an IQ balanced modulator 8001, an optional filter 308, and an optional amplifier 7108. During operation, the modulator 8001 up-converts an I baseband signal 3942 and a Q baseband signal 3944 to generate a combined harmonically rich signal 8011. The harmonically rich signal 8011 includes multiple harmonic images, where each image contains the baseband information in the I signal 3942 and the Q signal 3944. The optional bandpass filter 8012 may be included to select a harmonic of interest (or subset of harmonics) from the harmonically rich signal 8011 for transmission. The optional amplifier 308 may be included to amplify the selected harmonic prior to transmission, to generate the IQ output signal 3946.

The IQ modulator 8001 includes two shunt balanced modulators 7901 from FIG. 53A, and a 90 degree signal combiner 7408 as shown. The operation of the IQ modulator 8001 is described in reference to the flowchart 8800 (FIG. 62), as follows.

In step 8802, the balanced modulator 8001 receives the I baseband signal 3942 and the Q baseband signal 3944.

In step 8804, the balanced modulator 7901 a differentially shunts the I baseband signal 3942 to ground according the control signals 7123 and 7127, to generate a harmonically rich signal 8006. More specifically, the UFT modules 102A and 102B alternately shunt the I baseband signal 3942 and an inverted version of the I baseband signal 3942 to ground according to the control signals 7123 and 7127, respectively. The operation of the balanced modulator 7901 and the generation of harmonically rich signals was fully described above and is illustrated in FIGs.53A-C, to which the reader is referred for further details. As such, the harmonically rich signal 8006 contains multiple harmonic images of the I baseband information as described above.

In step 8806, the balanced modulator 7901b differentially shunts the Q baseband signal 3944 to ground according to control signals 7123 and 7127, to generate harmonically rich signal 8008. More specifically, the UFT modules 102A and 102B alternately shunt the Q baseband signal 3944 and an inverted version of the Q baseband signal 3944 to ground, according to the control signals 7123 and 7127, respectively. As such, the harmonically rich signal 8008 contains multiple harmonic images that contain the Q baseband information.

In step 8808, the 90 degree signal combiner 7408 combines the harmonically rich signals 8006 and 8008 to generate IQ harmonically rich signal 8011. This is further illustrated in FIGs. 55A-C. FIG. 55A depicts an exemplary frequency spectrum for the harmonically rich signal 8006 having harmonic images 8102a-n. The harmonic images 8102 repeat at harmonics of the sampling frequency $1/T_S$, where each image 8102 contains the necessary amplitude, frequency, and phase information to reconstruct the I baseband signal 3942. Likewise, FIG. 55B depicts an exemplary frequency spectrum for the harmonically rich signal 8008 having harmonic images 8104a-n. The harmonic images 8104a-n also repeat at harmonics of the sampling frequency $1/T_S$, where each image 8104 contains the necessary amplitude, frequency, and phase information to reconstruct the Q baseband signal 3944. FIG.81C illustrates an exemplary frequency spectrum for the IQ harmonically rich signal 8011 having images 8106a-n. Each image 8106 carries the I baseband information and the Q baseband information from the corresponding images 8102 and 8104, respectively, without substantially increasing the frequency bandwidth occupied by each image 8106. This can occur because the signal combiner 7408 phase shifts the Q signal 8008 by 90 degrees relative to the I signal 8006.

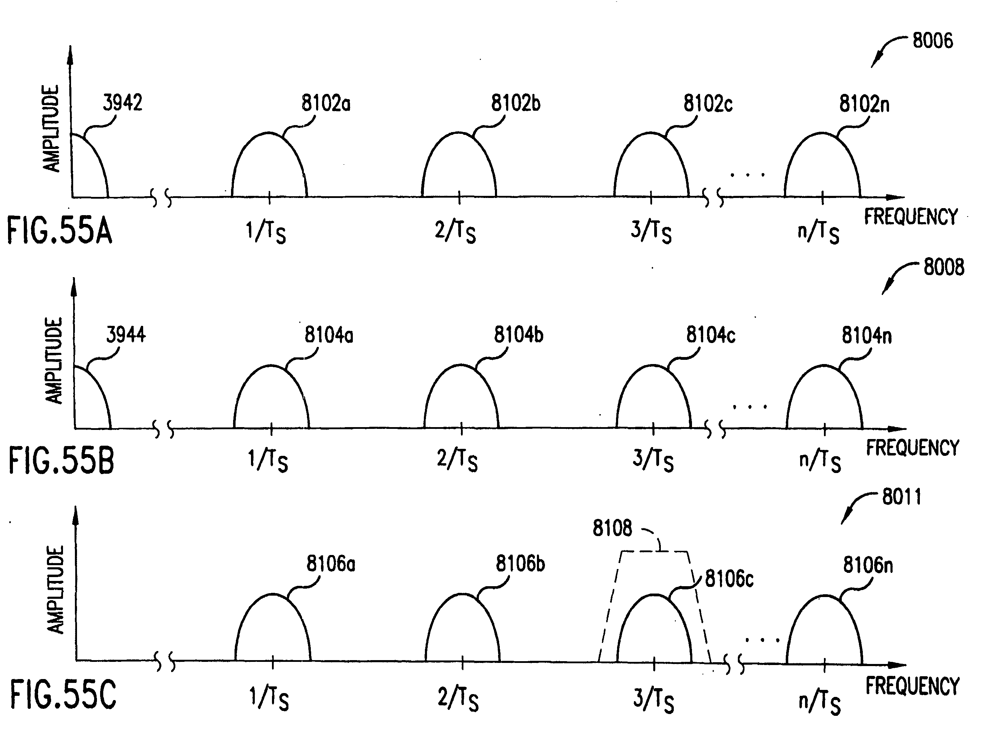

In step 8810, the optional filter 308 may be included to select a harmonic of interest, as represented by the passband 8108 selecting the image 8106c in FIG. 55C.

In step 8812, the optional amplifier 7108 can be included to amplify the selected harmonic image 8106 prior to transmission.

In step 8814, the selected harmonic (or harmonics) is transmitted over a communications medium.

FIG. 56 illustrates a transmitter 3910 having a modulator 8202 that is another example of an IQ transmitter having a balanced configuration. Modulator 8202 is similar to the modulator 8001 except that the 90 degree phase shift between the I and Q channels is achieved by phase shifting the control signals instead of using a 90 degree signal combiner to combine the harmonically rich signals. More specifically, delays 8204a and 8204b delay the control signals 7123 and 7127 for the Q channel modulator 7901b by 90 degrees relative the control signals for the I channel modulator 7901a. As a result, the Q modulator 7901b samples the Q baseband signal 3944 with a 90 degree delay relative to the sampling of the I baseband signal 3942 by the I channel modulator 7901a. Therefore, the Q harmonically rich signal 8008 is phase shifted by 90 degrees relative to the I harmonically rich signal 8006. Since the phase shift is achieved using the control signals, an in-phase signal combiner 8206 combines the harmonically rich signals 8006 and 8008, to generate the harmonically rich signal 8011.

FIG.83 illustrates a transmitter 3910 having modulator 8302 that is similar to modulator 8202 in FIG. 56. The difference being that the transmitter 3910 has a balanced modulator 8302 that utilizes a summing node 8304 to sum the I harmonically rich signal 8006 and the Q harmonically rich signal 8008 instead of the in-phase signal combiner 8206 that is used in the modulator 8202 of transmitter 8200. The 90 degree phase shift between the I and Q channels is implemented by delaying the Q clock signals using 90 degree delays 8204, as shown.

### 4.3.2.3 IQ Transmitters Configured for Carrier Insertion

The modulators 7410 (FIG. 48) and 7602 (FIG. 50A) have a balanced configuration that substantially eliminates any DC offset and results in minimal carrier insertion in the IQ output signal 7418. Minimal carrier insertion is generally desired for most applications because the carrier signal carries no information and reduces the overall transmitter efficiency. However, some applications require the received signal to have sufficient carrier energy for the receiver to extract the carrier for coherent demodulation. In support thereof, FIG. 51 illustrates a transmitter 3910 with modulator 7704 to provide any necessary carrier insertion by implementing a DC offset between the two sets of sampling UFT modules.

Modulator 7704 is similar to the modulator 7410 with the exception that a modulator 7704 is configured to accept two DC reference voltages so that the I channel modulator 7104a can be biased separately from the Q channel modulator 7104b. More specifically, modulator 7704 includes a terminal 7706 to accept a DC voltage reference 7707, and a terminal 7708 to accept a DC voltage reference 7709. Voltage 7707 biases the UFT modules 102A and 102B in the I channel modulator 7104a. Likewise, voltage 7709 biases the UFT modules 102A and 102B in the Q channel modulator 7104b. When voltage 7707 is different from voltage 7709, then a DC offset will appear between the I channel modulator 7104a and the Q channel modulator 7104b, which results in carrier insertion in the IQ harmonically rich signal 7412. The relative amplitude of the carrier frequency energy increases in proportion to the amount of DC offset.

FIG. 52 illustrates a transmitter 3910 having modulator 7804 that is a second example of an IQ transmitter having two DC terminals to cause DC offset, and therefore carrier insertion. Modulator 7804 is similar to modulator 7704 except that the 90 degree phase shift between the I and Q channels is achieved by phase shifting the control signals, similar to that done in transmitter 7608. More specifically, delays 7804a and 7804b phase shift the control signals 7123 and 7127 for the Q channel modulator 7104b relative to those of the I channel modulator 7104a. As a result, the Q modulator 7104b samples the Q baseband signal 3944 with 90 degree delay relative to the sampling of the I baseband signal 3942 by the I channel modulator 7104a. Therefore, the Q harmonically rich signal 7411b is phase shifted by 90 degrees relative to the I harmonically rich signal 7411a, which are combined by the in-phase combiner 7606.

### 4.4 Transceiver Embodiments

Referring to FIG. 31, in embodiments the receiver 3906, transmitter 3910, and LNA/PA 3904 are configured as a transceiver, such as but not limited to transceiver 9100, that is shown in FIG. 65.

Referring to FIG. 65, the transceiver 9100 includes a diplexer 9108, the IQ receiver 3906, and the IQ transmitter 3910. Transceiver 9100 up-converts an I baseband signal 3942 and a Q baseband signal 3944 using the IQ transmitter 3910 having modulator 8001 (FIG. 54) to generate an IQ RF output signal 9106. A detailed description of the IQ transmitter 3910 is included for example in section 7.3.2.2, to which the reader is referred for further details. Additionally, the transceiver 9100 also down-converts a received RF signal 9104 using the IQ Receiver 3906, resulting in I baseband output signal 3926 and a Q baseband output signal 3928. A detailed description of the IQ receiver 3906 is included in section 7.2.2, to which the reader is referred for further details.

### 4.5 Demodulator/Modulator Facilitation Module

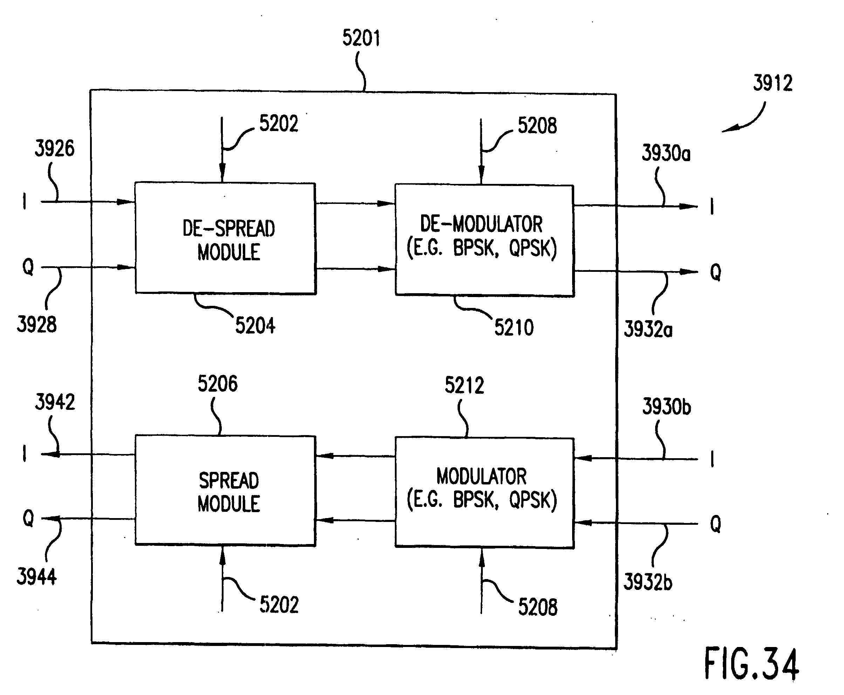

FIG. 34 illustrates an exemplary demodulator/modulator facilitation module 5201. Facilitation module 5201 includes the following: de-spread module 5204, spread module 5206, de-modulator 5210, and modulator 5212.

For receive, the de-spread module 5204 de-spreads received spread signals 3926 and 3928 using a spreading code 5202. Separate spreading codes can be used for the I and Q channels as will be understood by those skilled in the arts. The demodulator 5210 uses a signal 5208 to demodulate the de-spread received signals from the de-spread module 5204, to generate the I baseband signal 3930a and the Q baseband signal 3932a.

For transmit, the modulator 5212 modulates the I baseband signal 3930b and the Q baseband signal 3932b using a modulation signal 5208. The resulting modulated signals are then spread by the spread module 5206, to generate I spread signal 3942 and Q spread signal 3944.

Preferably, the modulation scheme that is utilized is differential binary phase shift keying (DBPSK) or differential quadrature phase shift keying (DQPSK), and is compliant with the various versions of IEEE 802.11. Other modulation schemes could be utilized besides DBPSK or DQPSK, as will understood by those skilled in arts based on the discussion herein.

Preferably, the spreading code 5202 is a Barker spreading code, and is compliant with the various versions of IEEE 802.11. More specifically, an 11-bit Barker word may be utilized for spreading/de-spreading. Other spreading codes could be utilized as will be understood by those skilled in the arts based on the discussion herein.

### 4.6 MAC Interface

The MAC 3918 and MAC interface 3914 supply the functionality required to provide a reliable delivery mechanism for user data over noisy, and unreliable wireless media. This is done this while also providing advanced LAN services, equal to or beyond those of existing wired LANs.

The first functionality of the MAC is to provide a reliable data delivery service to users of the MAC. Through a frame exchange protocol at the MAC level, the MAC significantly improves on the reliability of data delivery services over wireless media, as compared to earlier WLANs. More specifically, the MAC implements a frame exchange protocol to allow the source of a frame to determine when the frame has been successfully received at the destination. This frame exchange protocol adds some overhead beyond that of other MAC protocols, like IEEE 802.3, because it is not sufficient to simply transmit a frame and expect that the destination has received it correctly on the wireless media. In addition, it cannot be expected that every station in the WLAN is able to communicate with every other station in the WLAN. If the source does not receive this acknowledgment, then the source will attempt to transmit the frame again. This retransmission of frame by the source effectively reduces the effective error rate of the medium at the cost of additional bandwidth consumption.

The minimal MAC frame exchange protocol consists of two frames, a frame sent from the source to the destination and an acknowledgment from the destination that the frame was received correctly. The frame and its acknowledgment are an atomic unit of the MAC protocol. As such, they cannot be interrupted by the transmission from any other station. Additionally, a second set of frames may be added to the minimal MAC frame exchange. The two added frames are a request to send frame and a clear to send frame. The source sends a request to send to the destination. The destination returns a clear to send to the source. Each of these frames contains information that allows other stations receiving them to be notified of the upcoming frame transmission, and therefore to delay any transmission their own. The request to send and clear frames serve to announce to all stations in the neighborhood of both the source and the destination about the pending transmission from the source to the destination. When the source receives the clear to send from the destination, the real frame that the source wants delivered to the destination is sent. If the frame is correctly received at the destination, then the destination will return an acknowledgment. completing the frame exchange protocol. While this four way frame exchange protocol is a required function of the MAC, it may be disabled by an attribute in the management information base.

The second functionality of the MAC is to fairly control access to the shared wireless medium. It performs this function through two different access mechanisms: the basic access mechanism, call the distribution coordination system function, and a centrally controlled access mechanism, called the point coordination function.

The basic access mechanism is a carrier sense multiple access with collision avoidance (CSMA/CA) with binary exponential backoff. This access mechanism is similar to that used for IEEE 802.3, with some variations. CSMA/CA is a "listen before talk" (LBT) access mechanism. In this type of access mechanism, a station will listen to the medium before: beginning a transmission. If the medium is already carrying a transmission, then the station that listening will not begin its own transmission. More specifically, if a listening station detects an existing transmission in progress, the listening station enters a transmit deferral period determined by the binary exponential backoff algorithm. The binary exponential backoff mechanism chooses a random number which represents the amount of time that must elapse while there are not any transmission. In other words, the medium is idle before the listening station may attempt to begin its transmission again. The MAC may also implement a network allocation vector (NAV). The NAV is the value that indicates to a station that amount of time that remains before a medium becomes available. The NAV is kept current through duration values that are transmitted in all frames. By examining the NAV, a station may avoid transmitting, even when the medium does not appear to be carrying a transmission in the physical sense.

The centrally controlled access mechanism uses a poll and response protocol to eliminate the possibility of contention for the medium. This access mechanism is called the point coordination function (PCF). A point coordinator (PC) controls the PCF. The PC is always located in an AP. Generally, the PCF operates by stations requesting that the PC register them on a polling list, and the PC then regularly polls the stations for traffic while also delivering traffic to the stations. With proper planning, the PCF is able to deliver near isochronous service to the stations on the polling list.

The third function of the MAC is to protect the data that it delivers. Because it is difficult to contain wireless WLAN signals to a particular physical area, the MAC provides a privacy service, called Wired Equivalent Privacy (WEP), which encrypts the data sent over the wireless medium. The level of encryption chosen approximates the level of protection data might have on a wireless LAN in a building with controlled access that prevents physically connecting to the LAN without authorization.

### 5.0 802.11 Physical Layer Configurations

The 802.11 WLAN standard specifies two RF physical layers: frequency hopped spread spectrum (FHSS) and direct sequence spread spectrum (DSSS). The invention is not limited to these specific examples. Both DSSS and FHSS support 1 Mbps and 2 Mbps data rates and operate in the 2.400-2.835 GHz band for wireless communications in accordance to FCC part 15 and ETSI-300 rules. Additionally, 802.11 has added an 11 Mbps standard that operates at 5 GHz and utilizes OFDM modulation.

The DSSS configuration supports the 1 MBPS data rate utilizing differential binary phase shift keying (DBPSK) modulation, and supports 2 MBPS utilizing differential quadrature phase shift keying modulation. In embodiments, an 11-bit Barker word is used as the spreading sequence that is utilized by the stations in the 802.11 network. A Barker word has a relatively short sequence, and is known to have very good correlation properties, and includes the following sequence: +1, -1, +1, +1, -1, +1, +1, +1, -1, -1, -1. The Barker word used for 802.11 is not to be confused with the spreading codes used for code division multiple access (CDMA) and global positioning system (GPS). CDMA and GPS use orthogonal spreading codes, which allow multiple users to operate on the same channel frequency. Generally, CDMA codes have longer sequences and have richer correlation properties.

During transmission, the 11-bit barker word is exclusive-ored (EX-OR) with each of the information bits using a modulo-2 adder, as illustrated by modulo-2 adder 9202 in FIG. 66. Referring to FIG. 66, the 11-bit (at 11 MBPS) Barker word is applied to a modulo-2 adder together with each one (at 1 MBPS) of the information bits (in the PPDU data). The Ex-OR function combines both signals by performing a modulo-2 addition of each information bit with each Barker bit (or chip). The output of the modulo-2 adder results in a signal with a data rate that is 10x higher than the information rate. The result in the frequency domain signal is a signal that is spread over a wider bandwidth at a reduced RF power level. At the receiver, the DSSS signal is convolved with an 11-bit Barker word and correlated. As shown in FIG. 66, the correlation recovers the information bits at the transmitted information rate, and the undesired interfering in-band signals are spread out-of-band. The spreading and despreading of narrowband to wideband signal is commonly referred to as processing gain and is measured in decibels (dB). Processing gain is the ratio of DSSS signal rate information rate. The minimum requirement for processing gain is 10 dB.

The second RF physical layer that is specified by the IEEE 802.11 standard is frequency hopping spread spectrum (FHSS). A set of hop sequences is defined in IEEE 802.11 for use in the 2.4 GHz frequency band. The channels are evenly spaced across the band over a span of 83.5 MHz. During the development of IEEE 802.11, the hop sequences listed in the standard were pre-approved for operation in North America, Europe, and Japan. In North America and Europe (excluding Spain and France), the required number of hop channels is 79. The number of hopped channels for Spain and France is 23 and 35, respectively. In Japan, the required number of hopped channels is 23. The hopped center channels are spaced uniformly across the 2.4 GHz frequency band occupying a bandwidth of 1MHz. In North America and Europe (excluding Spain and France), the hopped channels operate from 2.402 GHz to 2.480 GHz. In Japan, the hopped channels operate from 2.447 GHz to 2.473 GHz. The modulation scheme called out for FHSS by 802.11 is 2-level Gaussian Phase Shift Keying (GFSK) for the 1 MBps data rate, and 4-level GFSK for the 2 MBps data rate.

In addition to DSSS and FHSS RF layer standards, the IEEE 802.11 Executive Committee approved two projects for higher rate physical layer extensions. The first extension, IEEE 802.11a defines requirements for a physical layer operating in the 5.0 GHz frequency band, and data rates ranging from 6 MBps to 54 MBps. This 802.11a draft standard is based on Orthogonal Frequency Division Multiplexing (OFDM) and uses 48 carriers as a phase reference (so coherent), with 20 MHZ spacing between the channels. The second extension, IEEE 802.11b, defines a set of physical layer specifications operating in the 2.4 GHz ISM frequency band. This 802.11b utilizes complementary code keying (CCK), and extends the data rate up to 5.5 Mbps and 11 Mbps.

The transmitter and receiver circuits described herein can be operated in all of the WLAN physical layer embodiments described herein, including the DSSS and FHSS embodiments described herein. However, the present invention is not limited to being operated in WLAN physical layer embodiments that were described herein, as the invention could be configured in other physical layer embodiments.

Figure 68 illustrates a block diagram of an IEEE 802.11 DSSS radio transceiver 9400 using UFT Zero IF technology. DSSS transceiver 9400 includes: antenna 3903, switch 9404, amplifiers 9406 and 9408, transceivers 9410, baseband processor 9412, MAC 3918, bus interface unit 9416, and PCMCIA connector 9418. The DSSS transceiver 9400 includes an IQ receiver 3906 and an IQ transmitter 3910, which are described herein. UFT technology interfaces directly to the baseband processor 9412 of the physical layer. In the receive path, the IQ receiver 3906 transforms a 2.4GHz RF signal-of-interest into I/Q analog baseband signals in a single step and passes the signals to the baseband processor 9412, where the baseband processor is then responsible for de-spreading and demodulating the signal. Preferably, the IQ receiver 3906 includes all of the circuitry necessary for accommodating AGC, baseband filtering and baseband amplification. In the transmit path, the transmitter 3910 transforms the I/Q analog baseband signals to a 2.4GHz RF carrier directly in a single step. The signal conversion clock is derived from a single synthesized local oscillator (LO) 9420. The selection of the clock frequency is determined by choosing a sub-harmonic of the carrier frequency. For example, a 5th harmonic of 490 MHZ was used, which corresponds to a RF channel frequency of 2.450GHz. Using UFT technology simplifies the requirements and complexity of the synthesizer design.

## 6. Conclusions

Example implementations of the systems and components of the invention have been described herein. As noted elsewhere, these example implementations have been described for illustrative purposes only, and are not limiting. Other implementation examples are possible, such as software and software/hardware implementations of the systems and components of the invention. Such implementation will be apparent to persons skilled in the relevant art (s) based on the teachings contained herein.

While various application embodiments of the present invention have been described above, it should be understood that they have been presented by way of example only, and not limitation. Thus, the breadth and scope of the present invention should not be limited by any of the above-described exemplary embodiments, but should be defined only in accordance with the following claims.

## Claims

1. A wireless modem apparatus (3902), comprising:

    a spreader (5206) for spreading a baseband signal (3930, 3932) using a spreading code;
    a balanced transmitter (3910), coupled to said spreader, for up-converting said spread baseband signal (3942, 3944), including,
        an inverter (7112), to receive said baseband signal and generate an inverted baseband signal (7116);
        a first controlled switch (7148A), coupled to a non-inverting output (7114) of said inverter, said first controlled switch (7148A) to sample said baseband signal (3942, 3944) according to a first control signal (7123), resulting in a first harmonically rich signal (7130);
        a second controlled switch (7148B), coupled to an inverting output of said inverter (7112), said second controlled switch (7148B) to sample said inverted baseband signal (7116) according to a second control signal (7127), resulting in a second harmonically rich signal (7134); and
        a summing node (7132), coupled to an output of said first controlled switch (7148A) and an output of said second controlled switch (7148B), said summing node (7132) to combine said first harmonically rich signal (7130) and said second harmonically rich signal (7134), resulting in a third harmonically rich signal (7133).

2. The apparatus of claim 1, wherein said second control signal (7127) is phase shifted with respect to said first control signal (7123).

3. The apparatus of claim 1, wherein said second control signal (7127) is phase shifted by 180 degrees with respect to said first control signal (7123).

4. The apparatus of any preceding claim, further comprising a filter (308) attached to an output of said summing node, wherein said filter selects a desired harmonic from said third harmonically rich signal.

5. The apparatus of any preceding claim, further comprising:

    a balanced receiver (3906), coupled to said balanced transmitter (3910), said receiver (3906) including,
        a first universal frequency down-conversion module (114A-1) to down-convert an input signal (3924), wherein said first universal frequency down-conversion module (114A-1) down-converts said input signal (3924) according to a third control signal (7090) and outputs a first down-converted signal (7007);
        a second universal frequency down-conversion module (114A-2) to down-convert said input signal (3924), wherein said second universal frequency down-conversion module (114A-2) down-converts said input signal (3924) according to a fourth control signal (7092) and outputs a second down-converted signal (7009); and
        a subtractor module (7020) that subtracts said second down-converted signal (7009) from said first down-converted signal (7007) and outputs a down-converted signal (3926).

6. The apparatus of claim 5, wherein said fourth control signal (7092) is delayed relative to said third control signal (7090) by one quarter cycle.

7. The apparatus of claim 5 or 6, wherein said first universal frequency down-conversion module (114A-1) under-samples said input signal (3924) according to said third control signal (7090), and said second universal frequency down-conversion module (114A-2) under-samples said input signal (3924) according to said fourth control signal (7092).

8. The apparatus of any one of claims 5 to 7, wherein said third (7090) and said fourth (7092) control signals each comprise a train of pulses.

9. The apparatus of claim 8, wherein said train of pulses have a pulse width that is approximately a fraction of a period of said input signal (3924).

10. The apparatus of claim 8, wherein said train of pulses have a pulse width that is approximately multiple periods and a fraction of a period of said input signal (3924).

11. The apparatus of any one of claims 8 to 10, wherein said first (114A-1) and said second (114A-2) universal frequency down-conversion modules each comprise a switch (7099A) and a storage element (7024, 7036).

12. The apparatus of claim 11, wherein said storage element (7024, 7036) comprises a capacitor (7074, 7076) that reduces a DC offset voltage in said first down-converted signal (7007) and said second down-converted signal (7009).

13. The apparatus of any one of claims 5 to 12, wherein said subtractor module (7020) comprises a differential amplifier.

14. The apparatus of any one of claims 5 to 13, further comprising an antenna (3903) coupled to said balanced transmitter (3910) and said balanced receiver (3906).

15. The apparatus of claim 14, further comprising a switch (9302), said switch (9302) connecting either said transmitter (3910) or said receiver (3906) to said antenna (3903).

16. The apparatus of any one of claims 5 to 15, further comprising a baseband processor (9412) coupled to said transmitter (3910) and said receiver (3906).

17. The apparatus of any one of claims 5 to 16, further comprising a media access controller (MAC) (3918) coupled to said transmitter (3910) and said receiver (3906).

18. The apparatus of claim 17, wherein said MAC (3918) comprises a means for controlling access to a WLAN medium (3914).

19. The apparatus of claim 18, wherein said means for controlling (3914) includes carrier sense multiple access with collision avoidance (CSMA/CA).

20. The apparatus of any one of claims 5 to 19, further comprising a demodulator/modulator facilitation module (3912) coupled to said transmitter (3910) and receiver (3906).

21. The apparatus of claim 20, wherein said demodulator/modulator facilitation module (3912) comprises a means for modulating (5212) said baseband signal (3942, 3944) using differential binary phase shift keying (DBPSK).

22. The apparatus of claim 20 or claim 21, wherein said demodulator/modulator facilitation module (3912) comprises a means for de-modulating (5210) said down-converted signal (3926) using differential binary phase shift keying (DBPSK).

23. The apparatus of any preceding claim, wherein said spreader(5206) comprises a means for spreading said baseband signal (3942, 3944) using a Barker code.

24. The apparatus of claim 20, wherein said demodulator/modulator facilitation module (3912) comprises a means for de-spreading (5204) said down-converted signal (3926).

**25.** The apparatus of claim 24, wherein said means for de-spreading (5204) comprises a means for de-spreading said down-converted signal using a Barker code.

**26.** The apparatus of any preceding claim, wherein said apparatus is an infrastructure device.

**27.** The apparatus of any one of claims 1 to 25, wherein said apparatus is a client device.

**28.** The apparatus of any preceding claim, wherein said first controlled switch (7918) shunts said baseband signal (7114, 3942, 3944) to a reference potential (7920) according to said first control signal (7123), and wherein said second controlled switch (7924) shunts said inverted baseband signal (7116) to said reference potential (7920) according to said second control signal (7127).

**29.** A method of transmitting a baseband signal over a wireless LAN, comprising the steps of:

(1) spreading the baseband signal (3930b, 3932b) using a spreading code, resulting in a spread baseband signal (3942, 3944); and
(2) differentially sampling the spread baseband signal (3942, 3944) according to a first control signal (7123) and a second control signal (7127) resulting in a plurality of harmonic images that are each representative of the baseband signal (3930b, 3932b).

**30.** The method of claim 29, further comprising the step of:

modulating the baseband signal (3930b, 3932b) using phase shift keying prior to step (1).

**31.** The method of claim 29 or 30, further comprising the steps of:

(3) determining availability of a WLAN medium; and
(4) transmitting a desired harmonic from said plurality of harmonic images over said WLAN medium if said medium is available.

**32.** The method of claim 31, wherein step (3) comprises the step of determining availability of said WLAN medium using carrier sense multiple access (CSMA) protocol.

**33.** The method of any one of claims 29 to 32, wherein said step (2) comprises the step of:

(a) converting said baseband signal (3942, 3944) into a differential baseband signal having a first differential baseband component (7114) and a second differential baseband component (7116);
(b) sampling said first differential component (7114) according to said first control signal (7123) to generate a first harmonically rich signal (7130), and sampling said second differential component (7116) according to said second control signal (7127) to generate a second harmonically rich signal (7130), wherein said second control signal (7127) is phase shifted relative to said first control signal (7123); and
(c) combining said first harmonically rich signal (7130) and said second harmonically rich signal (7130) to generate said harmonic images.

**34.** The method of any one of claims 29 to 33, further comprising the step of:

minimizing DC offset voltages between sampling modules during step (2), and thereby minimizing carrier insertion in said harmonic images.

**Patentansprüche**

**1.** Drahtlose Modemvorrichtung (3902), die aufweist:

eine Spreizvorrichtung (5206) zum Spreizen eines Basisbandsignals (3930, 3932) unter Verwendung eines Spreizcodes;
einen mit der Spreizvorrichtung verbundenen symmetrischen Sender (3910) zum Aufwärtswandeln des gespreizten Basisbandsignals (3942, 3944), der umfaßt:

einen Inverter (7112) zum Empfangen des Basisbandsignals und Erzeugen eines invertierten Basisbandsignals (7116);

einen ersten gesteuerten Schalter (7148A), der mit einem nichtinvertierenden Ausgang (7114) des Inverters verbunden ist, wobei der erste gesteuerte Schalter (7148A) entsprechend einem ersten Steuersignal (7123) das Basisbandsignal (3942, 3944) abtastet, was ein erstes Signal (7130) mit vielen Harmonischen ergibt;

einen zweiten gesteuerten Schalter (7148B), der mit einem invertierenden Ausgang des Inverters (7112) verbunden ist, wobei der zweite gesteuerte Schalter (7148B) entsprechend einem zweiten Steuersignal (7127) das invertierte Basisbandsignal (7116) abtastet, was ein zweites Signal (7134) mit vielen Harmonischen ergibt;

einen Summierknoten (7132), der mit einem Ausgang des ersten gesteuerten Schalters (7148A) und einem Ausgang des zweiten gesteuerten Schalters (7148B) verbunden ist, wobei der Summierknoten (7132) das erste Signal (7130) mit vielen Harmonischen und das zweite Signal (7134) mit vielen Harmonischen kombiniert, was ein drittes Signal (7133) mit vielen Harmonischen ergibt.

2. Vorrichtung nach Anspruch 1, wobei das zweite Steuersignal (7127) relativ zu dem ersten Steuersignal (7123) phasenverschoben ist.

3. Vorrichtung nach Anspruch 1, wobei das zweite Steuersignal (7127) relativ zu dem ersten Steuersignal (7123) um 180 Grad phasenverschoben ist.

4. Vorrichtung nach einem der vorhergehenden Ansprüche, die ferner ein Filter (308) aufweist, das an einem Ausgang des Summierknotens angebracht ist, wobei dieses Filter eine gewünschte Harmonische aus dem dritten Signal mit vielen Harmonischen auswählt.

5. Vorrichtung nach einem der vorhergehenden Ansprüche, die ferner aufweist:

einen mit dem symmetrischen Sender (3910) verbundenen symmetrischen Empfänger (3906), wobei dieser Empfänger (3906) aufweist:

ein erstes universelles Frequenzabwärtswandelmodul (114A-1) zum Abwärtswandeln eines Eingangssignals (3924), wobei das erste universelle Frequenzabwärtswandelmodul (114A-1) dieses Eingangssignal (3924) entsprechend einem dritten Steuersignal (7090) abwärtswandelt und ein erstes abwärtsgewandeltes Signal (7007) ausgibt;

ein zweites universelles Frequenzabwärtswandelmodul (114A-2) zum Abwärtswandeln des Eingangssignals (3924), wobei das zweite universelle Frequenzabwärtswandelhmodul (114A-2) dieses Eingangssignal (3924) entsprechend einem vierten Steuersignal (7092) abwärtswandelt und ein zweites abwärtsgewandeltes Signal (7009) ausgibt; und

ein Subtrahiermodul (7020), welches das zweite abwärtsgewandelte Signal (7009) von dem ersten abwärtsgewandelten Signal (7007) subtrahiert und ein abwärtsgewandeltes Signal (3926) ausgibt.

6. Vorrichtung nach Anspruch 5, wobei das vierte Steuersignal (7092) relativ zu dem dritten Steuersignal (7090) um eine viertel Periode verzögert ist.

7. Vorrichtung nach Anspruch 5 oder 6, wobei das erste universelle Frequenzabwärtswandelmodul (114A-1) das Eingangssignal (3924) entsprechend dem dritten. Steuersignal (7090) unterabtastet und das zweite universelle Frequenzabwärtswandelmodul (114A-2) das Eingangssignal (3924) entsprechend dem vierten Steuersignal (7092) unterabtastet.

8. Vorrichtung nach einem der Ansprüche 5 bis 7, wobei das dritte (7090) und das vierte (7092) Steuersignal jeweils einen Impulszug aufweisen.

9. Vorrichtung nach Anspruch 8, wobei die Impulszüge eine Impulsbreite haben, die ungefähr ein Bruchteil einer Periode des Eingangssignals (3924) ist.

10. Vorrichtung nach Anspruch 8, wobei die Impulszüge eine Impulsbreite haben, die ungefähr mehrere Perioden und ein Bruchteil einer Periode des Eingangssignals (3924) ist.

11. Vorrichtung nach einem der Ansprüche 8 bis 10, wobei das erste (114A-1) und das zweite (114A-2) universelle Frequenzabwärtswandlemodul jeweils einen Schalter (7099A) und ein Speicherelement (7024, 7036) aufweisen.

12. Vorrichtung nach Anspruch 11, wobei das Speicherelement (7024, 7036) einen Kondensator (7074, 7076) aufweist, der eine Gegengleichspannung in dem ersten abwärtsgewandelten Signal (7007) und dem zweiten abwärtsgewandelten Signal (7009) verringert.

13. Vorrichtung nach einem der Ansprüche 5 bis 12, wobei das Subtrahiermodul (7020) einen Differenzverstärker aufweist.

14. Vorrichtung nach einem der Ansprüche 5 bis 13, die ferner einen Antenne (3903) aufweist, die mit dem symmetrischen Sender (3910) und dem symmetrischen Empfänger (3906) verbunden ist.

15. Vorrichtung nach Anspruch 14, die ferner einen Schalter (9302) aufweist, wobei dieser Schalter (9302) entweder den Sender (3910) oder den Empfänger (3906) mit der Antenne (3903) verbindet.

16. Vorrichtung nach einem der Ansprüche 5 bis 15, die ferner einen Basisbandprozessor (9412) aufweist, der mit dem Sender (3910) und dem Empfänger (3906) verbunden ist.

17. Vorrichtung nach einem der Ansprüche 5 bis 16, die ferner eine Medienzugriffssteuerung (Medium Access Controller - MAC) (3918) aufweist, die mit dem Sender (3910) und dem Empfänger (3906) verbunden ist.

18. Vorrichtung nach Anspruch 17, wobei die MAC (3918) eine Einrichtung zur Steuerung des Zugriffs auf ein WLAN-Medium (3914) aufweist.

19. Vorrichtung nach Anspruch 18, wobei die Steuerungseinrichtung (3914) Vielfachzugriff mit Leitungsabfrage und Kollisionsvermeidung aufweist (CSMA/CA).

20. Vorrichtung nach einem der Ansprüche 5 bis 19, die ferner ein Demodulations-/Modulationserleichterungsmodul (3912) aufweist, das mit dem Sender (3910) und dem Empfänger (3906) verbunden ist.

21. Vorrichtung nach Anspruch 20, wobei das Demodulations-/Modulationserleichterungsmodul (3912) eine Einrichtung zum Modulieren (5212) des Basisbandsignals (3942, 3944) unter Verwendung differentieller binärer Phasenumtastung (DBPSK) hat.

22. Vorrichtung nach Anspruch 20 oder 21, wobei das Demodulations-/Modulationserleichterungsmodul (3912) eine Einrichtung zum Demodulieren (5210) des abwärtsgewandelten Signals (3926) unter Verwendung differentieller binärer Phasenumtastung (DBPSK)aufweist.

23. Vorrichtung nach einem der vorhergehenden Ansprüche, wobei die Spreizvorrichtung (5206) eine Einrichtung zum Spreizen des Basisbandsignals (3942, 3944) unter Verwendung eines Barker-Codes aufweist.

24. Vorrichtung nach Anspruch 20, wobei das Demodulations-/Modulationserleichterungsmodul (3912) eine Einrichtung zum Entspreizen (5204) des abwärtsgewandelten Signals (3926) aufweist.

25. Vorrichtung nach Anspruch 24, wobei die Einrichtung zum Entspreizen (5204) eine Einrichtung zum Entspreizen des abwärtsgewandelten Signals unter Verwendung eines Barker-Codes aufweist.

26. Vorrichtung nach einem der vorhergehenden Ansprüche, wobei die Vorrichtung eine Infrastrukturvorrichtung ist.

27. Vorrichtung nach einem der Ansprüche 1 bis 25, wobei die Vorrichtung eine Client-Vorrichtung ist.

28. Vorrichtung nach einem der vorhergehenden Ansprüche, wobei der erste gesteuerte Schalter (7918) das Basisbandsignal (7114, 3942, 3944) entsprechend einem ersten Steuersignal (7123) parallel zu einem Referenzpotential (7920) schaltet und wobei der zweite gesteuerte Schalter (7924) das invertierte Basisbandsignal (7116) entsprechend dem zweiten Steuersignal (7127) parallel zu dem Referenzpotential (7920) schaltet.

29. Verfahren zum Senden eines Basisbandsignals über ein drahtloses LAN, das die folgenden Schritte aufweist:

(1) Spreizen des Basisbandsignals (3930b, 3932b) unter Verwendung eines Spreizcodes, was ein gespreiztes Basisbandsignal (3942, 3944) ergibt; und
(2) differentielles Abtasten des gespreizten Basisbandsignals (3942, 3944) entsprechend einem ersten Steuersignal (7123) und einem zweiten Steuersignal (7127), was mehrere harmonische Bilder ergibt, die jeweils das Basisbandsignal (3930b, 3932b) darstellen.

**30.** Verfahren nach Anspruch 29, das ferner die folgenden Schritte aufweist:

Modulieren des Basisbandsignals (3930b, 3932b) unter Verwendung von Phasenumtastung vor dem Schritt (1).

**31.** Verfahren nach Anspruch 29 oder 30, das ferner die folgenden Schritte aufweist:

(3) Bestimmen der Verfügbarkeit eines WLAN-Mediums; und
(4) Senden einer gewünschten Harmonischen von den mehreren harmonischen Bildern über das WLAN-MEdium, wenn das Medium verfügbar ist.

**32.** Verfahren nach Anspruch 31, wobei Schritt (3) den Schritt zur Bestimmung der Verfügbarkeit des WLAN-Mediums unter Verwendung des Protokolls für Vielfachzugriff mit Leitungsüberwachung (CSMA) aufweist.

**33.** Verfahren nach einem der Ansprüche 29 bis 32, wobei der Schritt (2) die folgenden Schritte aufweist:

(a) Umwandeln des Basisbandsignals (3942, 3944) in ein differentielles Basisbandsignal mit einer ersten differentiellen Basisbandkomponente (7114) und einer zweiten differentiellen Basisbandkomponente (7116);
(b) Abtasten der ersten differentiellen Komponente (7114) entsprechend dem ersten Steuersignal (7123), um ein erstes Signal (7130) mit vielen Harmonischen zu erzeugen, und Abtasten der zweiten differentiellen Komponente (7116) entsprechend dem zweiten Steuersignal (7127), um ein zweites Signal (7130) mit vielen Harmonischen zu erzeugen, wobei das zweite Steuersignal (7127) relativ zu dem ersten Steuersignal (7123) phasenverschoben ist; und
(c) Kombinieren des ersten Signals (7130) mit vielen Harmonischen und des zweiten Signals (7130) mit vielen Harmonischen, um die harmonischen Bilder zu erzeugen.

**34.** Verfahren nach einem der Ansprüche 29 bis 33, das ferner den folgenden Schritt aufweist:

Minimieren von Gegengleichspannungen zwischen Abtastmodulen während des Schritts (2) und dadurch Minimieren der Trägereinfügung in diesen harmonischen Bildern.

## Revendications

**1.** Modem sans fil (3902), comprenant :

un étaleur (5206) pour étaler un signal de bande de base (3930, 3932) en utilisant un code d'étalement ;
un émetteur équilibré (3910), couplé audit étaleur, pour augmenter la fréquence dudit signal de bande de base (3942, 3944), comportant :

un inverseur (7112), pour recevoir ledit signal de bande de base et produire un signal de bande de base inversé (7116) ;
un premier interrupteur commandé (7148A), couplé à une sortie non inverseuse (7114) dudit inverseur, ledit premier interrupteur commandé (7148A) servant à échantillonner ledit signal de bande de base (3942, 3944) selon un premier signal de commande (7123) pour obtenir un premier signal harmoniquement riche (7130) ;
un deuxième interrupteur commandé (7148B), couplé à une sortie inverseuse dudit inverseur (7112), ledit deuxième interrupteur commandé (7148B) servant à échantillonner ledit signal de bande de base inversé (7116) selon un deuxième signal de commande (7127), pour obtenir un deuxième signal harmoniquement riche (7134) ; et
un noeud de sommation (7132), couplé à une sortie dudit premier interrupteur commandé (7148A) et à une sortie dudit deuxième interrupteur commandé (7148B), ledit noeud de sommation (7132) servant à combiner ledit premier signal harmoniquement riche (7130) et ledit deuxième signal harmoniquement riche (7134) pour donner un troisième signal harmoniquement riche (7133).

2. Modem selon la revendication 1, dans lequel ledit deuxième signal de commande (7127) est déphasé par rapport audit premier signal de commande (7123).

3. Modem selon la revendication 1, dans lequel ledit deuxième signal de commande (7127) est déphasé de 180 degrés par rapport audit premier signal de commande (7123).

4. Modem selon l'une quelconque des revendications précédentes, comprenant en outre un filtre (308) relié à une sortie dudit noeud de sommation, ledit filtre choisissant un harmonique voulu dans ledit troisième signal harmoniquement riche.

5. Modem selon l'une quelconque des revendications précédentes, comprenant en outre :

un récepteur équilibré (3906) couplé audit émetteur équilibré (3910), ledit récepteur (3906) comportant :

un premier module d'abaissement de fréquence universel (114A-1) pour abaisser la fréquence d'un signal d'entrée (3924), ledit premier module d'abaissement de fréquence universel (114A-1) abaissant la fréquence dudit signal d'entrée (3924) selon un troisième signal de commande (7090) et délivrant en sortie un premier signal abaissé en fréquence (7007) ;
un deuxième module d'abaissement de fréquence universel (114A-2) pour abaisser la fréquence dudit signal d'entrée (3924), ledit deuxième module d'abaissement de fréquence universel (114A-2) abaissant la fréquence dudit signal d'entrée (3924) selon un quatrième signal de commande (7092) et délivrant en sortie un deuxième signal abaissé en fréquence (7009) ; et
un module soustracteur (7020) qui soustrait ledit deuxième signal abaissé en fréquence (7009) dudit premier signal abaissé en fréquence (7007) et délivre en sortie un signal abaissé en fréquence (3926).

6. Modem selon la revendication 5, dans lequel ledit quatrième signal de commande (7092) est retardé par rapport audit troisième signal de commande (7090) d'un quart de cycle.

7. Modem selon la revendication 5 ou 6, dans lequel ledit premier module d'abaissement de fréquence universel (114A-1) sous-échantillonne ledit signal d'entrée (3924) selon ledit troisième signal de commande (7090), et ledit deuxième module d'abaissement de fréquence universel (114A-2) sous-échantillonne ledit signal d'entrée (3924) selon ledit quatrième signal de commande (7092).

8. Modem selon l'une quelconque des revendications 5 à 7, dans lequel lesdits troisième (7090) et quatrième (7092) signaux de commande comprennent chacun un train d'impulsions.

9. Modem selon la revendication 8, dans lequel lesdits trains d'impulsions ont une largeur d'impulsion qui est à peu près une fraction d'une période dudit signal d'entrée (3924).

10. Modem selon la revendication 8, dans lequel lesdits trains d'impulsions ont une largeur d'impulsion qui vaut à peu près plusieurs périodes et une fraction de période dudit signal d'entrée (3924).

11. Modem selon l'une quelconque des revendications 8 à 10, dans lequel lesdits premier (114A-1) et deuxième (114A-2) modules d'abaissement de fréquence universels comprennent chacun un interrupteur (7099A) et un élément de stockage (7024, 7036).

12. Modem selon la revendication 11, dans lequel ledit élément de stockage (7024, 7036) comprend un condensateur (7074, 7076) qui réduit une tension de décalage du niveau continu dudit premier signal abaissé en fréquence (7007) et dudit deuxième signal abaissé en fréquence (7009).

13. Modem selon l'une quelconque des revendications 5 à 12, dans lequel ledit module soustracteur (7020) comprend un amplificateur différentiel.

14. Modem selon l'une quelconque des revendications 5 à 13, comprenant en outre une antenne (3903) couplée audit émetteur équilibré (3910) et audit récepteur équilibré (3906).

**15.** Modem selon la revendication 14, comprenant en outre un interrupteur (9302), ledit interrupteur (9302) connectant soit ledit émetteur (3910) soit ledit récepteur (3906) à ladite antenne (3903).

**16.** Modem selon l'une quelconque des revendications 5 à 15, comprenant en outre un processeur de bande de base (9412) couplé audit émetteur (3910) et audit récepteur (3906).

**17.** Modem selon l'une quelconque des revendications 5 à 16, comprenant en outre un dispositif de contrôle d'accès au support (MAC) (3918) couplé audit émetteur (3910) et audit récepteur (3906).

**18.** Modem selon la revendication 17, dans lequel ledit dispositif MAC (3918) comprend un moyen servant à contrôler l'accès à un support WLAN (3914).

**19.** Modem selon la revendication 18, dans lequel ledit moyen de contrôle (3914) met en oeuvre l'accès multiple avec écoute de porteuse et évitement de collision (CSMA-CA).

**20.** Modem selon l'une quelconque des revendications 5 à 19, comprenant en outre un module de facilitation démodulateur-modulateur (3912) couplé audit émetteur (3910) et audit récepteur (3906).

**21.** Modem selon la revendication 20, dans lequel ledit module de facilitation démodulateur-modulateur (3912) comprend un moyen servant à moduler (5212) ledit signal de bande de base (3942, 3944) en utilisant la modulation par déplacement de phase binaire différentielle (DBPSK).

**22.** Modem selon la revendication 20 ou 21, dans lequel ledit module de facilitation démodulateur-modulateur (3912) comprend un moyen servant à démoduler (5210) ledit signal abaissé en fréquence (3926) en utilisant la modulation par déplacement de phase binaire différentielle (DBPSK).

**23.** Modem selon l'une quelconque des revendications précédentes, dans lequel ledit étaleur (5206) comprend un moyen servant à étaler ledit signal de bande de base (3942, 3944) en utilisant un code de Barker.

**24.** Modem selon la revendication 20, dans lequel ledit module de facilitation démodulateur-modulateur (3912) comprend un moyen servant à désétaler (5204) ledit signal abaissé en fréquence (3926).

**25.** Modem selon la revendication 24, dans lequel ledit moyen servant à désétaler (5204) comprend un moyen servant à désétaler ledit signal abaissé en fréquence en utilisant un code de Barker.

**26.** Modem selon l'une quelconque des revendications précédentes, dans lequel ledit modem est un dispositif d'infrastructure.

**27.** Modem selon l'une quelconque des revendications 1 à 25, dans lequel ledit modem est un dispositif de client.

**28.** Modem selon l'une quelconque des revendications précédentes, dans lequel ledit premier interrupteur commandé (7918) shunte ledit signal de bande de base (7114, 3942, 3944) vers un potentiel de référence (7920) selon ledit premier signal de commande (7123), et dans lequel ledit deuxième interrupteur commandé (7924) shunte ledit signal de bande de base inversé (7116) vers ledit potentiel de référence (7920) selon ledit deuxième signal de commande (7127).

**29.** Procédé de transmission d'un signal de bande de base sur un réseau local sans fil, comprenant les étapes consistant à :

(1) étaler le signal de bande de base (3930b, 3932b) en utilisant un code d'étalement, pour obtenir un signal de bande de base étalé (3942, 3944) ; et
(2) échantillonner de façon différentielle le signal de bande de base étalé (3942, 3944) selon un premier signal de commande (7123) et un deuxième signal de commande (7127) pour obtenir une pluralité d'images harmoniques qui sont toutes représentatives du signal de bande de base (3930b, 3932b).

**30.** Procédé selon la revendication 29, comprenant en outre l'étape consistant à moduler le signal de bande de base (3930b, 3932b) en utilisant la modulation par déplacement de phase avant l'étape (1).

**31.** Procédé selon la revendication 29 ou 30, comprenant en outre les étapes consistant à :

(3) déterminer la disponibilité d'un support WLAN ; et
(4) transmettre un harmonique voulu parmi ladite pluralité d'images harmoniques par ledit support WLAN si ledit support est disponible.

**32.** Procédé selon la revendication 31, dans lequel l'étape (3) comprend l'étape consistant à déterminer la disponibilité dudit support WLAN en utilisant le protocole d'accès multiple avec écoute de porteuse (CSMA).

**33.** Procédé selon l'une quelconque des revendications 29 à 32, dans lequel ladite étape (2) comprend les étapes consistant à :

(a) convertir ledit signal de bande de base (3942, 3944) en un signal de bande de base différentiel ayant une première composante de bande de base différentielle (7114) et une deuxième composante de bande de base différentielle (7116) ;
(b) échantillonner ladite première composante différentielle (7114) selon ledit premier signal de commande (7123) pour produire un premier signal harmoniquement riche (7130), et échantillonner ladite deuxième composante différentielle (7116) selon ledit deuxième signal de commande (7127) pour produire un deuxième signal harmoniquement riche (7130), ledit deuxième signal de commande (7127) étant déphasé par rapport audit premier signal de commande (7123) ; et
(c) combiner ledit premier signal harmoniquement riche (7130) et ledit deuxième signal harmoniquement riche (7134) pour produire lesdites images harmoniques.

**34.** Procédé selon l'une quelconque des revendications 29 à 33, comprenant en outre l'étape consistant à minimiser les tensions de décalage du niveau continu entre les modules d'échantillonnage au cours de l'étape (2), et minimiser ainsi l'insertion de porteuse dans lesdites images harmoniques.

102

UNIVERSAL FREQUENCY
TRANSLATION (UFT)
MODULE

PORT 1 ○     ○ PORT 2

PORT 3

CONTROL
SIGNAL

FIG.1A

UNIVERSAL FREQUENCY
TRANSLATION (UFT)
MODULE 102

106

PORT 1 ○     ○ PORT 2

PORT 3

CONTROL SIGNAL 108

FIG.1B

EP 1 206 831 B1

UNIVERSAL FREQUENCY
DOWN-CONVERSION
(UFD) MODULE 114

102

PORT 1 — UFT MODULE — PORT 2

PORT 3

CONTROL
SIGNAL

FIG.1C

UNIVERSAL FREQUENCY
UP-CONVERSION
(UFU) MODULE 116

102

PORT 1 — UFT MODULE — PORT 2

PORT 3

CONTROL
SIGNAL

FIG.1D

UNIVERSAL FREQUENCY
TRANSLATION (UFT)
102

PORT 1

204

PORT 2/3

CONTROL
SIGNAL

PORT 3

206

FIG.2A

102

PORT 1

PORT 2

S    D

210

G

PORT 2

CONTROL
SIGNAL

FIG.2B

UNIVERSAL FREQUENCY UP-CONVERSION (UFU) MODULE 116

CONTROL SIGNAL 302 → SWITCH MODULE 304 → HARMONICALLY RICH SIGNAL 306 → FILTER 308 → OUTPUT SIGNAL 310

FIG.3

UNIVERSAL FREQUENCY UP-CONVERSION (UFU) MODULE 116

UNSHAPED INPUT SIGNAL 501 → PULSE SHAPING MODULE (OPTIONAL) 502 → CONTROL SIGNAL 302 → SWITCH MODULE 304 → 306 → FILTER 308 → OUTPUT SIGNAL 310

FIG.5

UNIVERSAL FREQUENCY UP-CONVERSION (UFU) MODULE 116

SWITCH MODULE 304

BIAS SIGNAL 402

404

PORT 1 405

SWITCH 406

PORT 2 408

UFT 102

CONTROL SIGNAL PORT 3 302

306

FILTER 308

412

410

410

OUTPUT SIGNAL 310

FIG.4

40

FIG.6A

FIG.6B

FIG.6C

FIG.6D

INFORMATION
SIGNAL 602

OSCILLATING
SIGNAL 604

FREQUENCY MODULATED
INPUT SIGNAL 606

HARMONICALLY
RICH SIGNAL
(SHOWN AS SQUARE
WAVE) 608

SEE FIG.6E

EXPANDED VIEW OF
HARMONICALLY RICH
SIGNAL 608

610
SEE FIG.6F

612
SEE FIG.6G

FIG.6E

HARMONICS OF
SIGNAL 610
(SHOWN SEPARATELY)

FUNDAMENTAL
FREQUENCY
610A

THIRD HARMONIC
610B

FIFTH HARMONIC
610C

FIG.6F

HARMONICS OF
SIGNAL 612
(SHOWN SEPARATELY)

FUNDAMENTAL
FREQUENCY
612A

THIRD HARMONIC
612B

FIFTH HARMONIC
612C

FIG.6G

EP 1 206 831 B1

HARMONICS OF
SIGNALS 610 AND
612 (SHOWN
SIMULTANEOUSLY BUT
NOT SUMMED)

610     612

FIG.6H

610C     612C

FILTERED OUTPUT
SIGNAL 614

FIG.6I

EP 1 206 831 B1

RECEIVER 3906

DOWN-CONVERSION
MODULE 114

UFT MODULE

102

FIG.7

TRANSMITTER 3910

UP-CONVERSION
MODULE 116

UFT MODULE

102

FIG.8

3910

TRANSMITTER

904

3906

RECEIVER

FIG.9

TRANSCEIVER

TRANSMITTER 3910

UFT MODULE 102

RECEIVER 3906

UFT MODULE 102

FIG.10

TRANSCEIVER 1002

TRANSMITTER 3910

UFT MODULE 102

RECEIVER 3906

FIG.11

FIG.12

UNIFIED DOWN-CONVERTING
AND FILTERING (UDF) MODULE
1302

FREQUENCY DOWN-CONVERSION
MODULE 114

FILTERING
MODULE
308

UFT MODULE

102

FIG.13

RECEIVER 3906

UNIFIED DOWN-CONVERTING
AND FILTERING (UDF)
MODULE 1302

FIG.14

FIG.15A

FIG.15B

FIG.15C

1522

FILTER

1302

UDF MODULE

FIG.15D

114

DOWN-CONVERTER

1302

UDF MODULE

FIG.15E

1530

AMPLIFIER

1302

UDF MODULE

FIG.15F

TRANSMITTER 3910

ESR MODULE
(TRANSMIT)
1604

RECEIVER 3906

UNIFIED DOWN-CONVERSION
AND FILTERING-(UDF)
MODULE 1302

UDF MODULE — 1302a

UDF MODULE — 1302x

ESR MODULE
(RECEIVE)
1608

FIG.16

UNIFIED DOWNCONVERTING AND
FILTERING (UDF) MODULE 1302

INPUT
SIGNAL 1704

APPARENT INPUT
FILTER

1706

FREQUENCY
TRANSLATOR

1708

OUTPUT
SIGNAL 1710

FIG.17

ALIASING
MODULE
2000

102

2008

INPUT
SIGNAL

DOWN-CONVERTED
OUTPUT SIGNAL

2004

2010

2012

2006

CONTROL
SIGNAL

FIG.18A

EP 1 206 831 B1

FIG.18A-1

2014

FIG.18B

$t_0$     $t_1$     $t_2$     $t_3$     $t_4$

2016

2022

FIG.18C

$t_0$

2018

2020

FIG.18D

$t_0$   2022     2024

FIG.18E

2026

FIG.18F

FIG.19

EP 1 206 831 B1

FIG.20

EP 1 206 831 B1

FIG.21

EP 1 206 831 B1

FIG.22

2710

3903

UFD 114

UFT MODULE
102

A/D
3016

RECEIVER MODULE 3906

DSP
2720

UFU 116

UFT MODULE
102

MODULATOR
3012

TRANSMITTER MODULE 3910

INTERFACE 2506

COMPUTER

FIG.23

FIG.24

EP 1 206 831 B1

3402

WLAN
802.11

3412A          3404

WLAN
CELLULAR
TELEPHONE

3412B          3406

WLAN
RADIO
LINKS

3412C          3408

WLAN
CUSTOM

3410

**FIG.26**

3302

ETHERNET
IEEE 802.3

INTERFACE          3304

2506

WIRELESS LINK 3308

2506

INTERFACE

3306

WLAN

**FIG.25**

3502  ‌ BUILDING 3504

WLAN

3506

FIG.27

BUILDING 3602  3606  BUILDING 3604

WLAN

FIG.28

3702  BUILDING 3704

WLAN

3706  3708

FIG.29

3802

WLAN-SPECIFIC
GEOGRAPHIC AREA

FIG.30

FIG.31

EP 1 206 831 B1

EP 1 206 831 B1

RECEIVER 3906
(VECTOR DE-MODULATOR)

FIG.32

64

TRANSMITTER 3910
(VECTOR MODULATOR)

116A

I 3942 → UFU  I 4106

UFT 102A

CONTROL SIGNAL
3920B

90°
COMBINER

I/Q SIGNAL
3946

4110

116B

Q 3944 → UFU  Q 4108

UFT 102B

CONTROL SIGNAL
3920B

FIG.33

FIG.34

FIG.35A

FIG.35

EP 1 206 831 B1

FIG.35B

EP 1 206 831 B1

FIG.35C

| ITEM | QTY | REFERENCE | PART | PART NIMBER | MANUFACTURER |
|---|---|---|---|---|---|
| | | | | | |
| 1 | 10 | C/R7,C/R15,C16,C17,C18 | 0.1uF | GRM39Y5V104Z016 | MURATA |
| | | C19,C21,C22,C23,C24 | | | |
| 2 | 6 | C1,C3,C6,C8,C9,C12 | 22pF | GRM39COG220J050 | MURATA |
| 3 | 3 | C2,C4,C11 | 0.1uF | GRM39X7R104K016 | MURATA |
| 4 | 2 | C5,C15 | 47pF | GRM39COG470J050 | MURATA |
| 5 | 2 | C10,C7 | 1000pF | GRM39X7R102K050 | MURATA |
| 6 | 1 | C13 | 100pF | GRM39X7R101J050 | MURATA |
| 7 | 1 | C14 | 3pF | GRM40COG030B50V | MURATA |
| 8 | 2 | C20,C25 | 1uF | GRM40Y5V105Z016 | MURATA |
| 9 | 1 | JP1 | 69190-403 | 69190-403 | BERG |
| 10 | 1 | JP2 | 69190-402 | 69190-402 | BERG |
| 11 | 4 | J1,J2,J3,J4 | 82MMCX-50-0-1 | 82MMCX-50-0-1 | SUHNER |
| 12 | 2 | L3,L1 | DNP | L | TOKO |
| 13 | 2 | L4,L2 | 4.7nH | LL1608-F4N7K | TOKO |
| 14 | 1 | L5 | 15nH | LL2012FH15NJ | TOKO |
| 15 | 1 | L6 | DNP | DNP | TOKO |
| 16 | 2 | Q1,Q2 | BFR520 | BFR520 | PHILIPS |
| 17 | 2 | R1,R3 | 2K | ERJ3GSYJ202 | PANASONIC |
| 18 | 1 | R2 | 51 | ERJ3GSYJ510 | PANASONIC |
| 19 | 2 | R4,R12 | 221 | ERJ3EKF2210 | PANASONIC |
| 20 | 6 | R5,R6,R8,R13,R14,R16 | 33.2K | ERJ3EKF3322 | PANASONIC |
| 21 | 2 | R9,R17 | DNP | ERJ3EKF1001 | PANASONIC |
| 22 | 2 | R10,R18 | 249 | ERJ3EKF2490 | PANASONIC |
| 23 | 2 | R11,R19 | 10 | ERJ3GSYJ100 | PANASONIC |
| 24 | 1 | U1 | D2D_V4 | D2D_V4 | PARKER VISION |
| 25 | 1 | U2 | 1X603 | 1X603 | ANAREN |
| 26 | 1 | U3 | AD8032AR | AD8032AR | ANALOG DEVICES |
| 27 | 1 | | BOARD | STB500.641.001 V03.00 | |

FIG.36

EP 1 206 831 B1

FIG.37

FIG.37A

TRANSMITTER
3910

EP 1 206 831 B1

FIG.37B

FROM FIG.37A

N_BULK   4

EP 1 206 831 B1

73

+5VI

TP2
TP-105-01-00

C3
0.1uF

TP1
TP-105-01-00

I_DATA

R88
1.33K

IDATA

3942   2

FROM FIG.37A

+5VI

TP3
TP-105-01-00

U1A
AD8052AR

R89
4.02K

R90
2K

TP4
TP-105-01-00

+5VI

R7

6.04K

C9
1uF

R5
10K

R64
1K

C15
22pF

R8
1K

C78
0.1uF

TO FIG.37D

FROM FIG.37A

U16

6 GND          Sum Port 1

COMMON-CLK  5 NC — Tie 2 to 5 — NC 2

LO         4 Port 2        Port 1 3
5704A

ADP-2-10-75

LO GENERATOR
(CONTROLS UFT FROM BASE CLOCK)
5702

R79
RESISTOR

C25
1000pF

C23
1000pF

U17

ETC1-1-13

R84
0

R85
0

LO
5704B

3920B

TP5
1
TP-105-01-00

TP8
1
TP-105-01-00

U2
1 NC         VDD 16
2 B_LO        NC 15
3 CHRG1     B_SP1 14
4 CHRG_FDBK B_SP2 13
5 CHRG2     A_SP2 12
6 -VOUT     A_SP1 11
7 A_LO       NC 10
8 VSS     N_BULK 9

D2D_V11

116A

TO FIG.37D

FIG.37C

EP 1 206 831 B1

FROM FIG.37B

FROM FIG.37C

FIG.37D

U1B
AD8052AR

R9 2K
R11 1.5K
TP6
TP-105-01-00
R12 10K
C16 1uF
+5VI

C21 1pF
C35 0 ohm

C79 0.1uF
C80 1000pF
R66 1K

IREF    2

I CHANNEL
4106

TP9
TP-105-01-00

JUMPER TO TP20 IF REQUIRED

U14
+5VI
VIN    VOUT
GND
AD1582

TP21
TP-105-01-00

C82 4.7uF
C83 1uF

EP 1 206 831 B1

DATA CONDITIONING
INTERFACES (BUFFERS)
**5802**

FIG.38

EP 1 206 831 B1

| | | | |
|---|---|---|---|
| FIG.39A | FIG.39B | FIG.39C | FIG.39D |

FIG.39

TO FIG.39B

N_BULK ≫

+5VQ

1 C84
2 0.1uF

R69
1K

TO FIG.39B

TP22

1

·TR-105-01-00

R71
1.1K

Q_CLK ≫

LO 5704A

COMMON_CLK

3920B

C63
1 2 5

1000pF

U18

1

R86

0 TO FIG.39B

2
3

R80
RESISTOR

C61
2 1

1000pF

4

ETC1-1-13

R87

0 TO FIG.39B

# FIG.39A

EP 1 206 831 B1

FIG.39B

FIG.39C

TP11
TR-105-01-00

FROM FIG.39C

Q_DATA
**3944**

≪ QDATA

FROM FIG.39C

TP14
TR-105-01-00

+5VQ

C45
1uF

R32
10K

C85
0.1uF

R70
1K

FROM FIG.39C

C86
0.1uF

C87
1000pF

TP20

R72
1K

TR-105-01-00

≫ QREF

≫ Q CHANNEL **4108**

FROM FIG.39C

# FIG.39D

81

| ITEM | QTY | REFERENCE | PART | PART NUMBER | MANUFACTURER |
|---|---|---|---|---|---|
| 1 | 21 | C3,C6,C8,C10,C14,C38,C44, C46,C51,C71,C72,C77,C78, C79,C84,C85,C86,C93,C95, C96,C98 | 0.1uF | GRM39X7R104K016 | MURATA |
| 2 | 6 | C5,C7,C15,C43,C52,C75 | 22pF | GRM39C0G220J050 | MURATA |
| 3 | 5 | C9,C16,C45,C53,C89 | 1uF | GRM40Y5V105Z016 | MURATA |
| 4 | 8 | C11,C23,C25,C47,C61,C63 C80,C87 | 1000pF | GRM39X7R102K050 | MURATA |
| 5 | 2 | C58,C21 | 1pF | GRM39C0G010B50V | MURATA |
| 6 | 2 | C82,C33 | 4.7uF | T491A475K006AS | KEMET |
| 7 | 2 | C59,C35 | 0 ohm | GRM39C0Gxxxx50V | MURATA |
| 8 | 1 | C73 | 470pF | GRM39C0G471J050 | MURATA |
| 9 | 1 | C83 | 1uF | T491A105M016AS | KEMET |
| 10 | 3 | C90,C91,C92 | 100pF | ECU-V1H101JCV | |
| 11 | 2 | C94,C97 | 0.01uF | GRM39X7R103K016 | MURATA |
| 12 | 1 | FL1 | MDR642E | MDR642E | SOSHIN |
| 13 | 1 | JP1 | Shunt | 69190-402 | BERG |
| 14 | 1 | JP2 | 69190-403 | 69190-403 | BERG |
| 15 | 4 | J7,J8,J9,J10 | 82MMCX-50-0-1 | 82MMCX-50-0-1 | SUHNER |
| 16 | 1 | L10 | 22nH | LL1608-F22NK | COILCRAFT |
| 17 | 1 | L12 | BLM11A121S | BLM11A121S | MURATA |
| 18 | 1 | L13 | 330nH | LL2012-FR33K | |
| 19 | 10 | R5,R6,R12,R13,R32,R33, R39,R40,R95,R100 | 10K | ERJ3EKF1002 | PANASONIC |
| 20 | 2 | R34,R7 | 6.04K | ERJ3EKF6041 | PANASONIC |
| 21 | 4 | R8,R10,R35,R37 | 1K | 3224W-1-102 | BOUMS |
| 22 | 4 | R9,R36,R90,R103 | 2K | ERJ3EKF2001 | PANASONIC |
| 23 | 2 | R38,R11 | 1.5K | ERJ3EKF1501 | PANASONIC |
| 24 | 3 | R56,R94,R99 | 0 ohm | ERJ3GSY0R00 | PANASONIC |

FIG.40A

| | | | | | |
|---|---|---|---|---|---|
| 25 | 1 | R59 | 51 | ERJ3GSYJ510 | PANASONIC |
| 26 | 7 | R60,R61,R62,R84,R85,R86, R87 | 0 | ERJ3GSY0R00 | PANASONIC |
| 27 | 6 | R63,R64,R66,R69,R70,R72 | 1K | ERJ3EKF1001 | PANASONIC |
| 28 | 2 | R71,R65 | 1.1K | ERJ3EKF1101 | PANASONIC |
| 29 | 2 | R80,R79 | RESISTOR | | |
| 30 | 3 | R81,R82,R83 | R | | |
| 31 | 4 | R88,R91,R96,R101 | 1.33K | ERJ3EKF1331 | PANASONIC |
| 32 | 2 | R102,R89 | 4.02K | ERJ3EKF4021 | PANASONIC |
| 33 | 2 | R92,R97 | 499 | ERJ3EKF4990 | PANASONIC |
| 34 | 19 | TP1,TP2,TP3,TP4,TP5,TP6, TP8,TP9,TP11,TP12,TP13, TP14,TP15,TP16,TP18,TP19, TP20,TP21,TP22 | TP-105-01-00 | | |
| 35 | 3 | U1,U6,U19 | AD8052AR | AD8052AR | ANALOG DEVICES |
| 36 | 2 | U7,U2 | D2D_V11 | D2D_V11 | PARKER VISION |
| 37 | 1 | U11 | MAAM22010 | MAAM22010 | MACOM |
| 38 | 1 | U12 | 1X603 | 1X603 | ANAREN |
| 39 | 1 | U14 | AD1582 | AD1582 | ANALOG DEVICES |
| 40 | 1 | U15 | UPG1678 | UPG1678GV | NEC |
| 41 | 1 | U16 | ADP-2-10-75 | ADP-2-10-75 | MINI-CIRCUITS |
| 42 | 1 | | BOARD | 8500.641.021 | V05.10 |

## FIG.40B

FIG.41A

FIG.41B

FIG.42A

FIG.42B

EP 1 206 831 B1

FIG.43A

EP 1 206 831 B1

FIG.43B

EP 1 206 831 B1

FIG.44A

FIG.44A-1

FIG.44B

EP 1 206 831 B1

LOCAL OSCILLATOR
SIGNAL 7015

HALF FREQUENCY LO
SIGNAL 7017

PHASE SHIFTED LO
SIGNAL 7019

HALF FREQUENCY
PHASE SHIFTED LO
SIGNAL 7021

I CONTROL SIGNAL
7090

INVERTED I CONTROL
SIGNAL 7092

Q CONTROL SIGNAL
7094

INVERTED Q CONTROL
SIGNAL 7096

COMBINED CONTROL
SIGNAL 7045

FIG.44C

(A) IQDEMOD PULSE RELATIONSHIPS TO INPUT RF CARRIER

FIG.44D

EP 1 206 831 B1

FIG.44E1

FIG.44E2

FIG.44F

FIG.44G

EP 1 206 831 B1

FIG.44H

FIG.44I

FIG.44J

FIG.44K

FIG.44L

EP 1 206 831 B1

FIG.44M

FIG.44N

FIG.44O

FIG.44P

$\square$ V (RX_I)

SEL>>

$\square$ V (RX_Q)

$\square$ V (I+) $\bullet$ V (I−)

$\square$ V (Q+) $\bullet$ V (Q−)

TIME

EP 1 206 831 B1

FIG.44Q

FIG.44R

FIG.44S

FROM FIG.44S

3906

7048

114B-1

7012

7078

7003

7011

102B-1

7094

7099A

7054

7022

7052

7056

+

−

7005

I BASEBAND
OUTPUT SIGNAL
3928

7058

7013

7080

7060

7066

102B-2

7016

7096

7099A

7068

7064

7070

114B-2

FIG.44S-1

FIG.45A

FIG.45B

7130

3942

AMPLITUDE

7152a 7152b 7152c 7152n

1/T_S 2/T_S 3/T_S n/T_S

FREQUENCY

FIG.45C

7133,7138

3942

AMPLITUDE

7154a 7154b 7156 7154c 7154n

1/T_S 2/T_S 3/T_S n/T_S

FREQUENCY

FIG.45D

EP 1 206 831 B1

FIG.46A

FIG.46B

FIG.46C

FIG.46D

FIG.46E

+1

-1

7206

7116

$t_1$

## FIG.46F

7130

7209

7208

$V_R$
7113

$t_1$

## FIG.46G

$V_R$
7113

7211

7210

$t_1$

7134

## FIG.46H

7209a    7209b

7212

$V_R$
7113

$t_1$

$T_A$

7211a    7211b

7214

7133

## FIG.46I

FIG.46J

FIG.47A

FIG.47B

FIG.48

EP 1 206 831 B1

FIG.49A

FIG.49B

FIG.49C

EP 1 206 831 B1

FIG.50A

FIG.50B

EP 1 206 831 B1

FIG.51

EP 1 206 831 B1

FIG.52

7901

3910

7910    7914    7928

R OR L

$C_{BLK}$

CNTL
7123

7114

7918

102A

7112

7108

3942

7920

7932

308

A

7924

102B

CNTL
7127

7116    7912

7934

OUTPUT
SIGNAL
7936

R OR L

7926    7930

CNTL
SIGNAL
GENERATOR

$C_{BLK}$

7142

FIG.53A

118

FIG.53B

FIG.53C

EP 1 206 831 B1

FIG.53D

FIG.54

EP 1 206 831 B1

EP 1 206 831 B1

FIG.55A

AMPLITUDE

3942   8102a   8102b   8102c   8102n   8006

1/T_S   2/T_S   3/T_S   n/T_S   FREQUENCY

FIG.55B

AMPLITUDE

3944   8104a   8104b   8104c   8104n   8008

1/T_S   2/T_S   3/T_S   n/T_S   FREQUENCY

FIG.55C

AMPLITUDE

8106a   8106b   8108   8106c   8106n   8011

1/T_S   2/T_S   3/T_S   n/T_S   FREQUENCY

FIG.56

FIG.57

EP 1 206 831 B1

8400

| RECEIVE AN INPUT BASEBAND SIGNAL | 8402 |

| DIFFERENTIALLY SAMPLE THE BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE | 8404 |

| MINIMIZE DC OFFSET VOLTAGES BETWEEN SAMPLING MODULES DURING THE DIFFERENTIAL SAMPLING IN STEP 6204 | 8406 |

| SELECT A DESIRED HARMONIC (OR SUBSET OF HARMONICS) OF INTEREST FOR TRANSMISSION | 8408 |

| AMPLIFY THE SELECTED HARMONIC(S) | 8410 |

| TRANSMIT THE SELECTED HARMONIC(S) OVER A COMMUNICATIONS MEDIUM | 8412 |

FIG.58

8500

```
┌─────────────────────────────────────────────────────────────┐
│              RECEIVE AN INPUT BASEBAND SIGNAL                 │── 8402
└─────────────────────────────────────────────────────────────┘
                              │
                              ▼
┌─────────────────────────────────────────────────────────────┐
│   CONVERT THE (SINGLE-ENDED) INPUT BASEBAND SIGNAL INTO A     │
│   DIFFERENTIAL SIGNAL HAVING FIRST AND SECOND SIGNAL          │── 8502
│   COMPONENTS, WHERE THE SECOND COMPONENT IS AN INVERTED       │
│   VERSION OF THE FIRST COMPONENT                             │
└─────────────────────────────────────────────────────────────┘
                              │
                              ▼
┌─────────────────────────────────────────────────────────────┐
│   ADD A DC REFERENCE VOLTAGE TO BOTH OF THE DIFFERENTIAL      │
│   SIGNAL COMPONENTS, RESULTING IN A FIRST COMBINED SIGNAL     │── 8504
│   AND SECOND COMBINED SIGNAL                                 │
└─────────────────────────────────────────────────────────────┘
                              │
                              ▼
┌─────────────────────────────────────────────────────────────┐
│  GENERATE A FIRST CONTROL SIGNAL AND A SECOND CONTROL SIGNAL  │
│  THAT HAVE A COMMON FREQUENCY BUT ARE PHASE-SHIFTED WITH      │
│  RESPECT TO EACH OTHER, AND THAT HAVE PULSE WIDTHS (OR        │── 8506
│  APERTURES) OF T_A THAT ARE ESTABLISHED TO IMPROVE ENERGY     │
│  TRANSFER TO A DESIRED HARMONIC OF THE CONTROL               │
│  SIGNAL FREQUENCY                                            │
└─────────────────────────────────────────────────────────────┘
                              │
                              ▼
┌─────────────────────────────────────────────────────────────┐
│  SAMPLE THE FIRST COMBINED SIGNAL ACCORDING TO THE FIRST      │
│  CONTROL SIGNAL TO GENERATE A FIRST HARMONICALLY RICH SIGNAL  │── 8508
└─────────────────────────────────────────────────────────────┘
                              │
                              ▼
┌─────────────────────────────────────────────────────────────┐
│  SAMPLE THE SECOND COMBINED SIGNAL ACCORDING TO THE SECOND    │
│  CONTROL SIGNAL TO GENERATE A SECOND HARMONICALLY RICH SIGNAL │── 8510
└─────────────────────────────────────────────────────────────┘
                              │
                              ▼
┌─────────────────────────────────────────────────────────────┐
│  COMBINE THE FIRST HARMONICALLY RICH SIGNAL AND THE SECOND    │
│  HARMONICALLY RICH SIGNAL TO GENERATE A THIRD HARMONICALLY    │── 8512
│  RICH SIGNAL THAT HAS MINIMAL CARRIER INSERTION IN THE        │
│  HARMONIC IMAGES                                             │
└─────────────────────────────────────────────────────────────┘
                              │
                              ▼
┌─────────────────────────────────────────────────────────────┐
│    SELECT A DESIRED HARMONIC (OR SUBSET OF HARMONICS)         │── 8408
│                  FOR TRANSMISSION                            │
└─────────────────────────────────────────────────────────────┘
```

8404, 8406

FIG.59

8600

```
┌─────────────────────────────────────────────────────────────────┐
│              RECEIVE AN INPUT BASEBAND SIGNAL                     │── 8402
└─────────────────────────────────────────────────────────────────┘
                              │
                              ▼
┌─────────────────────────────────────────────────────────────────┐
│  CONVERT THE (SINGLE-ENDED) INPUT BASEBAND SIGNAL INTO A          │
│  DIFFERENTIAL SIGNAL HAVING FIRST AND SECOND SIGNAL COMPONENTS,   │── 8602
│  WHERE THE SECOND COMPONENT IS AN INVERTED VERSION OF THE         │
│  FIRST COMPONENT                                                  │
└─────────────────────────────────────────────────────────────────┘
                              │
                              ▼
┌─────────────────────────────────────────────────────────────────┐
│  GENERATE A FIRST CONTROL SIGNAL AND A SECOND CONTROL SIGNAL      │
│  THAT HAVE A COMMON FREQUENCY BUT ARE PHASE-SHIFTED WITH          │
│  RESPECT TO EACH OTHER, AND THAT HAVE PULSE WIDTHS (OR            │── 8604
│  APERTURES) OF $T_A$ THAT ARE ESTABLISHED TO IMPROVE ENERGY       │
│  TRANSFER TO A DESIRED HARMONIC OF THE CONTROL                    │
│  SIGNAL FREQUENCY                                                 │
└─────────────────────────────────────────────────────────────────┘
                              │
                              ▼
┌─────────────────────────────────────────────────────────────────┐
│  SHUNT THE FIRST DIFFERENTIAL SIGNAL COMPONENT TO GROUND          │
│  ACCORDING TO THE FIRST CONTROL SIGNAL TO GENERATE A FIRST        │── 8606
│  HARMONICALLY RICH SIGNAL                                         │
└─────────────────────────────────────────────────────────────────┘
                              │
                              ▼
┌─────────────────────────────────────────────────────────────────┐
│  SHUNT THE SECOND DIFFERENTIAL SIGNAL COMPONENT TO GROUND         │
│  ACCORDING TO THE SECOND CONTROL SIGNAL TO GENERATE A SECOND      │── 8608
│  HARMONICALLY RICH SIGNAL                                         │
└─────────────────────────────────────────────────────────────────┘
                              │
                              ▼
┌─────────────────────────────────────────────────────────────────┐
│  COMBINE THE FIRST HARMONICALLY RICH SIGNAL AND THE SECOND        │
│  HARMONICALLY RICH SIGNAL TO GENERATE A THIRD HARMONICALLY RICH   │── 8610
│  SIGNAL THAT HAS MINIMAL CARRIER INSERTION IN THE HARMONIC IMAGES │
└─────────────────────────────────────────────────────────────────┘
                              │
                              ▼
┌─────────────────────────────────────────────────────────────────┐
│         SELECT A DESIRED HARMONIC (OR SUBSET OF HARMONICS)        │── 8408
│                      FOR TRANSMISSION                             │
└─────────────────────────────────────────────────────────────────┘
```

8404, 8406

## FIG.60

8700

RECEIVE AN I BASEDBAND SIGNAL AND A Q BASEBAND SIGNAL — 8702

DIFFERENTIALLY SAMPLE THE I BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING I HARMONICALLY RICH SIGNAL — 8704

DIFFERENTIALLY SAMPLE THE Q BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING Q HARMONICALLY RICH SIGNAL — 8706

MINIMIZE DC OFFSET VOLTAGES BETWEEN SAMPLING MODULES DURING THE DIFFERENTIAL SAMPLING STEPS — 8708

COMBINE THE I HARMONICALLY RICH SIGNAL AND THE Q HARMONICALLY RICH SIGNAL TO GENERATE AN IQ HARMONICALLY RICH SIGNAL — 8710

SELECT A DESIRED HARMONIC (OR SUBSET OF HARMONICS) OF INTEREST FOR TRANSMISSION — 8712

AMPLIFY THE SELECTED HARMONIC(S) — 8714

TRANSMIT THE SELECTED HARMONIC(S) OVER A COMMUNICATIONS MEDIUM — 8716

FIG.61

8800

| RECEIVE AN I BASEDBAND SIGNAL AND A Q BASEBAND SIGNAL |
| :---: |

8802

| DIFFERENTIALLY SHUNT THE I BASEBAND SIGNAL TO GROUND ACCORDING TO FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING I HARMONICALLY RICH SIGNAL |
| :---: |

8804

| DIFFERENTIALLY SHUNT THE Q BASEBAND SIGNAL TO GROUND ACCORDING TO FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING Q HARMONICALLY RICH SIGNAL |
| :---: |

8806

| COMBINE THE I HARMONICALLY RICH SIGNAL AND THE Q HARMONICALLY RICH SIGNAL TO GENERATE AN IQ HARMONICALLY RICH SIGNAL |
| :---: |

8808

| SELECT A DESIRED HARMONIC (OR SUBSET OF HARMONICS) OF INTEREST FOR TRANSMISSION |
| :---: |

8810

| AMPLIFY THE SELECTED HARMONIC(S) |
| :---: |

8812

| TRANSMIT THE SELECTED HARMONIC(S) OVER A COMMUNICATIONS MEDIUM |
| :---: |

8814

# FIG.62

EP 1 206 831 B1

7144

INPUT SIGNAL
8904

PULSES
8908

INVERTER
8910

8906
DELAY

FIG.63A

FIG.63B

8904

FIG.63C

$T_A$

8908

RISING EDGE PULSE GENERATOR

FIG.63D

FALLING EDGE PULSE GENERATOR

FIG.63E

FIG.64A

FIG.64B

EP 1 206 831 B1

FIG.65

EP 1 206 831 B1

FIG.66

EP 1 206 831 B1

FIG.67

3093

9404

9406

9400

1002

9412

3918

9416

9418

EP 1 206 831 B1

IQ
RECEIVER
3906

BASEBAND
PROCESSOR

MAC

BUS
INTERFACE
UNIT

PCMCIA
CONNECTOR

9408

IQ
TRANSMITTER
3910

9420

FIG.68